(19) Europäisches Patentamt
European Patent Office
Office européen des brevets

(11) EP 3 859 447 B1

(12) **EUROPEAN PATENT SPECIFICATION**

(45) Date of publication and mention of the grant of the patent:
**19.11.2025 Bulletin 2025/47**

(21) Application number: **19865333.9**

(22) Date of filing: **26.08.2019**

(51) International Patent Classification (IPC):
***G03F 7/004*** (2006.01) ***C08F 290/00*** (2006.01)
***C08G 73/10*** (2006.01) ***C08G 73/22*** (2006.01)
***G03F 7/037*** (2006.01) ***G03F 7/038*** (2006.01)
***C08F 290/06*** (2006.01) ***G03F 7/085*** (2006.01)
***H01L 21/02*** (2006.01) ***H01L 23/02*** (2006.01)
***H01L 23/00*** (2006.01) ***G03F 7/028*** (2006.01)

(52) Cooperative Patent Classification (CPC):
(C-Sets available)
**H01L 21/02118; C08F 290/065; C08G 73/10; C08G 73/1025; C08G 73/1071; C08G 73/22; G03F 7/037; G03F 7/0388; G03F 7/085; H01L 21/02282;** C08L 2203/16; G03F 7/028; H01L 23/293; Y02P 20/55 (Cont.)

(86) International application number:
**PCT/JP2019/033316**

(87) International publication number:
**WO 2020/066416 (02.04.2020 Gazette 2020/14)**

(54) **PHOTOSENSITIVE RESIN COMPOSITION, CURED FILM, LAMINATE, METHOD FOR PRODUCING CURED FILM, AND SEMICONDUCTOR DEVICE**

LICHTEMPFINDLICHE HARZZUSAMMENSETZUNG, GEHÄRTETER FILM, LAMINAT, VERFAHREN ZUR HERSTELLUNG DES GEHÄRTETEN FILMS UND HALBLEITERBAUELEMENT

COMPOSITION DE RÉSINE PHOTOSENSIBLE, FILM DURCI, STRATIFIÉ, PROCÉDÉ DE PRODUCTION DE FILM DURCI, ET DISPOSITIF À SEMI-CONDUCTEURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.09.2018 JP 2018185070**

(43) Date of publication of application:
**04.08.2021 Bulletin 2021/31**

(73) Proprietor: **FUJIFILM Corporation**
**Tokyo 106-8620 (JP)**

(72) Inventors:
- **IWAI, Yu**
  **Haibara-gun, Shizuoka 421-0396 (JP)**
- **YOSHIDA, Kenta**
  **Haibara-gun, Shizuoka 421-0396 (JP)**
- **FUKUHARA, Toshiaki**
  **Haibara-gun, Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**WO-A1-2017/104672** **WO-A1-2018/151195**
**JP-A- 2010 254 982** **JP-A- 2011 052 214**
**JP-A- 2011 068 888** **JP-A- 2011 121 962**
**JP-A- 2013 204 019** **JP-A- 2013 241 548**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08F 290/065, C08F 222/1006**

## Description

### BACKGROUND OF THE INVENTION

1. Field of the Invention

The present invention relates to a photosensitive resin composition containing a precursor of a heterocyclic ring-containing polymer, a cured film, a laminate, a method for manufacturing a cured film, and a semiconductor device.

2. Description of the Related Art

Cyclized and cured resins such as a polyimide resin and a polybenzoxazole resin have excellent heat resistance and insulating properties and thus have been applied to various applications. The applications are not particularly limited, and examples thereof include the use as a material for an insulating film or a sealing material and a use as a protective film (see Science & Technology Co., Ltd., "High functionality and applied technology of polyimide" April 2008, CMC Technical library "Basics and development of polyimide materials" supervised by Masaaki Kakimoto, published in November 2011, and the like) in a semiconductor device for mounting. The cyclized and cured resin also used as a base film and a cover lay for a flexible substrate.

Such a polyimide resin generally has low solubility in a solvent. Therefore, a method in which dissolution is performed in a solvent in the state of a polymer precursor before the cyclization reaction, specifically in the state of a polyimide precursor or a polybenzoxazole precursor, is often used. As a result, excellent handleability can be realized, and in a case where each of the products as described above is manufactured, it is possible to coat a substrate or the like with the precursor in various forms to perform processing. After the coating, the polymer precursor can be heated for cyclization, and a cured resin film can be formed. In addition to the high performance of the polyimide resin and the like, from the viewpoint of excellent manufacturing adaptability described above, the industrial application expansion is expected increasingly.

For example, JP2011-121962A discloses a photosensitive resin composition containing a polyimide precursor or a polybenzoxazole precursor, and a photobase generator having a phenolic hydroxyl group. In addition, JP2011-121962A discloses that since the photobase generator has excellent sensitivity, a highly sensitive photosensitive resin composition can be obtained.

Further, JP2014-201695A discloses a photosensitive resin composition containing a polyimide precursor having a specific constitutional unit and, a compound that generates radicals by irradiation with active rays.

WO 2017/104672 A1 describes a method for producing a heterocycle-containing polymer precursor. JP 2013 204019 A describes a base generator which generates a base by irradiation of an electromagnetic wave and heating. WO 2018/151195 A1 describes a photosensitive resin composition containing a heterocycle-containing polymer precursor selected from a polyimide precursor and a polybenzoxazole precursor and a solvent. JP 2011 068888 A describes a base generator for generating a base upon irradiation of electromagnetic waves and heating. JP 2013-241548 A describes a base generator having a specific structure, which generates a base upon irradiation by light and heating. JP 2011-121962 A describes a photosensitive resin composition comprising a base generator, which generates a base upon irradiation of electromagnetic waves and heating.

### SUMMARY OF THE INVENTION

Since the photobase generator described in JP2011-121962A does not exhibit activity at ordinary temperature and under ordinary pressure, the photobase generator is considered to be useful from the viewpoint of preserving the photosensitive resin composition.

However, the base generating efficiency of the base generator in the photosensitive resin composition of JP2011-121962A is not sufficiently high. In a case where the base generating efficiency is insufficient, the cyclization rate of the resin is decreased and the curing is likely to be insufficient, and the exposure sensitivity at the time of pattern formation is also likely to be insufficient.

The present invention has been made in consideration of the above problems, and an object of the present invention is to provide a photosensitive resin composition exhibiting an excellent cyclization rate and excellent storage stability.

Another object of the present invention is to provide a cured film formed by using the photosensitive resin composition and a laminate. In addition, another object of the present invention is to provide a method for manufacturing a cured film using the photosensitive resin composition. Further, another object of the present invention is to provide a semiconductor device including the cured film or the laminate.

The above problems could be solved by using a base generator having a specific structure. Specifically, the

above problems have been solved by the following means, as specified in the appended claims.

A photosensitive resin composition comprising:

a thermal base generator represented by Formula (N1); and
a precursor of a heterocyclic ring-containing polymer.

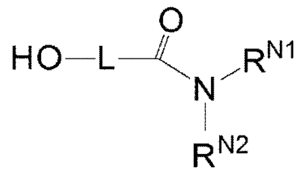

Formula (N1);

In Formula (N1), L represents a hydrocarbon group which is a divalent hydrocarbon group having a saturated hydrocarbon group on a path of a linking chain which links adjacent oxygen atom and carbon atom and in which the number of the atoms on the path of the linking chain is 4, 5 or 6, wherein the linking chain refers to an atomic chain which interconnects the linking targets with the minimum number of atoms, and $R^{N1}$ and $R^{N2}$ each independently represent a monovalent organic group and may be linked to each other to form a cyclic structure.

In the photosensitive resin composition according to the present invention, L in Formula (N1) may have a structure represented by Formula (N2-a) or Formula (N2-b).

$-L^1-Ar-L^2-$ Formula (N2-a);

$-Ar^1-L^3-Ar^2-$ Formula (N2-b);

In Formula (N2-a), $L^1$ and $L^2$ each independently represent a single bond or a hydrocarbon group, at least one of $L^1$ or $L^2$ contains a saturated hydrocarbon group on the path, and Ar represents an arylene group; and in Formula (N2-b), $L^3$ represents a hydrocarbon group containing a saturated hydrocarbon group on the path, and $Ar^1$ and $Ar^2$ each independently represent an arylene group.

In the photosensitive resin composition according to the present invention, $R^{N1}$ and $R^{N2}$ in Formula (N1) may be each independently an aliphatic hydrocarbon group.

In the photosensitive resin composition according to the present invention, at least one of $R^{N1}$ or $R^{N2}$ in Formula (N1) may be an aliphatic hydrocarbon group having a polar group.

In the photosensitive resin composition according to the present invention, $R^{N1}$ and $R^{N2}$ in Formula (N1) may be linked to each other to form an aliphatic cyclic structure.

In thephotosensitive resin composition according to the present invention, the aliphatic cyclic structure may have at least a polar group as a part of a substituent.

The photosensitive resin composition according to the present invention may further comprise a photo-radical polymerization initiator and a radically polymerizable compound.

In the photosensitive resin composition according to the present invention, the precursor of the heterocyclic ring-containing polymer may include a polyimide precursor or a polybenzoxazole precursor.

Preferably, the precursor of the heterocyclic ring-containing polymer includes the polyimide precursor.

More preferably, the polyimide precursor has a constitutional unit represented by Formula (1).

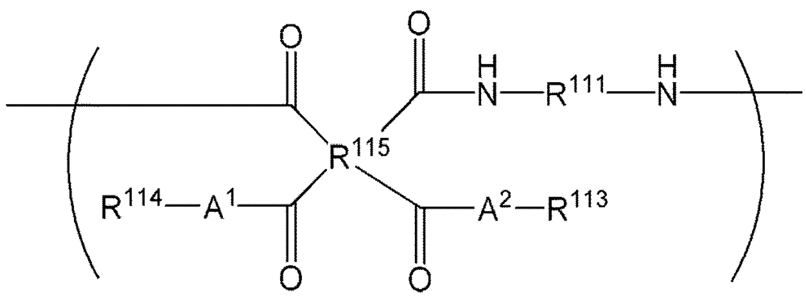

(1)

In Formula (1), $A^1$ and $A^2$ each independently represent an oxygen atom or NH, $R^{111}$ represents a divalent organic group, $R^{115}$ represents a tetravalent organic group, and $R^{113}$ and $R^{114}$ each independently represent a hydrogen atom or a monovalent organic group.

Further preferably, at least one of $R^{113}$ or $R^{114}$ in Formula (1) contains a radically polymerizable group.

The photosensitive resin composition according to the present invention may be is used for forming an interlayer insulating film for a rewiring layer.

A cured film obtained by curing the photosensitive resin composition as specified in any one of appended claims 1 to 12.

A laminate comprising two or more cured films as specified in appended claim 13, in which a metal layer is provided between any cured films.

A method for manufacturing a cured film, comprising a film forming step of applying the photosensitive resin composition as specified in any one of appended claims 1 to 12 onto a substrate to form a film.

The method for manufacturing a cured film may further comprise a step of heating the film at 50° to 450°C.

A semiconductor device comprising the cured film as specified in appended claim 13 or the laminate as specified in appended claim 14.

According to the present invention, a photosensitive resin composition exhibiting an excellent cyclization rate, and excellent storage stability can be obtained. In addition, in a case where the photosensitive resin composition according to an aspect of the present invention is used, it is possible to provide a cured film, a laminate, a method for manufacturing a cured film, and a semiconductor device according to an aspect of the present invention.

## DESCRIPTION OF THE PREFERRED EMBODIMENTS

Hereinafter, the main embodiments of the present invention will be described.

In the present specification, a numerical range described by using "to" means a range including numerical values described before and after the preposition "to" as a lower limit value and an upper limit value, respectively.

In the present specification, the term "step" means not only an independent step but also a step that cannot be clearly distinguished from other steps as long as the desired action of the step can be achieved.

In describing a group (an atomic group) in the present specification, in a case where a description has no indication about substitution and non-substitution, the description means the group includes a group having a substituent as well as a group having no substituent. For example, in a case of being simply described as an "alkyl group", this means the alkyl group includes both an alkyl group (an unsubstituted alkyl group) having no substituent and an alkyl group (a substituted alkyl group) having a substituent. In addition, in a case of simply being described as "alkyl group", this means that the alkyl group may be chain-like or cyclic, and in the case of being chain-like, it may be linear or branched. The same applies to "alkenyl group", "alkylene group", and "alkenylene group".

In the present specification, "exposure" means not only lithography using light but also lithography with particle beams such as electron beams and ion beams, unless otherwise specified. Examples of the energy rays used for lithography include emission line spectra of mercury lamps, far ultraviolet rays typified by excimer lasers, active rays such as extreme ultraviolet rays (EUV light) and X-rays, and particle beams such as electron beams and ion beams.

In the present specification, "(meth)acrylate" means one or both of "acrylate" and "methacrylate", "(meth)acryl" means one or both of "acryl" and "methacryl", and "(meth)acryloyl" means one or both of "acryloyl" and "methacryloyl".

In the present specification, the concentration of solid content in the composition is represented by the mass percentage of the other components excluding the solvent with respect to the total mass of the composition.

In the present specification, the physical property values are values under the conditions of a temperature of 23°C and an atmospheric pressure of 101,325 Pa (1 atm), unless otherwise described.

In the present specification, unless otherwise described, weight-average molecular weight (Mw) and number-average molecular weight (Mn) are indicated as polystyrene equivalent values according to gel permeation chromatography (GPC measurement). These weight-average molecular weight (Mw) and number-average molecular weight (Mn) can be determined, for example, by using HLC-8220 (manufactured by Tosoh Corporation) and using, as a column, GUARD COLUMN HZ-L, TSKgel Super HZM-M, TSK gel Super HZ4000, TSK gel Super HZ3000, or TSK gel Super HZ2000 (manufactured by Tosoh Corporation). In addition, unless otherwise described, measurement is performed using tetrahydrofuran (THF) as an eluent. In addition, unless otherwise described, detection is carried out using a detector having a UV ray (an ultraviolet ray) of a wavelength 254 nm in GPC measurement.

In the present specification, in a case where the positional relationship of respective layers constituting the laminate is described as "upper" or "lower", another layer may be on the upper side or the lower side of the reference layer among the plurality of layers of interest. That is, a third layer or element may be further interposed between the reference layer and the other layer, and the reference layer and the other layer need not be in contact with each other. In addition, unless otherwise specified, the direction in which the layers are laminated on the base material is referred to as "upward", or in a case where a photosensitive layer is present, the direction from the base material to the photosensitive layer is referred to as "upper". The opposite direction thereof is referred to as "downward". It is noted that such setting of the upward or downward direction is for convenience in the present specification, and in an actual aspect, the "upward" direction in the present specification may be different from the vertical upward direction.

[Photosensitive resin composition]

The photosensitive resin composition according to the embodiment of the present invention (hereinafter, also simply referred to as "the composition according to the embodiment of the present invention") contains a precursor of a heterocyclic ring-containing polymer and a specific thermal base generator described below. Further, the photosensitive resin composition according to the embodiment of the present invention preferably contains a photo-radical polymerization initiator and a radically polymerizable compound. Hereinafter, each of the components of the photosensitive resin composition according to the embodiment of the present invention will be described in detail.

<Precursor of heterocyclic ring-containing polymer>

Examples of the precursor of the heterocyclic ring-containing polymer include at least one polymer precursor selected from the group consisting of a polyimide precursor and a polybenzoxazole precursor, and a polyimide precursor is more preferable.

<<Polyimide precursor>>

The polyimide precursor preferably contains a constitutional unit represented by Formula (1). With such a configuration, a composition having more excellent film hardness can be obtained.

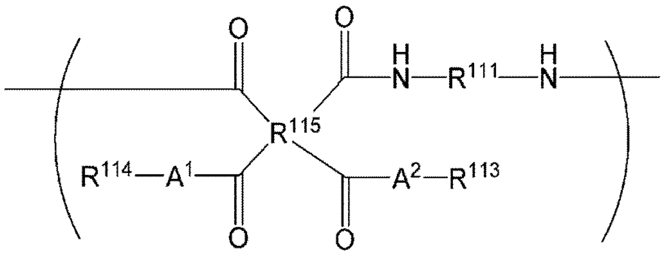 (1)

$A^1$ and $A^2$ each independently represent an oxygen atom or NH, $R^{111}$ represents a divalent organic group, $R^{115}$ represents a tetravalent organic group, and $R^{113}$ and $R^{114}$ each independently represent a hydrogen atom or a monovalent organic group.

$A^1$ and $A^2$ are each independently an oxygen atom or NH, and an oxygen atom is preferable.

<<<$R^{111}$>>>

$R^{111}$ represents a divalent organic group. Examples of the divalent organic group include a linear or branched aliphatic group, a cyclic aliphatic group, and an aromatic group, a heteroaromatic group, or a group consisting of a combination thereof. The divalent organic group is preferably a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group consisting of a combination thereof, and more preferably an aromatic group having 6 to 20 carbon atoms.

$R^{111}$ is preferably derived from a diamine. Examples of the diamine used for producing the polyimide precursor include a linear aliphatic or branched aliphatic, a cyclic aliphatic, or an aromatic diamine. Only one type of the diamine may be used, or two or more types thereof may be used.

Specifically, the diamine is preferably a diamine containing a linear aliphatic group having 2 to 20 carbon atoms, a branched or cyclic aliphatic group having 3 to 20 carbon atoms, an aromatic group having 6 to 20 carbon atoms, or a group consisting of a combination thereof, and more preferably a diamine containing an aromatic group having 6 to 20 carbon atoms. Examples of the aromatic group include the followings.

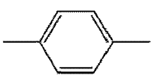 AR-1 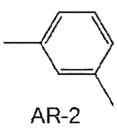 AR-2 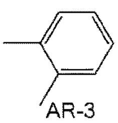 AR-3 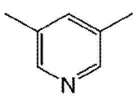 AR-4 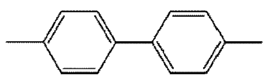 AR-5 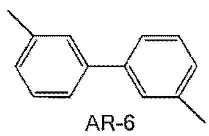 AR-6

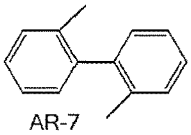
AR-7
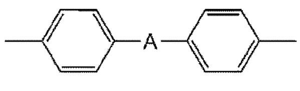
AR-8
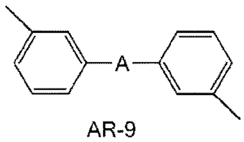
AR-9
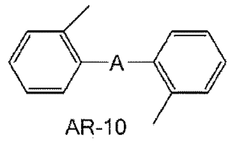
AR-10

In the formulae, A is preferably a single bond or a group selected from an aliphatic hydrocarbon group having 1 to 10 carbon atoms which may be substituted with a fluorine atom, -O-, -C(=O)-, -S-, $-S(=O)_2-$, -NHCO-, and a combination thereof, more preferably a single bond or a group selected from an alkylene group having 1 to 3 carbon atoms which may be substituted with a fluorine atom, -O-, -C(=O)-, -S-, and $-SO_2-$, and still more preferably a divalent group selected from the group consisting of $-CH_2-$, -O-, -S-, $-SO_2-$, $-C(CF_3)_2-$, and $-C(CH_3)_2-$.

As diamine, specifically, at least one diamine selected from 1,2-diaminoethane, 1,2-diaminopropane, 1,3-diaminopropane, 1,4-diaminobutane, and 1,6-diaminohexane; 1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, and isophorone diamine; meta- and paraphenylene diamine, diaminotoluene, 4,4'- and 3,3'-diaminobiphenyl, 4,4'-diaminodiphenyl ether, 3,3-diaminodiphenyl ether, 4,4'- and 3,3'-diaminodiphenylmethane, 4,4'- and 3,3'-diaminodiphenyl sulfone, 4,4'- and 3,3'-diaminodiphenyl sulfide, 4,4'- and 3,3'-diaminobenzophenone, 3,3'-dimethyl-4,4'-diaminobiphenyl, 2,2'-dimethyl-4,4'-diaminobiphenyl(4,4'-diamino-2,2' -dimethylbiphenyl), 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, bis(3-amino-4-hydroxyphenyl)sulfone, bis(4-amino-3-hydroxyphenyl)sulfone, 4,4'-diaminoparaterphenyl, 4,4-bis(4-aminophenoxy)biphenyl, bis[4-(4-aminophenoxy)phenyl]sulfone, bis[4-(3-aminophenoxy)phenyl]sulfone, bis[4-(2-aminophenoxy)phenyl]sulfone, 1,4-bis(4-aminophenoxy)benzene, 9,10-bis(4-aminophenyl)anthracene, 3,3'-dimethyl-4,4'-diaminodiphenyl sulfone, 1,3-bis(4-aminophenoxy)benzene, 1,3-bis(3-aminophenoxy)benzene, 1,3-bis(4-aminophenyl)benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl)fluorene, 4,4'-dimethyl-3,3'-diaminodiphenyl sulfone, 3,3',5,5'-tetramethyl-4,4'-diaminodiphenylmethane, 2-(3',5'-diaminobenzoyloxy) ethylmetacrylate, 2,4- and 2,5-diaminocumene, 2,5-dimethyl-paraphenylene diamine, acetoguanamine, 2,3,5,6-tetramethyl-paraphenylene diamine, 2,4,6-trimethyl-metaphenylene diamine, bis(3-aminopropyl)tetramethyldisiloxane, 2,7-diaminofluorene, 2,5-diaminopyridine, 1,2-bis(4-aminophenyl)ethane, diaminobenzanilide, esters of diaminobenzoic acid, 1,5-diaminonaphthalene, diaminobenzotrifluoride, 1,3-bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis [4-(4-aminophenoxy)-3,5-dimethylphenyl]hexafluoropropane, 2,2-bis[4-(4-aminophenoxy)-3,5-bis(trifluoromethyl)phenyl]hexafluoropropane, parabis(4-amino-2-trifluoromethylphenoxy)benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone, 2,2-bis[4-(4-amino-3-trifluoromethylphenoxy) phenyl]hexafluoropropane, 3,3',5,5'-tetramethyl-4,4'-diaminobiphenyl, 4,4'-diamino-2,2'-bis(trifluoromethyl)biphenyl, 2,2',5,5',6,6'-hexafluorotolidine, or 4,4'-diaminoquaterphenyl is mentioned.

In addition, diamines (DA-1) to (DA-18) as shown below are also preferable.

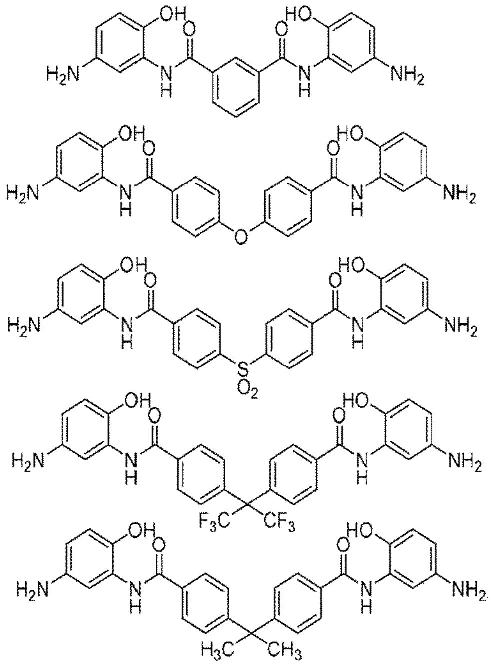

(DA-1)

(DA-2)

(DA-3)

(DA-4)

(DA-5)

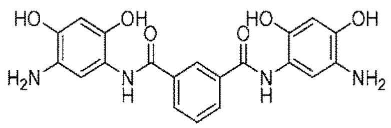

(DA-6)

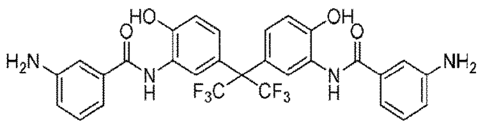

(DA-7)

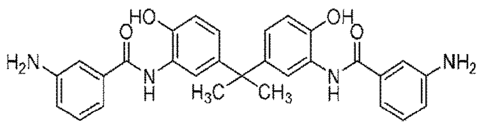

(DA-8)

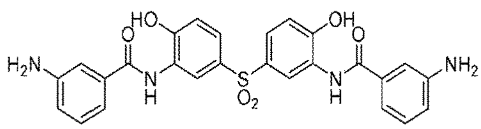

(DA-9)

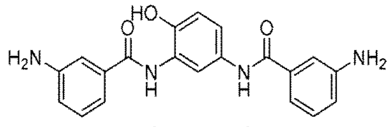

(DA-10)

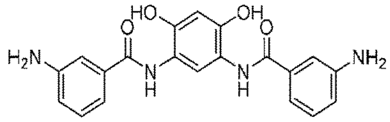

(DA-11)

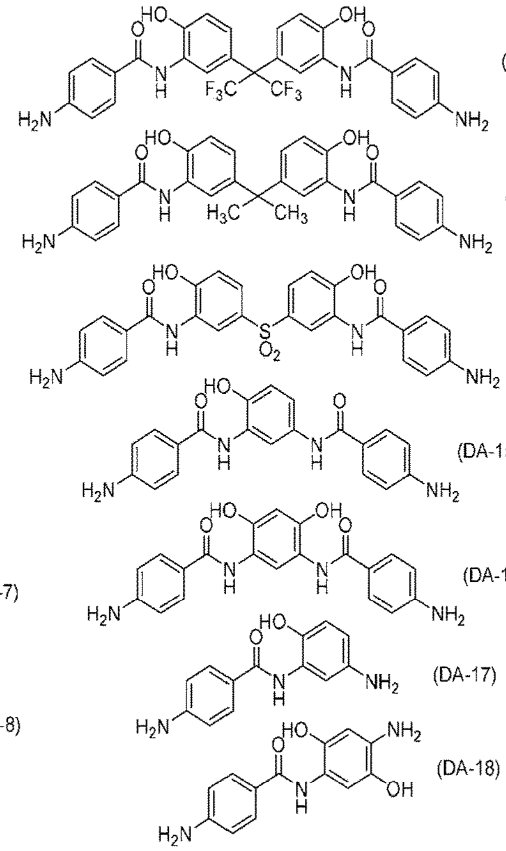

(DA-12)

(DA-13)

(DA-14)

(DA-15)

(DA-16)

(DA-17)

(DA-18)

In addition, preferred examples of the diamine also include a diamine having at least two or more alkylene glycol units in the main chain. A diamine containing two or more, in total, of one or both of ethylene glycol chain and propylene glycol chain in one molecule is preferable, and a diamine containing no aromatic ring is more preferable. Specific examples thereof include JEFFAMINE (registered trade mark) KH-511, JEFFAMINE (registered trade mark) ED-600, JEFFAMINE (registered trade mark) ED-900, JEFFAMINE (registered trade mark) ED-2003, JEFFAMINE (registered trade mark) EDR-148, JEFFAMINE (registered trade mark) EDR-176, D-200, D-400, D-2000, D-4000 (all trade names, manufactured by Huntsman Corporation), 1-(2-(2-(2-aminopropoxy)ethoxy)propoxy)propane-2-amine, and 1-(1-(1-(2-aminopropoxy) propan-2-yl)oxy)propane-2-amine, which are not limited thereto.

Structures of JEFFAMINE (registered trade mark) KH-511, JEFFAMINE (registered trade mark) ED-600, JEFFAMINE (registered trade mark) ED-900, JEFFAMINE (registered trade mark) ED-2003, JEFFAMINE (registered trade mark) EDR-148, and JEFFAMINE (registered trade mark) EDR-176 are shown below.

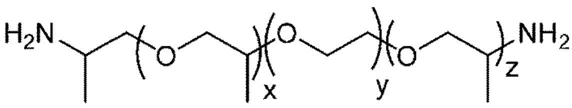

KH-511 (y=2.0,x+z=1.2)
ED-600 (y=9.0,x+z=3.6)
ED-900 (y=12.5,x+z=6.0)
ED-2003 (y=39.0,x+z=6.0)

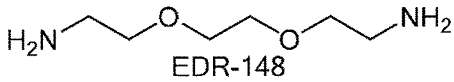

EDR-148

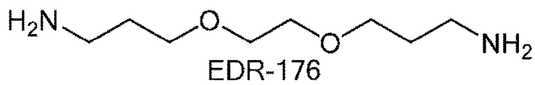

EDR-176

In the above, x, y, and z are average values.

$R^{111}$ is preferably represented by $-Ar^0-L^0-Ar^0-$ from the viewpoint of the flexibility of an obtained cured film. However, $Ar^0$'s are each independently an aromatic hydrocarbon group (preferably having 6 to 22 carbon atoms, more preferably 6 to 18 carbon atoms, and particularly preferably 6 to 10 carbon atoms), and a phenylene group is preferable. $L^0$ represents a single bond or a group selected from an aliphatic hydrocarbon group having 1 to 10 carbon atoms which may be substituted with a fluorine atom, -O-, -C(=O)-, -S-, $-S(=O)_2-$, -NHCO-, and a combination thereof. The preferred range is the same as that of A described above.

From the viewpoint of i-ray transmittance, $R^{111}$ is preferably a divalent organic group represented by Formula (51) or Formula (61) below. In particular, from the viewpoint of i-ray transmittance and ease of availability, a divalent organic group represented by Formula (61) is more preferable.

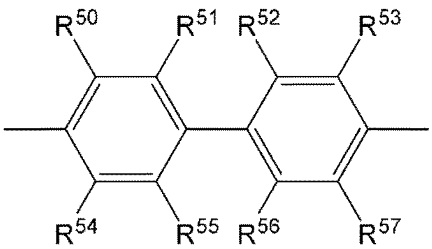

(51)

$R^{50}$ to $R^{57}$ each independently represent a hydrogen atom, a fluorine atom, or a monovalent organic group, and at least one of $R^{50}$, ..., or $R^{57}$ represents a fluorine atom, a methyl group, a fluoromethyl group, a difluoromethyl group, or a trifluoromethyl group.

Examples of the monovalent organic group as $R^{50}$ to $R^{57}$ include an unsubstituted alkyl group having 1 to 10 (preferably 1 to 6) carbon atoms and a fluorinated alkyl group having 1 to 10 (preferably 1 to 6) carbon atoms.

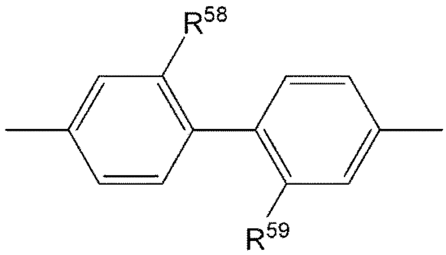

(61)

$R^{58}$ and $R^{59}$ each independently represent a fluorine atom, a fluoromethyl group, a difluoromethyl group, or a trifluoromethyl group.

As a diamine compound that forms a structure of Formula (51) or (61), dimethyl-4,4'-diaminobiphenyl, 2,2'-bis(trifluoromethyl)-4,4'-diaminobiphenyl, 2,2'-bis(fluoro)-4,4'-diaminobiphenyl, 4,4'-diaminooctafluorobiphenyl, and the like are mentioned. One type of these may be used, or two or more types thereof may be used in combination.

<<<$R^{115}$>>>

$R^{115}$ in Formula (1) represents a tetravalent organic group. The tetravalent organic group is preferably a group containing an aromatic ring and more preferably a group represented by Formula (5) or Formula (6).

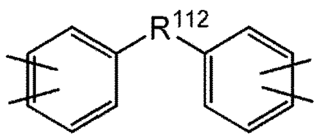
(5)

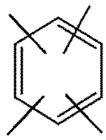
(6)

$R^{112}$ is the same as A and has the same preferred range as that of A.

Specific examples of the tetravalent organic group represented by $R^{115}$ in Formula (1) include a tetracarboxylic acid residue that remains after removing an acid dianhydride group from tetracarboxylic acid dianhydride. Only one type of tetracarboxylic acid dianhydride may be used, or two or more types of thereof may be used. The tetracarboxylic acid dianhydride is preferably a compound represented by Formula (7).

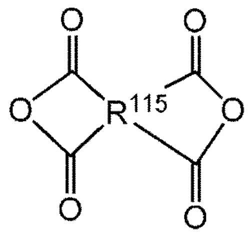
(7)

$R^{115}$ represents a tetravalent organic group. $R^{115}$ has the same meaning as $R^{115}$ in Formula (1).

Specific examples of the tetracarboxylic acid dianhydride include at least one selected from pyromellitic acid, pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride, 3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1-bis(2,3-dicarboxyphenyl)ethane dianhydride, 1,1-bis(3,4-dicarboxyphenyl)ethane dianhydride, 1,2,3,4-benzene tetracarboxylic acid dianhydride, or alkyl derivatives having 1 to 6 carbon atoms and alkoxy derivatives having 1 to 6 carbon atoms thereof.

In addition, tetracarboxylic acid dianhydrides (DAA-1) to (DAA-5) as shown below are also mentioned as preferable examples.

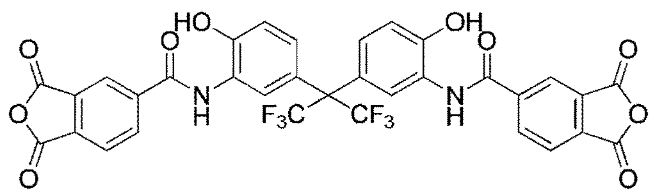
(DAA-1)

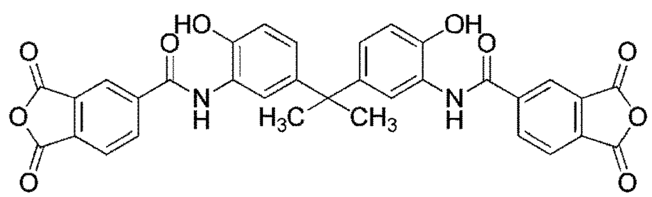
(DAA-2)

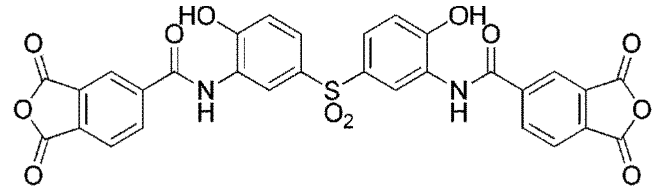

(DAA-3)

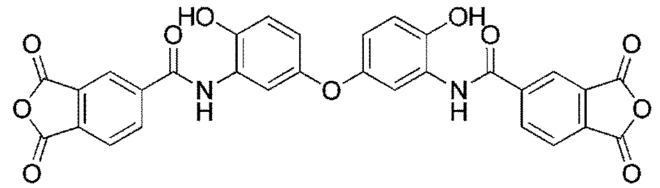

(DAA-4)

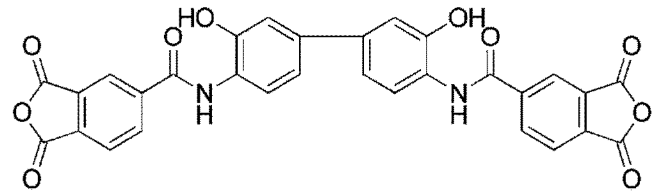

(DAA-5)

<<<$R^{113}$ and $R^{114}$>>>

In Formula (1), $R^{113}$ and $R^{114}$ each independently represent a hydrogen atom or a monovalent organic group. At least one of $R^{113}$ or $R^{114}$ preferably contains a radically polymerizable group, and more preferably both contain a radically polymerizable group. The radically polymerizable group is a group capable of undergoing a crosslinking reaction by an action of a radical, and preferable examples thereof include a group having an ethylenic unsaturated bond.

Examples of the group having an ethylenic unsaturated bond include a vinyl group, an allyl group, a (meth) acryloyl group, and a group represented by Formula (III).

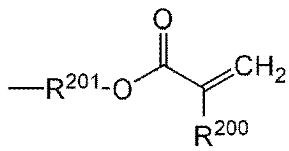

(III)

In Formula (III), $R^{200}$ represents a hydrogen atom or a methyl group and is preferably a methyl group.

In Formula (III), $R^{201}$ represents an alkylene group having 2 to 12 carbon atoms, $-CH_2CH(OH)CH_2-$, or a (poly) oxyalkylene group having 4 to 30 carbon atoms (the alkylene group preferably has 1 to 12 carbon atoms, more preferably 1 to 6 carbon atoms, and particularly preferably 1 to 3 carbon atoms; the number of repetitions thereof is preferably 1 to 12, more preferably 1 to 6, and particularly preferably 1 to 3). The (poly)oxyalkylene group means an oxyalkylene group or a polyoxyalkylene group.

Suitable examples of $R^{201}$ include an ethylene group, a propylene group, a trimethylene group, a tetramethylene group, a 1,2-butanediyl group, a 1,3-butanediyl group, a pentamethylene group, a hexamethylene group, an octamethylene group, a dodecamethylene group, and $-CH_2CH(OH)CH_2-$, and an ethylene group, a propylene group, a trimethylene group, or $-CH_2CH(OH)CH_2-$ is more preferable.

Particularly preferably, $R^{200}$ is a methyl group, and $R^{201}$ is an ethylene group.

As the preferred embodiment of the polyimide precursor in the present invention, examples of the monovalent organic group as $R^{113}$ or $R^{114}$ include an aliphatic group, an aromatic group, and an arylalkyl group having, which have one, two, or three, preferably one acid group. Specific examples thereof include an aromatic group having 6 to 20 carbon atoms, which has an acid group, and an arylalkyl group having 7 to 25 carbon atoms, which has an acid group. More specific examples thereof include a phenyl group having an acid group and a benzyl group having an acid group. The acid group is preferably a hydroxyl group. That is, $R^{113}$ or $R^{114}$ is preferably a group having a hydroxyl group.

As the monovalent organic group represented by $R^{113}$ or $R^{114}$, a substituent that improves the solubility of a developer is preferably used.

$R^{113}$ or $R^{114}$ is more preferably a hydrogen atom, 2-hydroxybenzyl, 3-hydroxybenzyl, or 4-hydroxybenzyl from the viewpoint of solubility in an aqueous developer.

From the viewpoint of solubility in an organic solvent, $R^{113}$ or $R^{114}$ is preferably a monovalent organic group. The monovalent organic group preferably contains a linear or a branched alkyl group, a cyclic alkyl group, or an aromatic group, and more preferably an alkyl group substituted with an aromatic group.

The alkyl group preferably has 1 to 30 carbon atoms (3 or more carbon atoms in the case of a cyclic group). The alkyl group may be linear, branched, or cyclic. Examples of the linear or branched alkyl group include a methyl group, an ethyl group, a propyl group, a butyl group, a pentyl group, a hexyl group, a heptyl group, an octyl group, a nonyl group, a decyl group, a dodecyl group, a tetradecyl group, an octadecyl group, an isopropyl group, an isobutyl group, a sec-butyl group, a t-butyl group, a 1-ethylpentyl group, and a 2-ethylhexyl group. The cyclic alkyl group may be a monocyclic cyclic alkyl group or a polycyclic cyclic alkyl group. Examples of the monocyclic cyclic alkyl group include a cyclopropyl group, a cyclobutyl group, a cyclopentyl group, a cyclohexyl group, a cycloheptyl group, and a cyclooctyl group. Examples of the polycyclic cyclic alkyl group include an adamantyl group, a norbornyl group, a bornyl group, a camphenyl group, a decahydronaphthyl group, a tricyclodecanyl group, a tetracyclodecanyl group, a camphoroyl group, a dicyclohexyl group, and a pinenyl group. In addition, the alkyl group substituted with an aromatic group is preferably a linear alkyl group substituted with an aromatic group as described next.

Specifically, the aromatic group is a substituted or unsubstituted aromatic hydrocarbon group (examples of the cyclic structure constituting the group include a benzene ring, a naphthalene ring, a biphenyl ring, a fluorene ring, a pentalene ring, an indene ring, an azulene ring, a heptalene ring, an indacene ring, a perylene ring, a pentacene ring, an acenaphthene ring, a phenanthrene ring, an anthracene ring, a naphthacene ring, a chrysene ring, and a triphenylene ring) or a substituted or unsubstituted aromatic heterocyclic group (examples of the cyclic structure constituting the group include fluorene ring, a pyrrole ring, a furan ring, a thiophene ring, an imidazole ring, an oxazole ring, a thiazole ring, a pyridine ring, a pyrazine ring, a pyrimidine ring, a pyridazine ring, an indolizine ring, an indole ring, a benzofuran ring, a benzothiophene ring, an isobenzofuran ring, a quinolizine ring, a quinoline ring, a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring, and a phenazine ring).

In addition, it is also preferable that the polyimide precursor has a fluorine atom in the constitutional unit. A content of fluorine atoms in the polyimide precursor is preferably 10% by mass or higher and preferably 20% by mass or lower. The upper limit is not particularly limited, but it is practically 50% by mass or less.

In addition, for the purpose of improving adhesion to a substrate, an aliphatic group having a siloxane structure may be copolymerized to a constitutional unit represented by Formula (1). Specific examples of the diamine components include bis(3-aminopropyl)tetramethyldisiloxane and bis(paraaminophenyl)octamethyl pentasiloxane.

The constitutional unit represented by Formula (1) is preferably a constitutional unit represented by Formula (1-A) or (1-B).

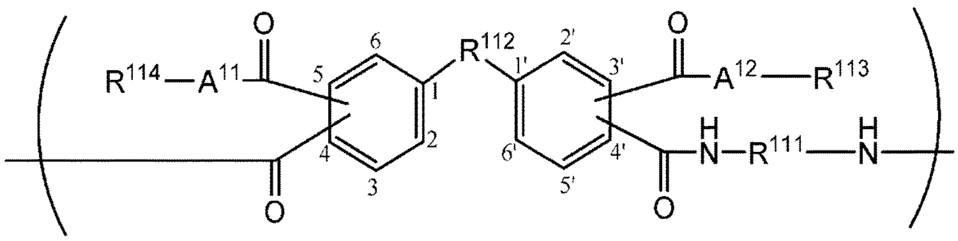
(1-A)

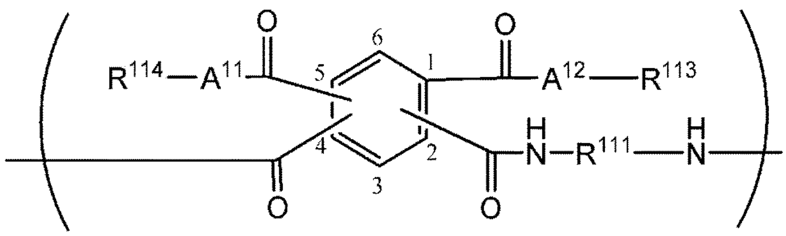
(1-B)

$A^{11}$ and $A^{12}$ represent an oxygen atom or NH, $R^{111}$ and $R^{112}$ each independently represent a divalent organic group, $R^{113}$ and $R^{114}$ each independently represent a hydrogen atom or a monovalent organic group, and at least one of $R^{113}$ or $R^{114}$ is preferably a group containing a radically polymerizable group and more preferably a radically polymerizable group.

The respective preferred ranges of $A^{11}$, $A^{12}$, $R^{111}$, $R^{113}$, and $R^{114}$ are independently the same as the preferred ranges as $A^1$, $A^2$, $R^{111}$, $R^{113}$, and $R^{114}$ in Formula (1).

The preferred range of $R^{112}$ is the same as that of $R^{112}$ in Formula (5), and among the preferred range, more preferably an oxygen atom.

The bonding position of the carbonyl group to the benzene ring in the formula is preferably 4, 5, 3', or 4' in Formula (1-A). In Formula (1-B), the bonding position is preferably 1, 2, 4, or 5.

In the polyimide precursor, a constitutional unit represented by Formula (1) may be one type or two or more types. In addition, the polyimide precursor may contain a structural isomer of the constitutional unit represented by Formula (1). In addition, the polyimide precursor may also contain other types of constitutional units in addition to the constitutional unit of Formula (1).

As one embodiment of the polyimide precursor in the present invention, a polyimide precursor in which the constitutional unit represented by Formula (1) accounts for 50% by mole or more, further 70% by mole or more, and particularly 90% by mole or more in the entirety of the constitutional units is exemplified. The upper limit is practically 100% by mole or less.

The weight-average molecular weight (Mw) of the polyimide precursor is preferably 2,000 to 500,000, more preferably 5,000 to 100,000, and still more preferably 10,000 to 50,000. In addition, the number-average molecular weight (Mn) thereof is preferably 800 to 250,000, more preferably 2,000 to 50,000, and still more preferably 4,000 to 25,000.

The degree of dispersion of the molecular weight of the polyimide precursor is preferably 1.5 to 3.5 and more preferably 2 to 3.

The polyimide precursor is obtained by reacting dicarboxylic acid or a dicarboxylic acid derivative with diamine. Preferably, the polyimide precursor is obtained by halogenating dicarboxylic acid or a dicarboxylic acid derivative with a halogenating agent and then causing the resultant to be reacted with diamine.

In the method for manufacturing the polyimide precursor, it is preferable to use an organic solvent at the time of reaction. One type of the organic solvent may be used, or two or more types of thereof may be used.

The organic solvent can be appropriately determined according to raw materials, and examples thereof include pyridine, diethylene glycol dimethyl ether (diglyme), N-methylpyrrolidone, and N-ethylpyrrolidone.

In a case of producing the polyimide precursor, it is preferable to include a step of precipitating a solid. Specifically, the polyimide precursor in a reaction solution is precipitated in water and dissolved in a solvent in which the polyimide precursor such as a tetrahydrofuran or the like can be solubilized, and then the solid can be precipitated.

<<Polybenzoxazole precursor>>

The polybenzoxazole precursor preferably contains a constitutional unit represented by Formula (2).

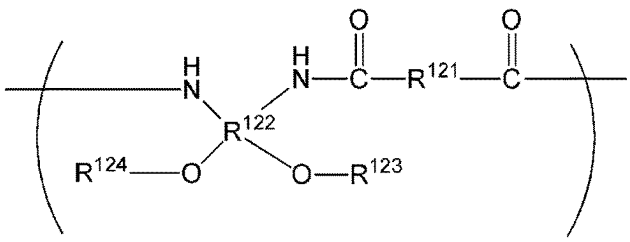

(2)

$R^{121}$ represents a divalent organic group, $R^{122}$ represents a tetravalent organic group, and $R^{123}$ and $R^{124}$ each independently represent a hydrogen atom or a monovalent organic group.

$R^{121}$ represents a divalent organic group. The divalent organic group is preferably a group including at least one of an aliphatic group (having preferably 1 to 24 carbon atoms, more preferably 1 to 12 carbon atoms, and particularly preferably 1 to 6 carbon atoms) or an aromatic group (having preferably 6 to 22 carbon atoms, more preferably 6 to 14 carbon atoms, and particularly preferably having 6 to 12 carbon atoms). Examples of the aromatic group constituting $R^{121}$ include the examples of $R^{111}$ of Formula (1). The aliphatic group is preferably a linear aliphatic group. $R^{121}$ is preferably derived from 4,4'-oxydibenzoyl chloride.

In Formula (2), $R^{122}$ represents a tetravalent organic group. The tetravalent organic group is the same as $R^{115}$ in Formula (1) described above, and the preferred range thereof is also the same as that of $R^{115}$. $R^{122}$ is preferably derived from 2,2'-bis (3-amino-4-hydroxyphenyl) hexafluoropropane.

$R^{123}$ and $R^{124}$ each independently represent a hydrogen atom or a monovalent organic group, which are respectively the same as $R^{113}$ and $R^{114}$ in Formula (1) described above, and the preferred range thereof is also the same as that of $R^{113}$ and $R^{114}$.

The polybenzoxazole precursor may contain another type of constitutional unit in addition to the constitutional unit of Formula (2).

From the viewpoint that occurrence of warping of a cured film due to ring closure can be suppressed, the

precursor preferably contains a diamine residue represented by Formula (SL) as the other type of constitutional unit.

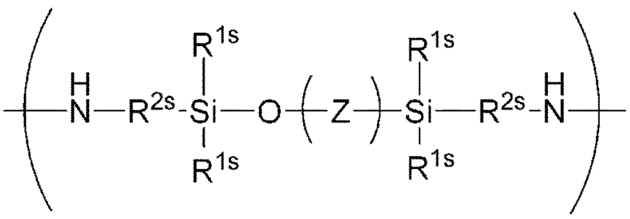 (SL)

a: 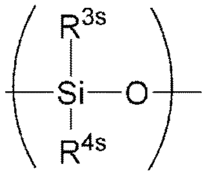 b: 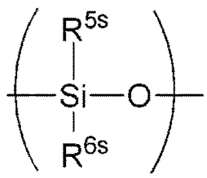

Z has an a structure and a b structure; $R^{1s}$ is a hydrogen atom or a hydrocarbon group having 1 to 10 carbon atoms (preferably 1 to 6 carbon atoms and more preferably 1 to 3 carbon atoms); $R^{2s}$ is a hydrocarbon group having 1 to 10 carbon atoms (preferably 1 to 6 carbon atoms and more preferably 1 to 3 carbon atoms); and at least one of $R^{3s}$, $R^{4s}$, $R^{5s}$, or $R^{6s}$ is an aromatic group (preferably having 6 to 22 carbon atoms, more preferably 6 to 18 carbon atoms, and particularly preferably 6 to 10 carbon atoms), and the rest are hydrogen atoms or organic groups having 1 to 30 carbon atoms (preferably 1 to 18 carbon atoms, more preferably 1 to 12 carbon atoms, and particularly preferably 1 to 6 carbon atoms), where the organic groups may be the same or different from each other. The polymerization of the a structure and the b structure may be block polymerization or random polymerization. In the Z portion, it is preferable that the a structure is 5% to 95% by mole, the b structure is 95% to 5% by mole, and a + b is 100% by mole.

In Formula (SL), as a preferable Z, the b structure in which $R^{5s}$ and $R^{6s}$ are phenyl groups is mentioned. In addition, the molecular weight of a structure represented by Formula (SL) is preferably 400 to 4,000 and more preferably 500 to 3,000. The molecular weight can be obtained by gel permeation chromatography which is commonly used. In a case where the molecular weight is set to be within the above-described range, it is possible to decrease a modulus of elasticity of the polybenzoxazole precursor after the dehydration ring closure and to achieve both effects of suppressing warping and improving solubility.

In a case where the precursor contains a diamine residue represented by Formula (SL) as the other type of constitutional unit, from the viewpoint of improving alkaline solubility, it is preferable that the precursor further contain a tetracarboxylic acid residue that remains after removing an acid dianhydride group from tetracarboxylic acid dianhydride, as a constitutional unit. Examples of such a tetracarboxylic acid residue include the examples of $R^{115}$ in Formula (1).

The weight-average molecular weight (Mw) of the polybenzoxazole precursor is preferably 2,000 to 500,000, more preferably 5,000 to 100,000, and still more preferably 10,000 to 50,000. In addition, the number-average molecular weight (Mn) thereof is preferably 800 to 250,000, more preferably 2,000 to 50,000, and still more preferably 4,000 to 25,000.

The degree of dispersion of the molecular weight of the polybenzoxazole precursor is preferably 1.5 to 3.5 and more preferably 2 to 3.

The content of the polymer precursor in the photosensitive resin composition according to the embodiment of the present invention is preferably 20% by mass or more, more preferably 30% by mass or more, still more preferably 40% by mass or more, even more preferably 50% by mass or more, even still more preferably 60% by mass or more, and even still further more preferably 70% by mass or more, with respect to the total solid content of the composition. In addition, the content of the polymer precursor in the photosensitive resin composition according to the embodiment of the present invention is preferably 99.5% by mass or less, more preferably 30% to 99% by mass or less, still more preferably 99% by mass or less, even more preferably 98% by mass or less, even still more preferably 95% by mass or less, and even still further more preferably 95% by mass or less, with respect to the total solid content of the composition.

The photosensitive resin composition according to the embodiment of the present invention may contain only one type of the polymer precursor or may contain two or more types thereof. In a case where two or more types are contained, the total amount thereof is preferably within the above-described range.

<Thermal base generator>

The thermal base generator according to the embodiment of the present invention is represented by Formula (N1). Hereinafter, this thermal base generator may be referred to as the "specific thermal base generator" to distinguish it

from other thermal base generators.

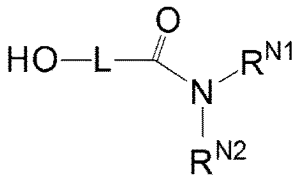

Formula (N1)

In Formula (N1), L represents a hydrocarbon group which is a divalent hydrocarbon group having a saturated hydrocarbon group on a path of a linking chain that links adjacent oxygen atom and carbon atom and in which the number of the atoms on the path of the linking chain is 4, 5 or 6. Further, $R^{N1}$ and $R^{N2}$ each independently represent a monovalent organic group.

In the present specification, the "saturated hydrocarbon group" refers to a hydrocarbon group having at least one carbon atom that is single-bonded to each of the four atoms. A simple example of such a hydrocarbon group is $-CH_2-$ (a methylene group). The "linking chain" refers to an atomic chain which interconnects linking targets shortest (with the minimum number of atoms) among the atomic chains on the path, which interconnects two atoms or a group of atoms to be linked. For example, in the exemplified compound B-1 described later, L is composed of a phenylene ethylene group, has an ethylene group as a saturated hydrocarbon group, and the linking chain is composed of four carbon atoms, and the number of atoms (that is, the number of atoms constituting the linking chain, and hereinafter, also referred to as the "linking chain length" or the "length of linking chain") on the path of the linking chain is 4.

The specific thermal base generator is acidic or neutral at room temperature and does not promote the cyclization of the precursor of the heterocyclic ring-containing polymer. Accordingly, the photosensitive resin composition according to the embodiment of the present invention containing the above-described specific thermal base generator is excellent in storage stability. On the other hand, in the above-described specific thermal base generator, the nucleophilic action of the hydroxyl group is activated by heating, and the oxygen atom in the hydroxyl group is bonded to the carbon atom in the carbonyl group as exemplified in the following reaction formula, whereby the cyclization reaction proceeds rapidly in the molecule. As a result, the carbonyl group and the nitrogen atom of the amide structure (-C(=O)-N=) portion in the formula are rapidly dissociated, and an amine (preferably, a secondary amine) is efficiently generated. Accordingly, after heating, the cyclization of the precursor of the heterocyclic ring-containing polymer is effectively promoted by the base that is generated from this specific thermal base generator, and thus the obtained cured film is excellent in breaking elongation.

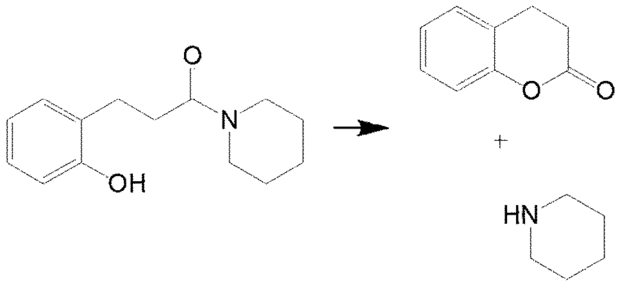

The above-described base generator (a base generator for a comparative example described later) of JP2011-121962A also has a structure in which an amide structure and a hydroxyl group are linked by a divalent hydrocarbon group. However, in the base generator of JP2011-121962A, the divalent hydrocarbon group is composed of an ethylenic double bond and a phenylene group, and thus it is presumed that the base generator has high structural rigidity and has a low intramolecular rotational degree of freedom. As a result, it is presumed that the base generator of JP2011-121962A did not improve the base generating efficiency since the intramolecular cyclization reaction is not easily proceed.

On the other hand, in the thermal base generator in the composition according to the embodiment of the present invention, the divalent hydrocarbon group that links the amide structure and the hydroxyl group has a saturated hydrocarbon group on the path of the linking chain. As a result, it is presumed that the thermal base generator has a high steric rotational degree of freedom, the intramolecular cyclization reaction proceeds rapidly, and thus the base generating efficiency is high.

In the present invention, the number of carbon atoms in L in Formula (N1) (including carbon atoms other than the carbon atoms in the linking chain) is preferably 4 to 24. The upper limit thereof is more preferably 12 or less, still more preferably 10 or less, and particularly preferably 8 or less. From the viewpoint of rapidly advancing the intramolecular cyclization reaction, the linking chain length of L is 4, 5 or 6. In particular, the linking chain length of L is preferably 4 or 5 and

most preferably 4.

L in Formula (N1) may be an aliphatic hydrocarbon group (the first embodiment) or may have an arylene group on the linking chain (the second embodiment). Hereinafter, each embodiment of L will be described. In each case, L represents a hydrocarbon group which is a divalent hydrocarbon group having a saturated hydrocarbon group on a path of a linking chain which links an oxygen atom and an adjacent carbon atom and in which the number of the atoms on the path of the linking chain is 4, 5 or 6, wherein the linking chain refers to an atomic chain which interconnects the linking targets with the minimum number of atoms.

A first embodiment of L in Formula (N1) useful for understanding the invention is an aliphatic hydrocarbon group having 3 or more carbon atoms. The aliphatic hydrocarbon group may have the substituent T described below or may have an atom (particularly, an oxygen atom) other than a carbon atom on the path of the linking chain. The aliphatic hydrocarbon group preferably has 3 to 12 carbon atoms, more preferably 3 to 6 carbon atoms, and still more preferably 4 or 5 carbon atoms, from the viewpoint of rapidly advancing the intramolecular cyclization reaction. Specifically, the aliphatic hydrocarbon group is a linear or branched chain-like alkylene group, a cyclic alkylene group, a group involved in the combination of a chain-like alkylene group and a cyclic alkylene group, an alkylene group having an oxygen atom in the chain, a linear or branched chain-like alkenylene group, a cyclic alkenylene group, or the like.

The linear or branched chain-like alkylene group preferably has 4 to 12 carbon atoms, more preferably 4 to 6 carbon atoms, and still more preferably 4 or 5 carbon atoms. Examples of the linear or branched chain-like alkylene group are a methylene group, an ethylene group, a propanediyl group, a butanediyl group, a pentanediyl group, a hexanediyl group, a heptanediyl group, an octanediyl group, a nonanediyl group, a decanediyl group, an undecanediyl group, and dodecanediyl group.

The cyclic alkylene group preferably has 4 to 12 carbon atoms, more preferably 5 to 10 carbon atoms, and still more preferably 6 to 8 carbon atoms. Examples of the cyclic alkylene group are a cyclopentanediyl group, a cyclohexanediyl group, a cycloheptanediyl group, and a cyclooctanediyl group.

The group involved in the combination of a chain-like alkylene group and a cyclic alkylene group preferably has 4 to 24 carbon atoms, more preferably 5 to 12 carbon atoms, and still more preferably 6 to 10 carbon atoms. Examples of the group involved in the combination of a chain-like alkylene group and a cyclic alkylene group are a methylene cyclohexanediyl group, an ethylene cyclohexanediyl group, a propylene cyclohexanediyl group, a methylene cyclohexanediylmethylene group, and an ethylene cyclohexanediylethylene group.

The alkylene group having an oxygen atom in the chain may be linear, branched, or cyclic. Such an alkylene group preferably has 2 to 12 carbon atoms, more preferably 3 to 8 carbon atoms, and still more preferably 4 to 6 carbon atoms. Examples of such an alkylene group are a methylene oxymethylene group, an ethylene oxyethylene group, a propylene oxypropylene group, and a butylene oxybutylene group.

The linear or branched chain-like alkenylene group preferably has 4 to 12 carbon atoms, more preferably 4 to 8 carbon atoms, and still more preferably 4 to 6 carbon atoms. The number of C= C bonds in such an alkenylene group is preferably 1 to 10, more preferably 1 to 6, and still more preferably 1 to 3. In particular, the number of C=C bonds is preferably 1 on the path of the linking chain of L. Examples of such an alkenylene group are a propenylene group, an isopropenylene group, a butenylene group, and an isobutenylene group.

The cyclic alkenylene group preferably has 4 to 12 carbon atoms, more preferably 5 to 10 carbon atoms, and still more preferably 6 to 8 carbon atoms. The number of C= C bonds in the cyclic alkenylene group is preferably 1 to 6, more preferably 1 to 4, and still more preferably 1 or 2. In particular, the number of C=C bonds is preferably 1 on the path of the linking chain of L. Examples of the cyclic alkenylene group are a cyclopropenediyl group, a cyclobutenediyl group, and a cyclohexenediyl group.

(Substituent T)

Examples of the substituent T includes a halogen atom, a cyano group, a nitro group, a hydrocarbon group, a heterocyclic group, $-ORt^1$, $-CORt^1$, $-COORt^1$, $-OCORt^1$, $-NRt^1Rt^2$, $-NHCORt^1$, $CONRt^1Rt^2$, $-NHCONRt^1Rt^2$, $-NHCOORt^1$, $-SRt^1$, $-SO_2Rt^1$, $-SO_2ORt^1$, $-NHSO_2Rt^1$, and $-SO_2NRt^1Rt^2$. $Rt^1$ and $Rt^2$ each independently represent a hydrogen atom, a hydrocarbon group, or a heterocyclic group. $Rt^1$ and $Rt^2$ may be combined to form a ring.

Regarding the substituent T, examples of the halogen atom include a fluorine atom, a chlorine atom, a bromine atom, and an iodine atom. Examples of the hydrocarbon group include an alkyl group, an alkenyl group, an alkynyl group, and an aryl group. The alkyl group preferably has 1 to 30 carbon atoms, more preferably 1 to 15 carbon atoms, and still more preferably 1 to 8 carbon atoms. The alkyl group may be linear, branched, or cyclic, preferably linear or branched, and more preferably branched. The alkenyl group preferably has 2 to 30 carbon atoms, more preferably 2 to 12 carbon atoms, and particularly preferably 2 to 8 carbon atoms. The alkenyl group may be linear, branched, or cyclic and preferably linear or branched. The alkynyl group preferably has 2 to 30 carbon atoms and more preferably 2 to 25 carbon atoms. The alkynyl group may be linear, branched, or cyclic and preferably linear or branched. The aryl group preferably has 6 to 30 carbon atoms, more preferably 6 to 20 carbon atoms, and still more preferably 6 to 12 carbon atoms. The heterocyclic group may

be a monocyclic ring or a fused ring. The heterocyclic group is preferably a monocyclic ring or a fused ring having 2 to 4 fused rings. The number of hetero atoms constituting the ring of the heterocyclic group is preferably 1 to 3. The hetero atom constituting the ring of the heterocyclic group is preferably a nitrogen atom, an oxygen atom, or a sulfur atom. The number of carbon atoms constituting the ring of the heterocyclic group is preferably 3 to 30, more preferably 3 to 18, and still more preferably 3 to 12.

The hydrocarbon group and the heterocyclic group may further have a substituent or may be unsubstituted. Examples of the substituent include the substituents described above for the substituent T.

A second embodiment of L in Formula (N1) useful for understanding the invention is a hydrocarbon group having 3 or more carbon atoms and having an arylene group on the linking chain. L is particularly preferably composed of a hydrocarbon group represented by Formula (N2-a) or Formula (N2-b).

$-L^1-Ar-L^2-$ Formula (N2-a);

$-Ar^1-L^3-Ar^2-$ Formula (N2-b);

In Formula (N2-a), $L^1$ and $L^2$ each independently represent a single bond or a hydrocarbon group, at least one of $L^1$ or $L^2$ contains a saturated hydrocarbon group on the path of the linking chain, and Ar represents an arylene group. In addition, the length of the linking chain which links $L^1$ and $L^2$ of Ar is preferably 2 or 3. That is, in a case where Ar is a phenylene group, it is preferable that $L^1$ and $L^2$ are bonded to each other at the ortho or meta position. $L^1$, $L^2$, and Ar may each independently have the substituent T.

In Formula (N2-b), $L^3$ represents a hydrocarbon group containing a saturated hydrocarbon group on the path of the linking chain which links $Ar^1$ and $Ar^2$, and $Ar^1$ and $Ar^2$ each independently represent an arylene group. In addition, the length of the linking chain which links adjacent oxygen atom in $Ar^1$ and $L^3$ is preferably 2 or 3. That is, in a case where $Ar^1$ is a phenylene group, it is preferable that the adjacent oxygen atom and $L^3$ are bonded to each other at the ortho or meta position. Further, the length of the linking chain which links adjacent carbon atom in $Ar^2$ and $L^3$ is preferably 2 or 3. That is, in a case where $Ar^2$ is a phenylene group, it is preferable that the adjacent carbon atom and $L^3$ are bonded to each other at the ortho or meta position. $L^3$, $Ar^1$, and $Ar^2$ may each independently have the substituent T.

It is preferable that the hydrocarbon groups $L^1$, $L^2$, and $L^3$ are each independently a linear or branched chain-like alkylene group having 1 to 10 carbon atoms. Here, the number of carbon atoms is more preferably 1 to 6, still more preferably 1 to 4, and particularly preferably 1 or 2. Examples of such a chain-like alkylene group are a methylene group, an ethylene group, a propylene group, a butylene group, a pentanediyl group, and a hexanediyl group.

The arylene groups Ar, $Ar^1$, and $Ar^2$ preferably has 5 to 22 carbon atoms, more preferably 6 to 18 carbon atoms, and still more preferably 6 to 10 carbon atoms. Examples of the arylene group are a phenylene group, a naphthylene group, an anthracenediyl group, and a phenanthrenediyl group, and the arylene group is preferably a phenylene group or a naphthylene group.

Examples of the hydrocarbon group represented by Formula (N2-a) or Formula (N2-b) are an arylene alkylene group having 7 to 23 carbon atoms, and the number of carbon atoms thereof is preferably 7 to 19 and more preferably 7 to 11. More specific examples of such an arylene alkylene group are a phenylene methylene group, a phenylene ethylene group, a naphthylene methylene group, a naphthylene ethylene group, a phenylene-n-butanediyl group, a phenylene isobutanediyl group, an ortho-xylenediyl group, a meta-xylenediyl group, an ortho-ethylene phenylene ethylene group, an ortho-methylene phenylene ethylene group, a meta-methylene phenylene ethylene group, a phenylene methylene phenylene group, and a phenylene ethylene phenylene group.

On the other hand, in the present invention, $R^{N1}$ and $R^{N2}$ in Formula (N1) each independently represent a monovalent organic group (preferably having 1 to 24 carbon atoms, more preferably 2 to 18 carbon atoms, and still more preferably 3 to 12 carbon atoms), more preferably a hydrocarbon group (preferably having 1 to 24 carbon atoms, more preferably 1 to 12 carbon atoms, and still more preferably 1 to 10 carbon atoms), and specific examples thereof include an aliphatic hydrocarbon group (preferably having 1 to 24 carbon atoms, more preferably 1 to 12 carbon atoms, and still more preferably 1 to 10 carbon atoms) and an aromatic hydrocarbon group (preferably having 6 to 22 carbon atoms, more preferably 6 to 18 carbon atoms, and still more preferably 6 to 10 carbon atoms), and an aliphatic hydrocarbon group is preferable. As $R^{N1}$ and $R^{N2}$, an aliphatic hydrocarbon group is preferably used since the basicity of the base that is generated is high.

Such an aliphatic hydrocarbon group and an aromatic hydrocarbon group may have the substituent T. In particular, from the viewpoint of promoting the intramolecular cyclization reaction of the specific thermal base generator, an aliphatic hydrocarbon group and an aromatic hydrocarbon group preferably have a polar group (for example, a hydroxyl group, a carboxyl group, a carbonyl group, a cyano group, a halogen group, an amide bond, and an ester bond) as a substituent or a part of the substituent). More specifically, the polar group is preferably at least one of a hydroxyl group, a carboxyl group, a cyano group, a nitro group, an alkylcarbonyl group, an alkyloxycarbonyl group, an arylcarbonyl group, an aryloxycarbonyl group, an aminocarbonyl group, an alkoxy group, an aryloxy group, a sulfo group, an alkylsulfonyl group,

an arylsulfonyl group, an alkyloxysulfonyl group, an aryloxysulfonyl group, an aminosulfonyl group, or a halogen group, more preferably a substituent containing an oxygen atom among the above, and still more preferably at least one of a hydroxyl group or a carboxyl group. In addition, the above-described aliphatic hydrocarbon group and aromatic hydrocarbon group may have an oxygen atom in the aliphatic hydrocarbon chain or the aromatic ring.

Examples of the aliphatic hydrocarbon group constituting $R^{N1}$ and $R^{N2}$ include a linear or branched chain-like alkyl group, a cyclic alkyl group, a group involved in the combination of a chain-like alkyl group and a cyclic alkyl group, and an alkyl group having an oxygen atom are contained in the chain.

The linear or branched chain-like alkyl group preferably has 1 to 24 carbon atoms, more preferably 2 to 18 carbon atoms, and still more preferably 3 to 12 carbon atoms. Examples of the linear or branched chain-like alkyl group are a methyl group, an ethyl group, a propyl group, a butyl group, a pentyl group, a hexyl group, a heptyl group, an octyl group, a nonyl group, a decyl group, an undecyl group, and a dodecyl group.

The cyclic alkyl group preferably has 3 to 12 carbon atoms and more preferably 3 to 6 carbon atoms. Examples of the cyclic alkyl group are a cyclopropyl group, a cyclobutyl group, a cyclopentyl group, a cyclohexyl group, and a cyclooctyl group.

The group involved in the combination of a chain-like alkyl group and a cyclic alkyl group preferably has 4 to 24 carbon atoms, more preferably 4 to 18 carbon atoms, and still more preferably 4 to 12 carbon atoms. Examples of the group involved in the combination of the chain-like alkyl group and the cyclic alkyl group are a cyclohexylmethyl group, a cyclohexylethyl group, a cyclohexylpropyl group, a methylcyclohexylmethyl group, and an ethylcyclohexylethyl group.

The alkyl group having an oxygen atom in the chain preferably has 2 to 12 carbon atoms, more preferably 2 to 6 carbon atoms, and still more preferably 2 to 4 carbon atoms. The alkyl group having an oxygen atom in the chain may be linear, branched, or cyclic.

Among them, from the viewpoint of enhancing the basicity of the base that is generated, $R^{N1}$ and $R^{N2}$ are preferably an alkyl group having 5 to 12 carbon atoms. However, in a case where a long-chain chain-like alkyl group is used in the photosensitive resin composition, adhesion may be inferior in a case where the cured film is laminated with a metal (for example, copper) layer, and in a formulation that emphasizes this point, $R^{N1}$ and $R^{N2}$ are preferably a group having a cyclic alkyl group or an alkyl group having 1 to 8 carbon atoms in that the inferiority in adhesion can be suppressed and maintain good adhesion to the metal layer.

$R^{N1}$ and $R^{N2}$ may be linked to each other to form a cyclic structure. In forming the cyclic structure, an oxygen atom or the like may be contained in the main chain of the cyclic structure. The cyclic structure formed by $R^{N1}$ and $R^{N2}$ can be a monocyclic ring or may be a fused ring but is preferably a monocyclic ring. The cyclic structure to be formed is preferably a 5-membered ring or a 6-membered ring containing a nitrogen atom in Formula (N1), examples thereof include a pyrrole ring, an imidazole ring, a pyrazole ring, a pyrroline ring, a pyrrolidine ring, an imidazolidine ring, a pyrazolidine ring, a piperidine ring, a piperazine ring, and a morpholine ring, and preferred examples thereof include a pyrroline ring, a pyrrolidine ring, a piperidine ring, a piperazine ring, and a morpholine ring. The cyclic structure is preferably an aliphatic cyclic structure from the viewpoint of improving the basicity of the base that is generated. Further, the cyclic structure preferably has the above-described polar group as a substituent or as a part of the substituent from the viewpoint of promoting the intramolecular cyclization reaction.

In the present invention, the specific thermal base generator is more preferably a compound represented by Formula (N3).

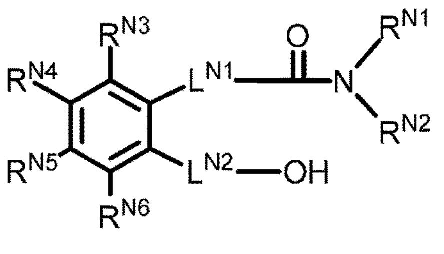

Formula (N3)

In Formula (N3), $L^{N1}$ and $L^{N2}$ each independently represent a single bond or a linear or branched alkylene group having 1 to 10 carbon atoms, and at least one of $L^{N1}$ or $L^{N2}$ is a linear or branched alkylene group having 1 to 10 carbon atoms. In addition, in Formula (N3), $R^{N1}$ and $R^{N2}$ are respectively the same meaning as $R^{N1}$ and $R^{N2}$ in Formula (N1) and may be linked to each other form a cyclic structure. $R^{N3}$ to $R^{N6}$ each independently represent a hydrogen atom, a halogen atom, or a monovalent organic group. In $R^{N3}$ to $R^{N6}$, two or more of them may be bonded to form a cyclic structure, or a heteroatom bond may be included.

$L^{N1}$ and $L^{N2}$ are preferably single-bond or a linear or branched alkylene groups having 1 to 6 carbon atoms. Further, in the case of being an alkylene group, it is more preferable that $L^{N1}$ and $L^{N2}$ are an alkylene group having 1 to 4 carbon atoms, in which the length of the linking chain which links adjacent carbon atoms is 2 or 3. Examples of the preferred

aspect of $L^{N1}$ and $L^{N2}$ are an aspect in which $L^{N1}$ is an alkylene group having a linking chain length of 2 or 3 and include an aspect in which $L^{N2}$ is a single bond, an aspect in which $L^{N1}$ and $L^{N2}$ are each independently an alkylene group having a linking chain length of 1 or 2, and an aspect in which $L^{N1}$ is a single bond and $L^{N2}$ is an alkylene group having a linking chain length of 2 or 3. $L^{N1}$ and $L^{N2}$ may each independently have the substituent T.

In $R^{N3}$ to $R^{N6}$, the halogen atom is preferably a fluorine atom, a chlorine atom, or a bromine atom and preferably a fluorine atom or a chlorine atom.

In $R^{N3}$ to $R^{N6}$, the monovalent organic group is preferably a hydrocarbon group consisting of one or a combination of two or more selected from the group consisting of a linear or branched chain-like alkyl group, a cyclic alkyl group, a linear or branched chain-like alkenyl group, a cyclic alkenyl group, an alkyl group having an oxygen atom in the chain, and an aryl group. In addition, the hydrocarbon group described above may have the substituent T.

In $R^{N3}$ to $R^{N6}$, the monovalent organic group may contain a bond containing a heteroatom or a substituent in addition to the hydrocarbon group. Examples of such a bond include an ether bond, a thioether bond, a carbonyl bond, a thiocarbonyl bond, an ester bond, and an amide bond. In addition, examples of such a substituent include a hydroxyl group, a mercapto group, a cyano group, a silyl group, a silanol group, an alkoxy group, an alkoxycarbonyl group, a nitro group, a carboxyl group, an acyl group, an acyloxy group, a sulfino group, a sulfo group, an alkyl ether group, and an amino group.

In the present invention, the specific thermal base generator is still more preferably a compound represented by Formula (N4).

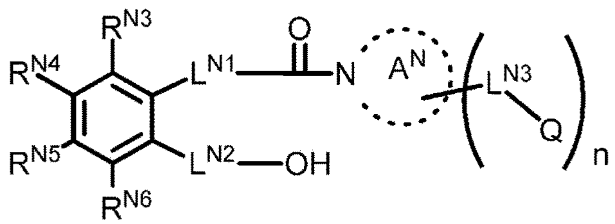

Formula (N4)

In Formula (N4), $L^{N1}$, $L^{N2}$, and $R^{N3}$ to $R^{N6}$ are respectively the same as $L^{N1}$, $L^{N2}$, and $R^{N3}$ to $R^{N6}$ in Formula (N3). In addition, $A^N$ represents a cyclic structure containing a nitrogen atom in Formula (N4), $L^{N3}$ represents a single bond or a divalent organic group independently for each parenthesis, and Q represents a polar group independently for each parenthesis. n represents an integer of 0 to 3, is preferably 1 or 2, and is more preferably 1.

$A^N$ is obtained by forming a cyclic structure in which $R^{N1}$ and $R^{N2}$ are linked to each other, may be a monocyclic ring, may be a fused ring, and is preferably a monocyclic ring. In a case of being a monocyclic ring, $A^N$ is preferably a 5-membered ring or a 6-membered ring, and a preferred cyclic structure thereof is as exemplified above. $A^N$ may have the substituent T other than $-L^{N3}-Q$.

In $L^{N3}$, the divalent organic group is not particularly limited, but it is preferably a hydrocarbon group capable of containing an oxygen atom. In addition, $L^{N3}$ is preferably a hydrocarbon group consisting of one or a combination of two or more selected from the group consisting of a linear or branched chain-like alkylene group, a cyclic alkylene group, an alkylene group having an oxygen atom in the chain, a linear or branched chain-like alkenylene group, a cyclic alkenylene group, and an arylene group. The details of each element are the same as the description of L in Formula (N1) and the description of Formula (N2) described above. In particular, $L^{N3}$ is preferably an alkylene group having 1 to 4 carbon atoms, which can have the substituent T.

From the viewpoint of compatibility with a precursor of a heterocyclic ring-containing polymer, the polar group Q is preferably at least one of a hydroxyl group, a carboxyl group, a cyano group, a nitro group, an alkylcarbonyl group, an alkyloxycarbonyl group, an arylcarbonyl group, an aryloxycarbonyl group, an aminocarbonyl group, an alkoxy group, or an aryloxy group, a sulfo group, an alkylsulfonyl group, an arylsulfonyl group, an alkyloxysulfonyl group, an aryloxysulfonyl group, an aminosulfonyl group, or a halogen group, more preferably a substituent containing an oxygen atom among the above, and still more preferably a hydroxyl group or a carboxyl group.

The present invention can have a configuration in which in a case where a base is generated from the specific thermal base generator, decomposition products other than the generated base are volatilized and substantially do not remain in the film. Here, "substantially do not remain" is preferably 1% by mass or less and may be 0.5% by mass or less or 0.1% by mass or less.

The specific thermal base generator represented by Formula (N1) is decomposed by heating to produce an amine compound represented by Formula (A1).

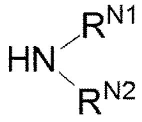

Formula (A1);

In Formula (A1), $R^{N1}$ and $R^{N2}$ are respectively the same as $R^{N1}$ and $R^{N2}$ in Formula (N1).

The specific thermal base generator is contained in a photosensitive resin composition, used in combination with a precursor of a heterocyclic ring-containing polymer, and decomposed by heating in the photosensitive resin composition to generate a base, thereby promoting the cyclization reaction of the polymer precursor and acting to effectively cure the composition. Further, the photosensitive resin composition is more preferably combined with a radically polymerizable compound and a photo-radical polymerization initiator. The decomposition temperature of the specific thermal base generator is not particularly limited, but it is preferably 50°C or higher, more preferably 80°C or higher, still more preferably 120°C or higher, and even still more preferably 140°C or higher. The upper limit thereof is preferably 450°C or lower, more preferably 350°C or lower, and still more preferably 250°C or lower. It is preferable to use a compound that is decomposed at a lower temperature since the photosensitive resin composition can be cured with lower energy consumption in a case of being used in the photosensitive resin composition. On the other hand, the decomposition temperature is preferably set to be equal to or higher than the above lower limit value, since the careless generation and action of the base during storage at room temperature are suppressed and the storage stability of the photosensitive resin composition is improved.

According to the specific thermal base generator according to the embodiment of the present invention, the photosensitive resin composition does not inhibit the photosensitivity by reacting with a photosensitizer (a photo-radical polymerization initiator or the like), a radically polymerizable compound, or the like, and particularly preferable since the photosensitivity after curing can be effectively maintained and good exposure and development characteristics can be exhibited thereafter.

From the viewpoint of setting the effective decomposition temperature in a suitable range as described above, the molecular weight of the specific thermal base generator is preferably 100 or more, more preferably 150 or more, still more preferably 200 or more, and even still more preferably 250 or more. The upper limit is practically 1,000 or less.

Examples of the thermal base generator represented by Formula (N1) include the following examples, but the present invention is not construed as being limited thereto. Compounds B-25 and B-28 are reference examples.

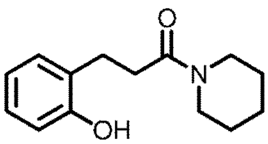

(B-1)

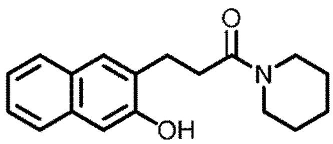

(B-2)

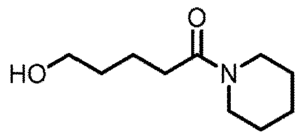

(B-3)

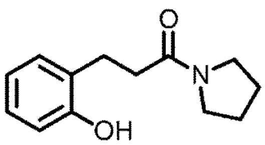

(B-4)

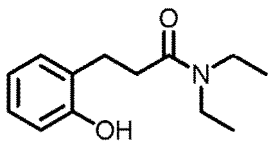

(B-5)

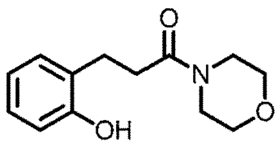

(B-6)

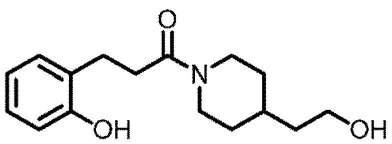

(B-7)

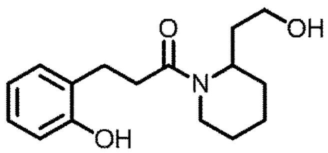

(B-8)

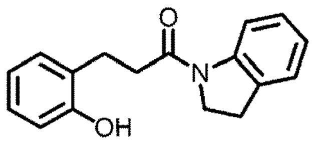

(B-9)

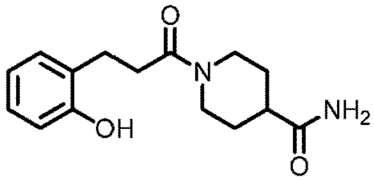
(B-10)

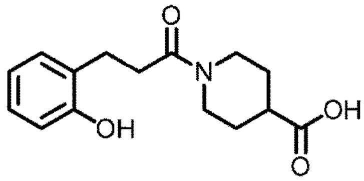
(B-11)

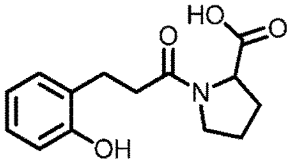
(B-12)

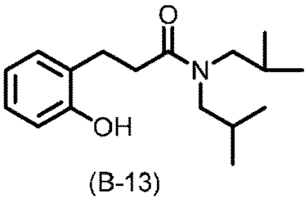
(B-13)

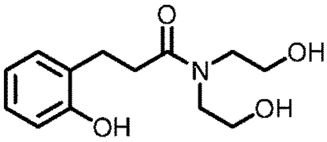
(B-14)

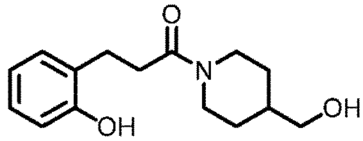
(B-15)

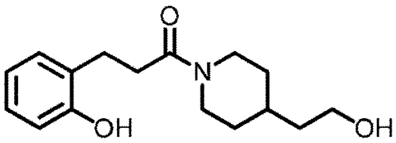
(B-16)

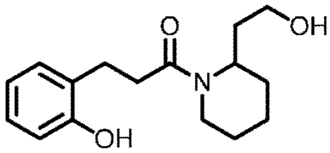
(B-17)

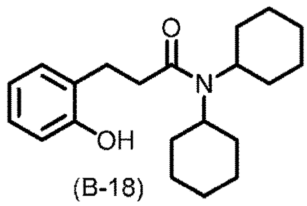
(B-18)

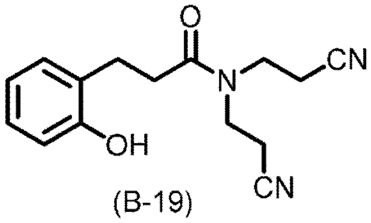
(B-19)

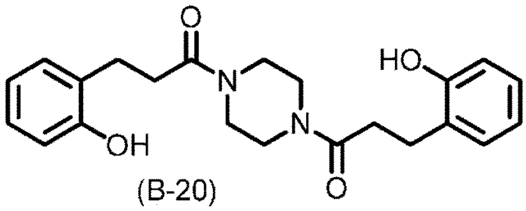
(B-20)

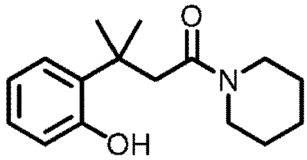
(B-21)

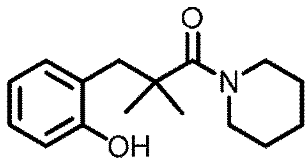
(B-22)

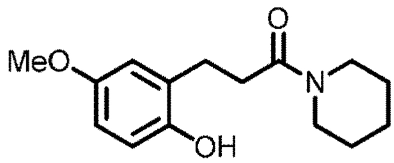
(B-23)

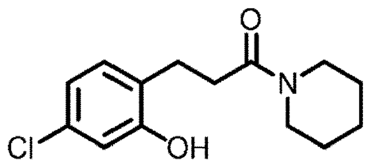
(B-24)

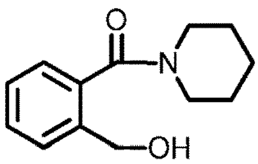
(B-25)

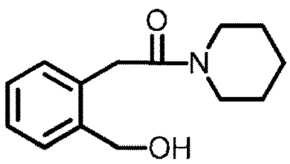
(B-26)

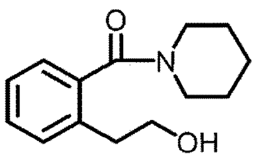
(B-27)

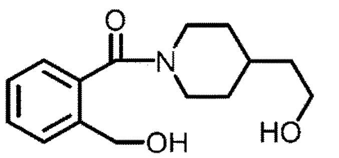
(B-28)

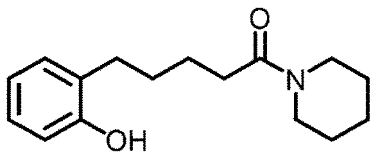
(B-29)

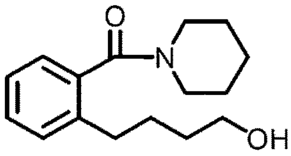
(B-30)

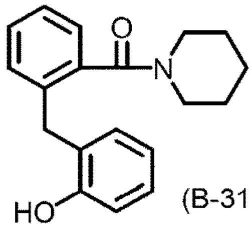
(B-31)

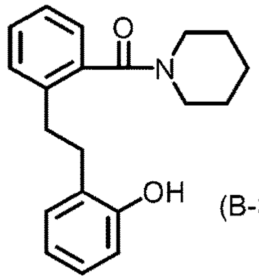
(B-32)

The thermal base generator represented by Formula (N1) can be produced by a conventional method. In addition, a commercially available reagent can be utilized.

In the specific thermal base generator represented by Formula (N1), the conjugate acid of the generated base preferably has a pKa of 8 or more, more preferably 9 or more, and still more preferably 10 or more. There is no particular upper limit of the pKa, but the upper limit thereof is practically 14 or less. The pKa of the specific thermal base generator is preferably set in the above range since the generated base can efficiently advance the cyclization reaction of the polymer precursor and the breaking elongation of the cured film can be increased at a low temperature. The pKa herein is a value specified by the following method.

The term "pKa" referred to in the present specification is represented by the negative common logarithm pKa of the equilibrium constant Ka of a dissociation reaction, in a case of assuming that hydrogen ions are released from an acid in the dissociation reaction. The smaller the pKa is, the stronger the acid is. Unless otherwise specified, pKa is a value calculated by ACD/ChemSketch (registered trade mark). Alternatively, the values published in "Handbook of Chemistry, Pure Chemistry, 5th Edition" edited by the Chemical Society of Japan may be referred to.

The content of the specific thermal base generator is preferably 0.005% to 50% by mass with respect to the total solid content of the photosensitive resin composition. The lower limit thereof is more preferably 0.05% by mass or more, still more preferably 0.5% by mass or more, and particularly preferably 1% by mass or more. The upper limit thereof is more preferably 20% by mass or less, still more preferably 10% by mass or less, and particularly preferably 5% by mass or less.

The content of the specific thermal base generator with respect to 100 parts by mass of the polymer precursor is preferably 0.005 parts by mass or more, more preferably 0.06 parts by mass or more, still more preferably 0.5 parts by mass or more, even still more preferably 1 part by mass or more. The upper limit is, for example, preferably 20 parts by mass or less, more preferably 15 parts by mass or less, still more preferably 10 parts by mass or less, and particularly preferably 7.5 parts by mass or less.

The content of the specific thermal base generator is preferably set to be equal to or more than the lower limit value described above since the good storage stability of the photosensitive resin composition can be ensured and the mechanical properties of the cured film can be suitably realized. The content thereof is preferably set to be equal to or less than the above upper limit value, since the corrosion resistance of the metal (for example, copper used for wiring or the like) can be ensured.

One type or two or more types of the specific thermal base generators may be used. In a case where two or more types thereof are used, the total amount is preferably within the above-described range.

The photosensitive resin composition according to the embodiment of the present invention may or may not contain a thermal base generator other than the specific thermal base generator. In a case where other thermal base generators are included, examples thereof include those described in WO2015/199219A and WO2015/199220A. In addition, the present invention can have a configuration in which other thermal base generators other than the specific thermal base generator are substantially not included. The description "substantially not included" means that the content of the specific thermal base generator contained in the photosensitive resin composition according to the embodiment of the present invention is 5% by mass or less, preferably 3% by mass or less, and more preferably 1% by mass.

In addition, the photobase generator may or may not be contained together with the specific thermal base generator.

<Photosensitizer>

The photosensitive resin composition according to the embodiment of the present invention preferably contains a photosensitizer. Examples of the photosensitizer include a photo-radical polymerization initiator, and may also include, for example, a photocuring accelerator, a thermal radical polymerization initiator, or a thermal acid generator.

<<Photopolymerization Initiator>>

The photopolymerization initiator that can be used as a photosensitizer is preferably a photo-radical polymerization initiator. The photo-radical polymerization initiator is not particularly limited and can be appropriately selected from known photo-radical polymerization initiators. For example, a photo-radical polymerization initiator having photosensitivity to rays ranging from an ultraviolet ray range to a visible region is preferable. In addition, the photo-radical polymerization initiator may be an activator that produces an active radical by any action with a photo-excited sensitizer.

The photo-radical polymerization initiator preferably contains at least one compound having a molar light absorption coefficient of at least about 50 within a range of about 300 to 800 nm (preferably 330 to 500 nm). The molar extinction coefficient of the compound can be measured using a known method. For example, it is preferable to perform the measurement at a concentration of 0.01 g/L using an ethyl acetate solvent with an ultraviolet-visible spectrophotometer (Cary-5 spectrophotometer manufactured by Varian Medical Systems, Inc.).

As the photo-radical polymerization initiator, a known compound can be optionally used. Examples thereof include a halogenated hydrocarbon derivative (for example, a compound having a triazine skeleton, a compound having an oxadiazole skeleton, a compound having a trihalomethyl group), an acylphosphine compound such as an acylphosphine oxide, hexaarylbiimidazole, an oxime compound such as an oxime derivative, an organic peroxide, a thio compound, a ketone compound, an aromatic onium salt, ketoxime ether, an aminoacetophenone compound, hydroxyacetophenone, an azo-based compound, an azide compound, a metallocene compound, an organic boron compound, and an iron arene complex. With regard to details thereof, reference can be made to the description of paragraphs 0165 to 0182 of JP2016-027357A and paragraphs 0138 to 0151 of WO2015/199219A.

As the ketone compound, for example, the compounds described in paragraph 0087 of JP2015-087611A are exemplified. For commercially available products, KAYACURE DETX (manufactured by Nippon Kayaku Co., Ltd.) is also suitably used.

As the photo-radical polymerization initiator, a hydroxyacetophenone compound, an aminoacetophenone compound, and an acylphosphine compound can also be suitably used. More specifically, for example, the aminoacetophenone-based initiators described in JP1998-291969A (JP-H10-291969A) and the acylphosphine oxide-based initiators described in JP4225898B can also be used.

As the hydroxyacetophenone-based initiator, IRGACURE 184 (IRGACURE is a registered trade mark), DAROCUR 1173, IRGACURE 500, IRGACURE-2959, and IRGACURE 127 (trade names, all manufactured by BASF SE) can be used.

As the aminoacetophenone-based initiator, IRGACURE 907, IRGACURE 369, and IRGACURE 379 (trade names, all manufactured by BASF SE) which are commercially available products can be used.

As the aminoacetophenone-based initiator, the compounds described in JP2009-191179A, an absorption maximum wavelength of which is matched to a light source having a wavelength such as 365 nm or 405 nm, can also be used.

As the acylphosphine-based initiator, 2,4,6-trimethylbenzoyl-diphenyl-phosphine oxide and the like are mentioned. In addition, IRGACURE-819 or IRGACURE-TPO (trade names, all manufactured by BASF SE) which are commercially available products can be used.

As the metallocene compound, IRGACURE-784 (manufactured by BASF SE) and the like are exemplified.

As the photo-radical polymerization initiator, an oxime compound is more preferably mentioned. By using the oxime compound, exposure latitude can be more effectively improved. The oxime compound is particularly preferable because the oxime compound has wide exposure latitude (exposure margin) and also works as a photocuring accelerator.

As specific examples of the oxime compound, the compounds described in JP2001-233842A, the compounds described in JP2000-080068A, and the compounds described in JP2006-342166A can be used.

Examples of preferred oxime compounds include compounds having the following structures, 3-benzooxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one. In the photosensitive resin composition according to the embodiment of the present invention, it is particularly preferable to use an oxime compound (an oxime-based photopolymerization initiator) as the photo-radical polymerization initiator. The oxime-based photopolymerization initiator has a >C=N-O-C(=O)- linking group in the molecule.

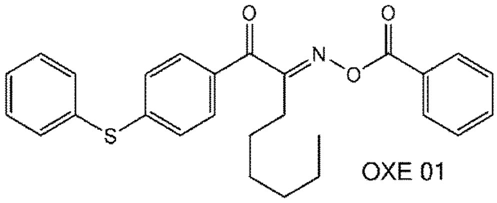
OXE 01

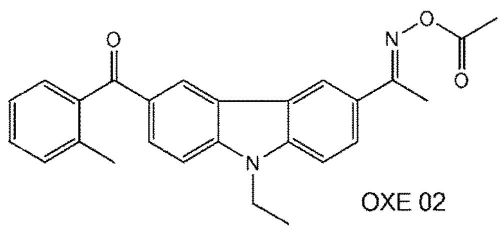
OXE 02

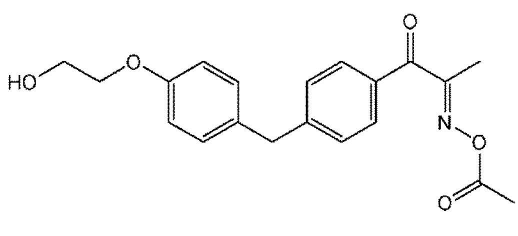

OXE 03

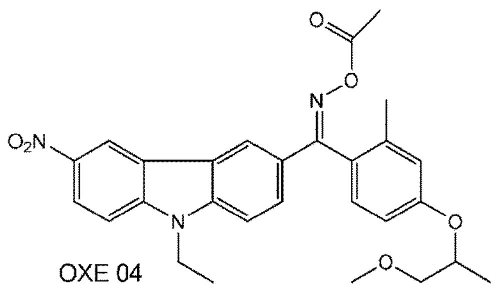

OXE 04

As commercially available products, IRGACURE OXE 01, IRGACURE OXE 02, IRGACURE OXE 03, IRGACURE OXE 04 (all manufactured by BASF SE), ADEKA OPTOMER N-1919 (manufactured by ADEKA Corporation, photo-radical polymerization initiator 2 described in JP2012-014052A) are also suitably used. In addition, TR-PBG-304 (manufactured by Changzhou Tronly New Electronic Materials Co., Ltd.), ADEKA ARKLS NCI-831, and ADEKA ARKLS NCI-930 (manufactured by ADEKA Corporation) can also be used. In addition, DFI-091 (manufactured by DAITO CHEMIX Co., Ltd.) can be used.

Furthermore, it is also possible to use an oxime compound having a fluorine atom. Specific examples of such oxime compounds include compounds described in JP2010-262028A, compounds 24, and 36 to 40 described in paragraph 0345 of JP2014-500852A, and a compound (C-3) described in paragraph 0101 of JP2013-164471A.

As the most preferable oxime compound, oxime compounds having a specific substituent described in JP2007-269779A or oxime compounds having a thioaryl group shown in JP2009-191061A, and the like are mentioned.

From the viewpoint of exposure sensitivity, the photo-radical polymerization initiator is preferably a compound selected from the group consisting of a trihalomethyltriazine compound, a benzyl dimethyl ketal compound, an $\alpha$ -hydroxy ketone compound, an $\alpha$ -aminoketone compound, an acylphosphine compound, a phosphine oxide compound, a metallocene compound, an oxime compound, a triaryl imidazole dimer, an onium salt compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.

The photo-radical polymerization initiator is more preferably a trihalomethyltriazine compound, an $\alpha$ -aminoketone compound, an acylphosphine compound, a phosphine oxide compound, a metallocene compound, an oxime compound, a triarylimidazole dimer, an onium salt compound, a benzophenone compound, or an acetophenone compound, still more preferably at least one compound selected from the group consisting of a trihalomethyltriazine compound, an $\alpha$ -aminoketone compound, an oxime compound, a triarylimidazole dimer, and a benzophenone compound, a metallocene compound or an oxime compound is even still more preferably used, and an oxime compound is even still further more preferable.

In addition, as the photo-radical polymerization initiator, it is possible to use benzophenone, N,N'-tetraalkyl-4,4'-diaminobenzophenone such as N,N'-tetramethyl-4,4'-diaminobenzophenone (Michler's ketone), an aromatic ketone such as 2-benzyl-2-dimethylamino-1-(4-morpholinophenyl)-butanone-1,2-methyl-1-[4-(methylthio)ph enyl]-2-morpholino-propanone-1, quinones fused with an aromatic ring such as alkylanthraquinone, a benzoin ether compound such as benzoin alkyl ether, a benzoin compound such as benzoin and alkylbenzoin, a benzyl derivative such as benzyl dimethyl ketal, and the like. In addition, a compound represented by Formula (I) may also be used.

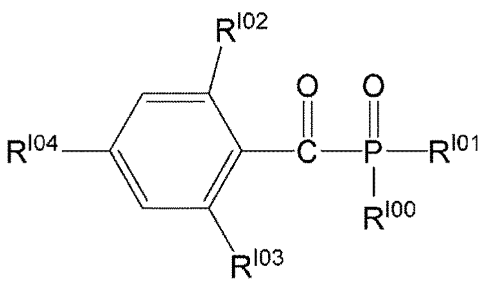

(I)

In Formula (I), $R^{I00}$ represents an alkyl group having 1 to 20 carbon atoms, an alkyl group having 2 to 20 carbon atoms which is interrupted by one or more oxygen atoms, an alkoxy group having 1 to 12 carbon atoms, a phenyl group, a phenyl group which is substituted with at least one of an alkyl group having 1 to 20 carbon atoms, an alkoxy group having 1 to 12 carbon atoms, a halogen atom, a cyclopentyl group, a cyclohexyl group, an alkenyl group having 2 to 12 carbon atoms, a phenyl group substituted with at least one of an alkyl group having 2 to 18 carbon atoms which is interrupted by one or more oxygen atoms or an alkyl group having 1 to 4 carbon atoms, or a biphenyl group, $R^{I01}$ is a group represented by

Formula (II) or a group identical to $R^{I00}$, and $R^{I02}$ to $R^{I04}$ each independently represent an alkyl group having 1 to 12 carbon atoms, an alkoxy group having 1 to 12 carbon atoms, or a halogen.

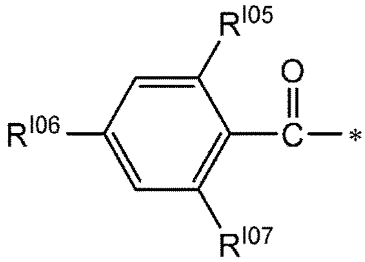

(II)

In the formula, $R^{I05}$ to $R^{I07}$ are respectively the same as $R^{I02}$ to $R^{I04}$ in Formula (I).

In addition, as the photo-radical polymerization initiator, the compounds described in paragraphs 0048 to 0055 of WO2015/125469A can also be used.

In a case where the photopolymerization initiator is contained, the content thereof is preferably 0.1% to 30% by mass, more preferably 0.1% to 20% by mass, still more preferably 0.5% to 15% by mass, and still more preferably 1.0% to 10% by mass, with respect to the total solid content of the photosensitive resin composition according to the embodiment of the present invention. Only one type of the photopolymerization initiator may be contained, or two or more types thereof may be contained. In a case where two or more types of photopolymerization initiators are contained, the total thereof is preferably within the above-described range.

<<Thermal polymerization initiator>>

The thermal polymerization initiator may be used as the photosensitizer, and in particular, a thermal radical polymerization initiator may be used. The thermal radical polymerization initiator is a compound that generates radicals by heat energy and initiates or promotes a polymerization reaction of a compound having polymerization properties. By adding the thermal radical polymerization initiator, a polymerization reaction of the polymer precursor can be advanced together with cyclization of the polymer precursor, whereby a higher degree of heat resistance can be achieved.

Specifically, as the thermal radical polymerization initiator, compounds described in paragraphs 0074 to 0118 of JP2008-063554A are mentioned.

In a case where the thermal radical polymerization initiator is contained, the content thereof is preferably 0.1% to 30% by mass, with respect to the total solid content of the photosensitive resin composition according to the embodiment of the present invention, more preferably 0.1% to 20% by mass, and still more preferably 5% to 15% by mass. Only one type of the thermal radical polymerization initiator may be contained, or two or more types thereof may be contained. In a case where two or more types of the thermal radical polymerization initiators are contained, the total thereof is preferably within the above-described range.

<Polymerizable compound>

<<Radically polymerizable compound>>

The photosensitive resin composition according to the embodiment of the present invention preferably contains a polymerizable compound. As the polymerizable compound, a radically polymerizable compound can be used. The radically polymerizable compound is a compound having a radically polymerizable group. Examples of the radically polymerizable group include groups having an ethylenic unsaturated bond such as a vinyl group, an allyl group, a vinylphenyl group, or a (meth)acryloyl group, and an allyl group. The radically polymerizable group is preferably a (meth) acryloyl group.

The number of radically polymerizable groups contained in the radically polymerizable compound may be one or two or more, but the radically polymerizable compound preferably has two or more radically polymerizable groups and more preferably has three or more radically polymerizable groups. The upper limit thereof is preferably 15 or lower, more preferably 10 or lower, and still more preferably 8 or lower.

The molecular weight of the radically polymerizable compound is preferably 2,000 or lower, more preferably 1,500 or lower, and still more preferably 900 or lower. The lower limit of the molecular weight of the radically polymerizable compound is preferably 100 or more.

From the viewpoint of developability, the photosensitive resin composition according to the embodiment of the present invention preferably contains at least one di- or higher-functional radically polymerizable compound containing

two or more polymerizable groups and more preferably contains at least one tri- or higher-functional radically polymerizable compound. In addition, the photosensitive resin composition may contain a mixture of a difunctional radically polymerizable compound and a trifunctional or higher functional radically polymerizable compound. The number of functional groups in the radically polymerizable compound means the number of radically polymerizable groups in one molecule.

Specific examples of the radically polymerizable compound include unsaturated carboxylic acids (for example, acrylic acid, methacrylic acid, itaconic acid, crotonic acid, isocrotonic acid, maleic acid), and esters and amides thereof, and are preferably esters of unsaturated carboxylic acids with polyhydric alcohol compounds, and amides of unsaturated carboxylic acids with polyvalent amine compounds. In addition, addition reaction products of unsaturated carboxylic acid esters or amides having a nucleophilic substituent such as a hydroxyl group, an amino group, and a sulfanyl group, with monofunctional or polyfunctional isocyanates or epoxies, dehydration condensation reaction products thereof with monofunctional or polyfunctional carboxylic acids, and the like are also suitably used. In addition, addition reaction products of unsaturated carboxylic acid esters or amides having an electrophilic substituent such as an isocyanate group and an epoxy group, with monofunctional or polyfunctional alcohols, amines, or thiols, and substitution reaction products of unsaturated carboxylic acid esters or amides having a leaving substituent such as a halogen group and a tosyloxy group with monofunctional or polyfunctional alcohols, amines, or thiols are also suitable. In addition, as other examples, it is also possible to use a group of compounds that are substituted with an unsaturated phosphonic acid, a vinylbenzene derivative such as styrene, a vinyl ether, an allyl ether, or the like, instead of the unsaturated carboxylic acid described above. As the specific examples, reference can be made to the description of paragraphs 0113 to 0122 of JP2016-027357A.

In addition, the radically polymerizable compound is also preferably a compound having a boiling point of 100°C or higher under atmospheric pressure. Examples thereof include a compound obtained by adding ethylene oxide or propylene oxide to a polyfunctional alcohol such as polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylolpropane tri(acryloyloxypropyl)ether, tri(acryloyloxyethyl)isocyanurate, glycerin, and trimethylolethane, and then being subjected to (meth)acrylation, urethane (meth)acrylates respectively described in JP1973-041708B (JP-S48-041708B), JP1975-006034B (JP-S50-006034B), and JP1976-037193A (JP-S51-037193A), polyester acrylates respectively described in JP1973-064183A (JP-S48-064183A), JP1974-043191B (JP-S49-043191B), and JP1977-030490B (JP-S52-030490B), polyfunctional acrylates or methacrylates such as epoxy acrylates which are reaction products of epoxy resins and (meth)acrylic acid, and mixtures thereof. In addition, the compounds described in paragraphs 0254 to 0257 of JP2008-292970A are also suitable. Moreover, the polyfunctional (meth)acrylate or the like obtained by reacting a compound having a cyclic ether group with an ethylenic unsaturated bond, such as glycidyl (meth)acrylate, with polyfunctional carboxylic acid can also be mentioned.

In addition, as a preferred radically polymerizable compound other than those described above, a compound having two or more groups containing a fluorene ring and an ethylenic unsaturated bond and a cardo resin, which are described in JP2010-160418A, JP2010-129825A, and JP4364216B, can also be used.

Further, as other examples, the specific unsaturated compounds described in JP1971-043946B (JP-S46-043946B), JP1989-040337B (JP-H1-040337B), and JP1989-040336B (JP-H1-040336B), the vinylphosphonic acid-based compounds described in JP1990-025493A (JP-H2-025493A), and the like can also be mentioned. In addition, the compounds containing a perfluoroalkyl group described in JP1986-022048A (JP-S61-022048A) can also be used. Furthermore, photopolymerizable monomers and oligomers which are described in Journal of Japan Adhesive Association Vol. 20, No. 7, pages 300 to 308 (1984) can also be used.

In addition to the above, the compounds described in paragraphs 0048 to 0051 of JP2015-034964A and the compounds described in paragraphs 0087 to 0131 of WO2015/199219A can also be preferably used.

In addition, the compounds which are described in JP1998-062986A (JP-H10-062986A) as Formulae (1) and (2) together with the specific examples thereof and which are obtained by adding ethylene oxide or propylene oxide to a polyfunctional alcohol and then being subjected to (meth)acrylation can be used as the radically polymerizable compound.

Further, the compounds described in paragraphs 0104 to 0131 of JP2015-187211A can also be used as the other radically polymerizable compounds.

As the radically polymerizable compound, dipentaerythritol triacrylate (as a commercially available product, KAYARAD D-330; manufactured by Nippon Kayaku Co., Ltd.), dipentaerythritol tetraacrylate (as a commercially available product, KAYARAD D-320; Nippon Kayaku Co., Ltd., A-TMMT: manufactured by Shin-Nakamura Chemical Co., Ltd.), dipentaerythritol penta(meth)acrylate (as a commercially available product, KAYARAD D-310; manufactured by Nippon Kayaku Co., Ltd.), dipentaerythritol hexa(meth)acrylate (as commercially available product, KAYARAD DPHA; by Nippon Kayaku Co., Ltd., A-DPH; manufactured by Shin-Nakamura Chemical Co., Ltd.), or a structure in which a (meth)acryloyl group thereof is bonded through an ethylene glycol residue or a propylene glycol residue is preferable. Oligomer types thereof can also be used.

Examples of the commercially available product of the radically polymerizable compound include SR-494 which

is a tetrafunctional acrylate having four ethyleneoxy chains, manufactured by Sartomer Co., Ltd., SR-209, 231, and 239 which are a difunctional methacrylate having four ethyleneoxy chains, manufactured by Sartomer Co., Ltd., DPCA-60 which is a hexafunctional acrylate having six pentyleneoxy chains, manufactured by Nippon Kayaku Co., Ltd., TPA-330 which is a trifunctional acrylate having three isobutylene oxy chains, a urethane oligomer UAS-10, UAB-140 (manufactured by Nippon Paper Industries Co., Ltd.), NK Ester M-40G, NK Ester 4G, NK Ester M-9300, NK Ester A-9300, UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, AI-600 (manufactured by Kyoeisha Chemical Co., Ltd.), and Brenmer PME400 (manufactured by NOF Corporation).

As the radically polymerizable compound, the urethane acrylates as described in JP1973-041708B (JP-S48-041708B), JP1976-037193A (JP-S51-037193A), JP1990-032293B (JP-H2-032293B), and JP1990-016765B (JP-H2-016765B), and the urethane compounds having an ethylene oxide-based skeleton described in JP1983-049860B (JP-S58-049860B), JP1981-017654B (JP-S56-017654B), JP1987-039417B (JP-S62-039417B), and JP1987-039418B (JP-S62-039418B) are also suitable. Further, as the radically polymerizable compound, the compounds having an amino structure or a sulfide structure in a molecule as described in JP1988-277653A (JP-S63-277653A), JP1988-260909A (JP-S63-260909A), and JP1989-105238A (JP-H1-105238A) can also be used.

The radically polymerizable compound may be a radically polymerizable compound having an acid group such as a carboxyl group or a phosphoric acid group. The radically polymerizable compound having an acid group is preferably an ester of an aliphatic polyhydroxy compound and an unsaturated carboxylic acid and more preferably a radically polymerizable compound obtained by reacting an unreacted hydroxyl group of an aliphatic polyhydroxy compound with a non-aromatic carboxylic acid anhydride to have an acid group. The radically polymerizable compound is particularly preferably a compound in which an aliphatic polyhydroxy compound is pentaerythritol or dipentaerythritol in a radically polymerizable compound having an acid group obtained by reacting an unreacted hydroxyl group of the aliphatic polyhydroxy compound with a non-aromatic carboxylic acid anhydride. As commercially available products thereof, for example, M-510 and M-520 as polybasic acid-modified acrylic oligomers which are manufactured by Toagosei Co., Ltd., are mentioned.

The acid value of the radically polymerizable compound having an acid group is preferably 0.1 to 40 mg KOH/g, and particularly preferably 5 to 30 mg KOH/g. In a case where the acid value of the radically polymerizable compound is within the above-described range, excellent production handling properties are exhibited, and furthermore, excellent developability is exhibited. In addition, good polymerization properties are exhibited.

In the photosensitive resin composition according to the embodiment of the present invention, a monofunctional radically polymerizable compound can be preferably used as the radically polymerizable compound from the viewpoint of suppressing warping associated with controlling the elastic modulus of the cured film. As the monofunctional radically polymerizable compound, (meth)acrylic acid derivatives such as n-butyl (meth)acrylate, 2-ethylhexyl (meth)acrylate, 2-hydroxyethyl (meth)acrylate, butoxyethyl (meth)acrylate, carbitol (meth)acrylate, cyclohexyl (meth)acrylate, benzyl (meth)acrylate, phenoxyethyl (meth)acrylate, N-methylol (meth)acrylamide, glycidyl (meth)acrylate, polyethylene glycol mono(meth)acrylate, and polypropylene glycol mono(meth)acrylate, N-vinyl compounds such as N-vinylpyrrolidone and N-vinylcaprolactam, allyl compounds such as allyl glycidyl ether, diallyl phthalate, and triallyl trimellitate, and the like are preferably used. As the monofunctional radically polymerizable compound, a compound having a boiling point of 100°C or higher under atmospheric pressure is also preferable in order to suppress volatilization before exposure.

<<Polymerizable compound other than the radically polymerizable compound described above>>

The photosensitive resin composition according to the embodiment of the present invention may further contain other polymerizable compounds, in addition to the radically polymerizable compound described above. Examples of the radically polymerizable compound other than the polymerizable compound described above include a compound having a hydroxymethyl group, an alkoxymethyl group, or an acyloxymethyl group; an epoxy compound; an oxetane compound; and a benzoxazine compound.

<<<Compound having hydroxymethyl group, alkoxymethyl group, or acyloxymethyl group>>>

The compound having a hydroxymethyl group, an alkoxymethyl group, or an acyloxymethyl group is preferably a compound represented by Formula (AM1), (AM4), or (AM5).

$$R^{104}\left(CH_2-R^{105}\right)_t \qquad (AM1)$$

(In the formula, t represents an integer of 1 to 20, $R^{104}$ represents a t-valent organic group having 1 to 200 carbon atoms, $R^{105}$ represents a group represented by $-OR^{106}$ or $-OCO-R^{107}$, $R^{106}$ represents a hydrogen atom or an organic group having 1 to 10 carbon atoms, and $R^{107}$ represents an organic group having 1 to 10 carbon atoms.)

$$R^{404}\left(CH_2-R^{405}\right)_2 \qquad (AM4)$$

(In the formula, $R^{404}$ represents a divalent organic group having 1 to 200 carbon atoms, $R^{405}$ represents a group represented by $-OR^{406}$ or $-OCO-R^{407}$, $R^{406}$ represents a hydrogen atom or an organic group having 1 to 10 carbon atoms, and $R^{407}$ represents an organic group having 1 to 10 carbon atoms.)

$$R^{504}\left(CH_2-R^{505}\right)_u \qquad (AM5)$$

(In the formula, u represents an integer of 3 to 8, $R^{504}$ represents a u-valent organic group having 1 to 200 carbon atoms, $R^{505}$ represents a group represented by $-OR^{506}$ or $-OCO-R^{507}$, $R^{506}$ represents a hydrogen atom or an organic group having 1 to 10 carbon atoms, and $R^{507}$ represents an organic group having 1 to 10 carbon atoms.).

Specific examples of the compound represented by Formula (AM4) include 46DMOC, 46DMOEP (all trade names, manufactured by Asahi Organic Chemicals Industry Co., Ltd.), DML-MBPC, DML-MBOC, DML-OCHP, DML-PCHP, DML-PC, DML-PTBP, DML-34X, DML-EP, DML-POP, dimethylol BisOC-P, DML-PFP, DML-PSBP, DML-MTris PC (all trade names, manufactured by Honshu Chemical Industry Co., Ltd.), NIKALAC MX-290 (trade name, manufactured by Sanwa Chemical Co., Ltd.), 2,6-dimethoxymethyl-4-t-buthylphenol, 2,6-dimethoxymethyl-p-cresol, and 2,6-diacethoxymethyl-p-cresol.

In addition, specific examples of the compound represented by Formula (AM5) include TriML-P, TriML-35XL, TML-HQ, TML-BP, TML-pp-BPF, TML-BPA, TMOM-BP, HML-TPPHBA, HML-TPHAP, HMOM-TPPHBA, HMOM-TPHAP (all trade name, manufactured by Honshu Chemical Industry Co., Ltd.), TM-BIP-A (trade name, manufactured by Asahi Organic Materials Industry Co., Ltd.), NIKALAC MX-280, NIKALAC MX-270, and NIKALAC MW-100LM (all trade names, manufactured by Sanwa Chemical Co., Ltd.).

<<<Epoxy compound (compound having epoxy group)>>>

The epoxy compound is preferably a compound having two or more epoxy groups in one molecule. Since the epoxy group undergoes a crosslinking reaction at 200°C or lower and a dehydration reaction derived from crosslinking does not occur, film shrinkage hardly occurs. Therefore, containing an epoxy compound is effective for low-temperature curing of the composition and suppression of warping thereof.

The epoxy compound preferably contains a polyethylene oxide group. As a result, it is possible to further decrease a modulus of elasticity and to suppress warping. The polyethylene oxide group means a group in which the number of constitutional units of ethylene oxide is 2 or higher, and the number of constitutional units is preferably 2 to 15.

Examples of the epoxy compound include a bisphenol A type epoxy resin; a bisphenol F type epoxy resin; an alkylene glycol type epoxy resin such as propylene glycol diglycidyl ether; a polyalkylene glycol type epoxy resin such as polypropylene glycol diglycidyl ether; and an epoxy group-containing silicone such as polymethyl(glycidyloxypropyl) siloxane, but the examples thereof are not limited thereto. Specifically, EPICLON (registered trade mark) 850-S, EPICLON (registered trade mark) HP-4032, EPICLON (registered trade mark) HP-7200, EPICLON (registered trade mark) HP-820, EPICLON (registered trade mark) HP-4700, EPICLON (registered trade mark) EXA-4710, EPICLON (registered trade mark) HP-4770, EPICLON (registered trade mark) EXA-859CRP, EPICLON (registered trade mark) EXA-1514, EPICLON (registered trade mark) EXA-4880, EPICLON (registered trade mark) EXA-4850-150, EPICLON EXA-4850-1000, EPICLON (registered trade mark) EXA-4816, EPICLON (registered trade mark) EXA-4822 (all trade names, manufactured by Dainippon Ink and Chemicals, Inc.), RIKARESIN (registered trade mark) BEO-60E (trade name, manufactured by New Japan Chemical Co., Ltd.), EP-4003S, EP-4000S (all trade names, manufactured by ADEKA Corporation), and the like are mentioned. Among these, an epoxy resin containing a polyethylene oxide group is preferable from the viewpoint of suppression of warping and excellent heat resistance. For example, EPICLON (registered trade mark) EXA-4880, EPICLON (registered trade mark) EXA-4822, and RIKARESIN (registered trade mark) BEO-60E are preferable due to containing a polyethylene oxide group.

<<<Oxetane compound (compound having oxetanyl group)>>>

As the oxetane compound, a compound having two or more oxetane rings in one molecule, 3-ethyl-3-hydroxymethyloxetane, 1,4-bis{[(3-ethyl-3-oxetanyl)methoxy]methyl}benzene, 3-ethyl-3-(2-ethylhexylmethyl)oxetane, 1,4-benzenedicarboxylic acid-bis[(3-ethyl-3-oxetanyl)methyl] ester, and the like can be mentioned. As specific examples thereof, ARON OXETANE series (for example, OXT-121, OXT-221, OXT-191, OXT-223) manufactured by Toagosei Co., Ltd., can be suitably used, and these can be used alone or two or more thereof may be mixed and used.

<<<Benzoxazine compound (compound having benzoxazolyl group)>>>

Due to a crosslinking reaction derived from a ring-opening addition reaction, the benzoxazine compound does not result in degassing during curing and results in decreased thermal contraction, and thus the occurrence of warping is suppressed, which is preferable.

Preferred examples of the benzoxazine compound include B-a type benzoxazine, B-m type benzoxazine (all trade names, manufactured by Shikoku Chemicals Corporation), a benzoxazine adduct of polyhydroxystyrene resin, and a phenol novolak type dihydrobenzo oxazine compound. These may be used alone, or two or more types thereof may be mixed and used.

In a case where the polymerizable compound is contained, the content thereof is preferably more than 0% by mass and 60% by mass or less with respect to the total solid content of the photosensitive resin composition according to the embodiment of the present invention. The lower limit thereof is more preferably 5% by mass or higher. An upper limit is more preferably 50% by mass or less and still more preferably 30% by mass or less.

One type of the polymerizable compound may be used alone, or two or more types thereof may be mixed and used. In a case where two or more types thereof are used in combination, the total amount thereof is preferably in the above range.

<Solvent>

The photosensitive resin composition according to the embodiment of the present invention preferably contains a solvent. As the solvent, a known solvent can be optionally used. The solvent is preferably an organic solvent. As the organic solvent, compounds such as esters, ethers, ketones, aromatic hydrocarbons, sulfoxides, and amides are mentioned.

Examples of the suitable esters include ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate.

Suitable examples of the ethers include diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, and propylene glycol monopropyl ether acetate.

Examples of the suitable ketones include methyl ethyl ketone, cyclohexanone, cyclopentanone, 2-heptanone, and 3-heptanone.

Examples of the suitable aromatic hydrocarbons include toluene, xylene, anisole, and limonene.

Examples of the suitable sulfoxides include dimethyl sulfoxide.

Examples of the suitable amides include N-methyl-2-pyrrolidone, N-ethyl-2-pyrrolidone, N,N-dimethylacetamide, and N,N-dimethylformamide.

From the viewpoint of improving the properties of a coated surface or the like, it is also preferable to mix two or more types of solvents.

In the present invention, the preferred solvents are one type of solvent selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ -butyrolactone, dimethyl sulfoxide, ethyl carbitol acetate, butyl carbitol acetate, N-methyl-2-pyrrolidone, propylene glycol methyl ether, propylene glycol methyl ether acetate, or a mixed solvent composed of two or more types of the solvents. A combination of dimethyl sulfoxide and γ-butyrolactone is particularly preferable.

From the viewpoint of coating property, the content of the solvent is such that the total solid content concentration of the photosensitive resin composition according to the embodiment of the present invention is preferably 5% to 80% by mass, more preferably 5% to 75% by mass, still more preferably 10% to 70% by mass, and even still more preferably 40% to 70% by mass. The content of the solvent may be adjusted depending on the desired thickness and a coating method.

One type of the solvent may be contained, or two or more types thereof may be contained. In a case where two or more types of the solvents are contained, a total thereof is preferably within the above-described range.

<Migration suppressing agent>

The photosensitive resin composition according to the embodiment of the present invention preferably further contains a migration suppressing agent. By containing the migration suppressing agent, it is possible to effectively prevent metal ions derived from a metal layer (metal wiring) from being migrated into a photosensitive resin composition layer.

The migration suppressing agent is no particularly limited, but a compound having a heterocyclic ring (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, or a triazine ring), a compound having thioureas and a sulfanyl group, a hindered phenol-based compound, a salicylic acid derivative-based compound, and a hydrazide derivative-based compound are mentioned. In particular, triazole-based compounds such as 1,2,4-triazole and benzotriazole, and tetrazole-based compounds such as 1H-tetrazole and 5-phenyltetrazole can be preferably used.

In addition, an ion trapping agent that captures an anion such as a halogen ion can also be used.

As other migration suppressing agents, the rust inhibitors described in paragraph 0094 of JP2013-015701A, the compounds described in paragraphs 0073 to 0076 of JP2009-283711A, the compounds described in paragraph 0052 of JP2011-059656A, the compounds described in paragraphs 0114, 0116, and 0118 of JP2012-194520A, and the compounds described in paragraph 0166 of WO2015/199219A and the like can be used.

The following compounds can be mentioned as specific examples of the migration suppressing agent.

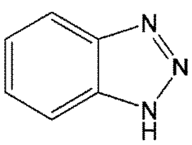

M-1

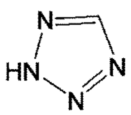

M-2

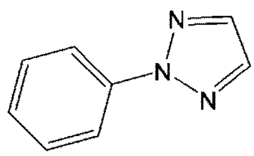

M-3

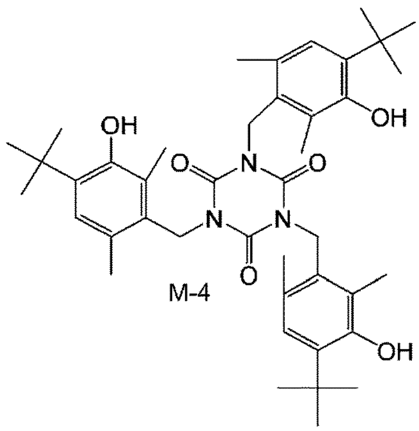

M-4

In a case where the photosensitive resin composition contains the migration suppressing agent, the content of the migration suppressing agent is preferably 0.01% to 5.0% by mass, more preferably 0.05% to 2.0% by mass, and still more preferably 0.1% to 1.0% by mass, with respect to the total solid content of the photosensitive resin composition.

Only one type of the migration suppressing agent may be used, or two or more types thereof may be used. In a case where two or more types of the migration suppressing agents are used, the total thereof is preferably within the above-described range.

<Polymerization inhibitor>

The photosensitive resin composition according to the embodiment of the present invention preferably contains a polymerization inhibitor.

As the polymerization inhibitor, for example, hydroquinone, p-methoxyphenol, di-tert-butyl-p-cresol, pyrogallol, p-tert-butylcatechol, 1,4-benzoquinone, diphenyl-p-benzoquinone, 4,4'-thiobis(3-methyl-6-tert-butylphenol), 2,2'-methylenebis(4-methyl-6-tert-butylphenol), N-nitroso-N-phenylhydroxyamine aluminum salt, phenothiazine, N-nitrosodiphenylamine, N-phenyl naphthylamine, ethylenediamine tetraacetic acid, 1,2-cyclohexanediamine tetraacetic acid, glycol ether diamine tetraacetic acid, 2,6-di-tert-butyl-4-methyl phenol, 5-nitroso-8-hydroxyquinoline, 1-nitroso-2-naphtoyl, 2-nitroso-1-naphtoyl, 2-nitroso-5-(N-ethyl-N-sulfopropylamino)phenol, N-nitroso-N-(1-naphthyl)hydroxyamine ammonium salt, bis(4-hydroxy-3,5-tert-butyl)phenylmethane, and the like are suitably used. In addition, the polymerization inhibitors described in paragraph 0060 of JP2015-127817A and the compounds described in paragraphs 0031 to 0046 of WO2015/125469A can also be used.

In addition, the following compounds can be used (Me is a methyl group).

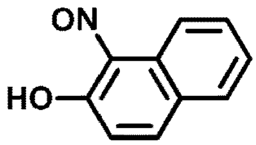
F-1

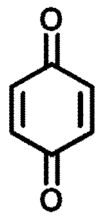
F-2

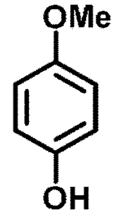
F-3

In a case where the photosensitive resin composition according to the embodiment of the present invention has a polymerization inhibitor, the content of the polymerization inhibitor is preferably 0.01% to 5% by mass, more preferably 0.02% to 3% by mass, and still more preferably 0.05% to 2.5% by mass, with respect to the total solid content of the photosensitive resin composition according to the embodiment of the present invention.

Only one type of the polymerization inhibitor may be used, or two or more types thereof may be used. In a case where two or more types of the polymerization inhibitors are used, the total thereof is preferably within the above-described range.

<Metal adhesiveness improving agent>

The photosensitive resin composition according to the embodiment of the present invention preferably contains a metal adhesiveness improving agent for improving adhesiveness to a metal material used for electrodes, wirings, and the like. As the metal adhesiveness improving agent, a silane coupling agent, and the like are mentioned.

Examples of the silane coupling agent include the compounds described in paragraph 0167 of WO2015/199219A, the compounds described in paragraphs 0062 to 0073 of JP2014-191002A, the compounds described in paragraphs 0063 to 0071 of WO2011/080992A1, the compounds described in paragraphs 0060 and 0061 of JP2014-191252A, the compounds described in paragraphs 0045 to 0052 of JP2014-041264A, and the compounds described in paragraph 0055 of WO2014/097594A. In addition, it is also preferable to use two or more types of the different silane coupling agents as described in paragraphs 0050 to 0058 of JP2011-128358A. In addition, as the silane coupling agent, the following compounds are also preferably used. In the following formulae, Et represents an ethyl group.

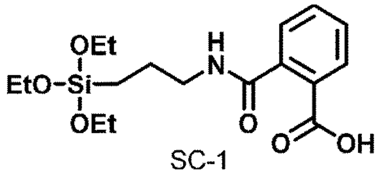
SC-1

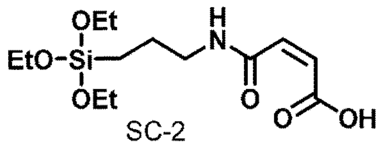
SC-2

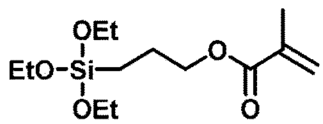
SC-3

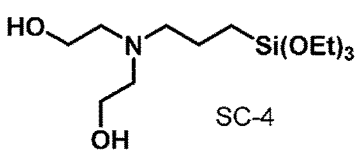
SC-4

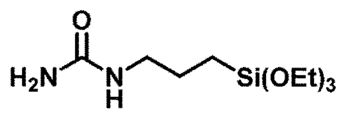
SC-5

In addition, as the metal adhesiveness improving agent, the compounds described in paragraphs 0046 to 0049 of JP2014-186186A, and the sulfide-based compounds described in paragraphs 0032 to 0043 of JP2013-072935A can also be used.

The content of the metal adhesiveness improving agent is preferably 0.1 to 30 parts by mass, more preferably in a range of 0.5 to 15 parts by mass, and still more preferably in a range of 0.5 to 5 parts by mass, with respect to 100 parts by

mass of the polymer precursor. In a case where the content is set to be equal to or higher than the above lower limit value, good adhesiveness between a cured film and a metal layer after a curing step is exhibited, and in a case where the content is set to be equal to or lower than the above upper limit value, heat resistance of the cured film after the curing step and mechanical properties are exhibited. Only one type of the metal adhesiveness improving agent may be used, or two or more types thereof may be used. In a case where two or more types thereof are used, the total thereof is preferably within the above-described range.

<<Other additives>>

Various additives, for example, a thermal acid generator, a sensitizing dye, a chain transfer agent, a surfactant, a higher fatty acid derivative, an inorganic particle, a curing agent, a curing catalyst, a filler, an antioxidant, an ultraviolet absorbent, and an aggregation inhibitor can be blended, as necessary, with the photosensitive resin composition according to the embodiment of the present invention to the extent that an effect of the present invention is not impaired. In a case where these additives are blended, the total blending amount thereof is preferably 3% by mass or lower of the solid content of the composition.

<<Sensitizing dye>>

The photosensitive resin composition according to the embodiment of the present invention may contain a sensitizing dye. The sensitizing dye absorbs specific actinic radiation and becomes an electronically excited state. The sensitizing dye in the electronically excited state is brought into contact with a thermal curing accelerator, a thermal radical polymerization initiator, a photo-radical polymerization initiator, or the like, to cause actions such as electron transfer, energy transfer, and heat generation. As a result, the thermal curing accelerator, the thermal radical polymerization initiator, or the photo-radical polymerization initiator undergoes a chemical change and decomposes, so that radicals, acids, or bases are generated. For details of the sensitizing dye, reference can be made to the description in paragraphs 0161 to 0163 of JP2016-027357A.

In a case where the photosensitive resin composition according to the embodiment of the present invention contains a sensitizing dye, the content of the sensitizing dye is preferably 0.01% to 20% by mass, more preferably 0.1% to 15% by mass, and still more preferably 0.5% to 10% by mass, with respect to the total solid content of the photosensitive resin composition according to the embodiment of the present invention. One type of the sensitizing dye may be used alone, or two or more types thereof may be used in combination.

<<<Chain transfer agent>>>

The photosensitive resin composition according to the embodiment of the present invention may contain a chain transfer agent. The chain transfer agent is defined, for example, in Polymer Dictionary, 3rd Edition, pp. 683 to 684 (edited by The Society of Polymer Science, 2005). As the chain transfer agent, for example, a group of compounds having SH, PH, SiH, or GeH in the molecule is used. These can donate hydrogen to a low active radical to generate a radical, or can be oxidized and then deprotonated to generate a radical. In particular, a thiol compound can be preferably used.

In addition, as the chain transfer agent, the compounds described in paragraphs 0152 and 0153 of WO2015/199219A can also be used.

In a case where the photosensitive resin composition according to the embodiment of the present invention has the chain transfer agent, the content of the chain transfer agent is preferably 0.01 to 20 parts by mass, more preferably 1 to 10 parts by mass, and still more preferably 1 to 5 parts by mass, with respect to 100 parts by mass of the total solid content of the photosensitive resin composition according to the embodiment of the present invention. Only one type of the chain transfer agent may be used, or two or more types thereof may be used. In a case where two or more types of the chain transfer agents are used, the total thereof is preferably within the above-described range.

<<Surfactant>>

From the viewpoint of further improving the coating property, each kind of surfactant may be added to the photosensitive resin composition according to the embodiment of the present invention. As the surfactant, each kind of the surfactant such as a fluorine-based surfactant, a nonionic surfactant, a cationic surfactant, an anionic surfactant, or a silicone-based surfactant can be used. In addition, the following surfactants are preferably used.

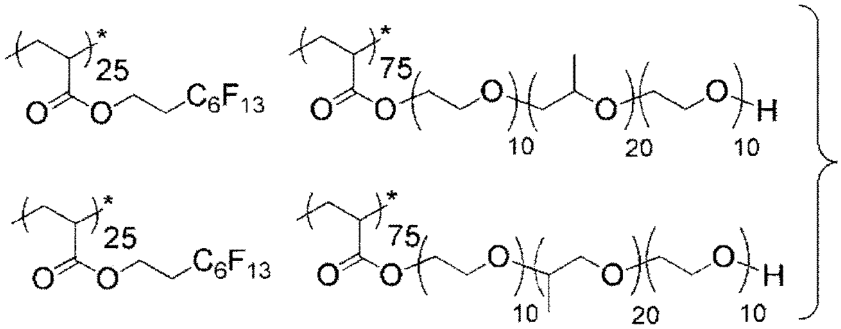

Mixture

In addition, as the surfactant, the compounds described in paragraphs 0159 to 0165 of WO2015/199219A can also be used.

In a case where the photosensitive resin composition according to the embodiment of the present invention has a surfactant, the content of the surfactant is preferably 0.001% to 2.0% by mass, with respect to the total solid content of the photosensitive resin composition according to the embodiment of the present invention, and more preferably 0.005% to 1.0% by mass. Only one type of the surfactant may be used, or two or more types thereof may be used. In a case where two or more types of the surfactants are used, the total thereof is preferably within the above-described range.

<<Higher fatty acid derivative>>

In the photosensitive resin composition according to the embodiment of the present invention, in order to prevent polymerization inhibition due to oxygen, a higher fatty acid derivative such as behenic acid or behenic acid amide may be added and be caused to be localized on a surface of the composition in the course of drying after coating.

In addition, as the higher fatty acid derivative, the compounds described in paragraph 0155 of WO2015/199219A can also be used.

In a case where the photosensitive resin composition according to the embodiment of the present invention has a higher fatty acid derivative, the content of the higher fatty acid derivative is preferably 0.1% to 10% by mass with respect to the total solid content of the photosensitive resin composition according to the embodiment of the present invention. Only one type of the higher fatty acid derivative may be used, or two or more types thereof may be used. In a case where two or more higher fatty acid derivatives are used, the total thereof is preferably within the above-described range.

<Restriction on other substances to be contained>

The water content of the photosensitive resin composition according to the embodiment of the present invention is preferably less than 5% by mass, more preferably less than 1% by mass, and still more preferably less than 0.6% by mass, from the viewpoint of properties of a coated surface.

From the viewpoint of insulating properties, the metal content of the photosensitive resin composition according to the embodiment of the present invention is preferably less than 5 parts per million (ppm) by mass, more preferably less than 1 ppm by mass, and still more preferably less than 0.5 ppm by mass. As the metal, sodium, potassium, magnesium, calcium, iron, chromium, nickel, and the like are mentioned. In a case where a plurality of metals are contained, the total of these metals is preferably within the above-described range.

In addition, as a method of reducing metal impurities which are unintentionally contained in the photosensitive resin composition according to the embodiment of the present invention, a method of selecting a raw material which contains a low metal content as the raw material constituting the photosensitive resin composition according to the embodiment of the present invention, a method of filtering the raw material constituting the photosensitive resin composition according to the embodiment of the present invention, a method of distilling under the condition in which the inside of the device is lined with polytetrafluoroethylene or the like to suppress the contamination as little as possible, and the like can be mentioned.

In the photosensitive resin composition according to the embodiment of the present invention, considering the use as a semiconductor material, the content of halogen atoms is preferably less than 500 ppm by mass, more preferably less than 300 ppm by mass, and still more preferably less than 200 ppm by mass, from the viewpoint of wiring corrosiveness. Among these, in a case of being present in a halogen ion state, the content is preferably less than 5 ppm by mass, more preferably less than 1 ppm by mass, and still more preferably less than 0.5 ppm by mass. As the halogen atom, a chlorine atom and a bromine atom are mentioned. It is preferable that each of the chlorine atom and the bromine atom, or a total of the chlorine ion and the bromine ion is within the above-described range.

As a storage container of the photosensitive resin composition according to the embodiment of the present

invention, a conventionally known storage container can be used. In addition, as the storage container, for the purpose of suppressing incorporation of impurities into raw materials and the composition, a multilayer bottle in which an inner wall of a container is composed of six types of six layers of resin, and a bottle with six types of resin being made as a seven-layer structure are preferably used. Examples of such a container include the container described in JP2015-123351A.

<Preparation of composition>

The photosensitive resin composition according to the embodiment of the present invention can be prepared by mixing the above-described components. The mixing method is not particularly limited, and mixing can be carried out by methods known in the related art.

In addition, for the purpose of removing foreign substances such as dust and fine particles in the composition, it is preferable to carry out filtration using a filter. A filter pore size is preferably 1 μm or lower, more preferably 0.5 μm or lower, and still more preferably 0.1 μm or lower. A material of the filter is preferably polytetrafluoroethylene, polyethylene, or nylon. As the filter, a filter which has been previously washed with an organic solvent may be used. In the filtration step using the filter, a plurality of types of filters may be linked in series or in parallel and used. In a case where a plurality of types of filters are used, filters having different pore sizes or different materials may be used in combination. In addition, various materials may be filtered a plurality of times. In a case of being filtered a plurality of times, circulation filtration may be used. In addition, filtration may be carried out under pressure. In a case where filtration is carried out under pressure, the pressure is preferably 0.05 MPa to 0.3 MPa.

In addition to filtration using a filter, impurity removal treatment using an adsorbing material may be carried out. The filtration using a filter and the impurity removal treatment using an adsorbing material may be combined. As the adsorbing material, a known adsorbing material can be used. For example, an inorganic adsorbing material such as silica gel and zeolite, and an organic adsorbing material such as activated carbon are mentioned.

<Cured film, laminate, semiconductor device, and manufacturing method therefor>

Next, a cured film, a laminate, a semiconductor device, and a manufacturing method therefor are described.

The cured film according to the embodiment of the present invention is formed by curing the photosensitive resin composition according to the embodiment of the present invention. A film thickness of the cured film according to the embodiment of the present invention can be, for example, 0.5 μm or higher, and 1 μm or higher. In addition, the upper limit value can be set to 100 μm or lower or can be set to 30 μm or lower.

Two or more layers, further 3 to 7 layers of the cured film according to the embodiment of the present invention may be laminated to form a laminate. A laminate having two or more layers of the cured film according to the embodiment of the present invention preferably has an aspect in which a metal layer is provided between any cured films. Such a metal layer is preferably used as a metal wiring such as a rewiring layer.

As a field to which the cured film according to the embodiment of the present invention can be applied, an insulating film of a semiconductor device, an interlayer insulating film for a rewiring layer, a stress buffer film, and the like are mentioned. In addition, a sealing film, a substrate material (a base film or cover lay of a flexible print substrate, an interlayer insulating film), or an insulating film applicable for mounting as described above, which is patterned by etching is mentioned. For these applications, for example, Science & Technology Co., Ltd., "High functionality and applied technology of polyimide" April 2008, CMC Technical library "Basics and development of polyimide materials" supervised by Masaaki Kakimoto, published in November 2011, "Latest Polyimide Basics and Applications" edited by Japan Polyimide & Aromatic Polymers Study Group, NTS Inc, August 2010, or the like can be referred to.

In addition, the cured film according to the embodiment of the present invention can also be used for production of board surfaces such as an offset board surface or a screen board surface, for etching of molded parts, for production of protective lacquers and dielectric layers in electronics, in particular, microelectronics, and the like.

The method for manufacturing a cured film according to the embodiment of the present invention includes using the photosensitive resin composition according to the embodiment of the present invention. Specifically, it is preferable to include the following steps (a) to (d).

(a) Film forming step of applying a photosensitive resin composition to a substrate to form a film.
(b) Exposure step of exposing the film after the film forming step.
(c) Developing step of performing a development treatment on an exposed photosensitive resin composition layer.
(d) Heating step of heating the developed photosensitive resin composition at 80°C to 450°C.

As in this embodiment, the resin layer cured by exposure can be further cured by heating after development. The thermal base generator according to the embodiment of the present invention acts in this heating step, whereby sufficient curability is obtained.

The method for manufacturing a laminate according to the preferred embodiment of the present invention includes a method for manufacturing a cured film according to the embodiment of the present invention. In the method for manufacturing a laminate of the present embodiment, the step (a), the steps (a) to (c), or the steps (a) to (d) are further performed again after forming the cured film according to the above-described method for manufacturing a cured film. In particular, it is preferable to carry out each of the above steps a plurality of times, for example, 2 to 5 times (that is, 3 to 6 times in total) in order. By laminating the cured film in this manner, a laminate can be obtained. In the present invention, it is preferable to provide a metal layer particularly on the portion in which a cured film is provided, between the cured films, or both thereon and therebetween. In manufacturing a laminate, it is not necessary to repeat all the steps (a) to (d), and as described above, at least the step (a), preferably the steps (a) to (c) or the steps (a) to (d) can be performed a plurality of times to obtain a laminate of the cured film.

<<Film forming step (layer forming step)>>

The manufacturing method according to the preferred embodiment of the present invention includes the film forming step (layer forming step) of applying the photosensitive resin composition to a substrate to form a film (having a layer shape).

The type of substrate can be appropriately determined depending on the application, such as a semiconductor production substrate such as silicon, silicon nitride, polysilicon, silicon oxide, amorphous silicon, quartz, glass, an optical film, a ceramic material, a vapor deposited film, magnetic film, a reflection film, a metal substrate such as Ni, Cu, Cr, or Fe, paper, a spin on glass (SOG), a thin film transistor (TFT) array substrate, and an electrode plate of a plasma display panel (PDP), and is not particularly limited thereto. In the present invention, in particular, the semiconductor production substrate is preferable, and the silicon substrate is more preferable.

In a case where the photosensitive resin composition layer is formed on a surface of a resin layer or on a surface of the metal layer, the resin layer or the metal layer is the substrate.

The means to apply the photosensitive resin composition to the substrate is preferably coating.

Specifically, as means for application, a dip coating method, an air knife coating method, a curtain coating method, a wire bar coating method, a gravure coating method, an extrusion coating method, a spray coating method, a spin coating method, a slit coating method, and an inkjet method are exemplified. From the viewpoint of uniformity of the thickness of the photosensitive resin composition layer, the spin coating method, the slit coating method, the spray coating method, or the inkjet method is more preferable. A resin layer having a desired thickness can be obtained by appropriately adjusting a concentration of the solid content and application conditions according to the method. In addition, the coating method can be appropriately selected depending on the shape of the substrate. In a case where a circular substrate such as a wafer is used, the spin coating method, the spray coating method, the inkjet method, and the like are preferable, and in a case where a rectangular substrate is used, the slit coating method, the spray coating method, the inkjet method, and the like are preferable. For example, the spin coating method can be applied at a rotational speed of 500 to 2,000 rpm for about 10 seconds to 1 minute.

<<Drying step>>

The manufacturing method according to the embodiment of the present invention may include, after the film forming step (the layer forming step), a step of drying to remove the solvent after forming the photosensitive resin composition layer. The preferred drying temperature is 50°C to 150°C, more preferably 70°C to 130°C, and still more preferably 90°C to 110°C. Examples of the drying time include 30 seconds to 20 minutes, and the drying time is preferably 1 minute to 10 minutes and more preferably 3 minutes to 7 minutes.

<<Exposure step>>

The manufacturing method according to the embodiment of the present invention may include an exposure step of exposing the photosensitive resin composition layer. The exposure amount is not particularly limited as long as the photosensitive resin composition can be cured, and for example, irradiation with 100 to 10,000 $mJ/cm^2$ is preferable, and irradiation with 200 to 8,000 $mJ/cm^2$ is more preferable, in terms of conversion of exposure energy at a wavelength of 365 nm.

The exposure wavelength can be appropriately determined in a range of 190 to 1,000 nm and preferably in a range of 240 to 550 nm.

The light sources in relation to the exposure wavelength are (1) a semiconductor laser (wavelength: 830 nm, 532 nm, 488 nm, 405 nm, or the like), (2) a metal halide lamp, (3) a high-pressure mercury lamp, a g-ray (wavelength: 436 nm), a h-ray (wavelength: 405 nm), an i-line (wavelength: 365 nm), or Broad (three wavelengths of g, h, and i-line), (4) an excimer laser, a KrF excimer laser (wavelength: 248 nm), an ArF excimer laser (wavelength: 193 nm), or a F2 excimer laser

(wavelength: 157 nm), (5) an extreme ultraviolet ray; EUV (wavelength: 13.6 nm), (6) an electron beam, and the like. Regarding the photosensitive resin composition according to the embodiment of the present invention, the exposure with a high-pressure mercury lamp is particularly preferable, and the exposure with an i-line is particularly preferable. In this case, particularly high exposure sensitivity can be obtained.

<<Development treatment step>>

The manufacturing method according to the embodiment of the present invention may include a development treatment step of performing development treatment on the exposed photosensitive resin composition layer. By performing development, an unexposed portion (non-exposed portion) is removed. The development method is not particularly limited as long as the development method can form the desired pattern, and, for example, a development method such as paddle, spray, immersion, and ultrasonic waves can be employed.

Development is performed using a developer. The developer can be used without particular limitation as long as the unexposed portion (non-exposed portion) is removed. The developer preferably contains an organic solvent, and the developer more preferably contains 90% or more of the organic solvent. In the present invention, the developer preferably contains an organic solvent having a ClogP value of -1 to 5 and more preferably an organic solvent having a ClogP value of 0 to 3. The ClogP value can be obtained as a calculated value by inputting a structural formula in ChemBioDraw.

The organic solvents, for example, esters such as ethyl acetate, n-butyl acetate, amyl formate, isoamyl acetate, isobutyl acetate, butyl propionate, isopropyl butyrate, ethyl butyrate, butyl butyrate, methyl lactate, ethyl lactate, γ-butyrolactone, ε-caprolactone, δ-valerolactone, an alkyl oxyacetate (example: a methyl alkyl oxyacetate, an ethyl alkyl oxy acetate, a butyl alkyl oxy acetate (for example, methyl methoxy acetate, ethyl methoxy acetate, butyl methoxy acetate, methyl ethoxy acetate, ethyl ethoxyacetate, and the like)), 3-alkyloxypropionic acid alkyl esters (example: a methyl 3-alkyloxypropionate, an ethyl 3-alkyloxypropionate, or the like (for example, methyl 3-methoxypropionate, ethyl 3-methoxypropionate), methyl 3-ethoxypropionate, ethyl 3-ethoxypropionate, and the like), 2-alkyloxypropionic acid alkyl esters (example: a methyl 2-alkyloxypropionate, an ethyl 2-alkyloxypropionate, a propyl 2-alkyl oxypropionate, or the like (for example, methyl 2-methoxypropionate, ethyl 2-methoxypropionate, propyl 2-methoxypropionate, methyl 2-ethoxypropionate, ethyl 2-ethoxypropionate)), a methyl 2-alkyloxy-2-methylpropionate and an ethyl 2-alkyloxy-2-methylpropionate (for example, methyl 2-methoxy-2-methylpropionate, ethyl 2-ethoxy-2-methylpropionate, and the like), methyl pyruvate, ethyl pyruvate, propyl pyruvate, methyl acetoacetate, ethyl acetoacetate, methyl 2-oxobutanoate, ethyl 2-oxobutanoate, and the like, and ethers, for example, such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, propylene glycol monopropyl ether acetate, and the like, and ketones, for example, such as methyl ethyl ketone, cyclohexanone, cyclopentanone, 2-heptanone, 3-heptanone, N-methyl-2-pyrrolidone, and the like, and aromatic hydrocarbons, for example, such as toluene, xylene, anisole, limonene, and the like, and sulfoxides such as dimethyl sulfoxide are suitably mentioned.

In the present invention, cyclopentanone and γ-butyrolactone are particularly preferable, and cyclopentanone is more preferable.

The developer is preferably 50% by mass or more of an organic solvent, more preferably 70% by mass or more of an organic solvent, and still more preferably 90% by mass or more of an organic solvent. In addition, the developer may be 100% by mass of an organic solvent.

The development time is preferably 10 seconds to 5 minutes. The temperature of the developer at the time of development is not particularly limited, and the development can usually be performed at 20°C to 40°C.

After treating with the developer, rinsing may be further performed. The rinsing is preferably performed with a solvent different from the developer. For example, the rinsing can be performed using the solvent contained in the photosensitive resin composition. The rinsing time is preferably 5 seconds to 1 minute.

<<Heating step>>

The manufacturing method according to the present invention preferably includes a step of heating after the film forming step (the layer forming step), the drying step, or the developing step. In the heating step, a cyclization reaction of the polymer precursor proceeds. In addition, the composition according to the embodiment of the present invention may contain a radically polymerizable compound other than the polymer precursor, and curing of the radically polymerizable compound other than the polymer precursor, which is not reacted, also can be advanced in this step. The heating temperature (the maximum heating temperature) of the layer in the heating step is preferably 50°C or higher, more preferably 80°C or higher, still more preferably 140°C or higher, even more preferably 150°C or higher, even still more preferably 160°C or higher, and even still further more preferably 170°C or higher. The upper limit thereof is preferably

500°C or lower, more preferably 450°C or lower, still more preferably 350°C or lower, even still more preferably 250°C or lower, and even still more preferably 220°C or lower.

The heating is preferably performed at a temperature elevation rate of 1°C to 12°C/min from the temperature at the start of heating to the maximum heating temperature, more preferably 2°C to 10°C/min, and still more preferably 3°C to 10°C/min. By setting the temperature elevation rate to 1°C/min or higher, excessive volatilization of the amine can be prevented while securing productivity, and by setting the temperature elevation rate to 12°C/min or lower, residual stress of the cured film can be relieved.

The temperature at the start of heating is preferably 20°C to 150°C, more preferably 20°C to 130°C, and still more preferably 25°C to 120°C. The temperature at the start of heating refers to a temperature at which the step of heating to the maximum heating temperature is started. For example, in a case where the photosensitive resin composition is applied on a substrate and then dried, the temperature at the start of heating is the temperature of the film (the layer) after drying, and for example, it is preferable to gradually raise the temperature from a temperature lower by 30°C to 200°C than the boiling point of the solvent contained in the photosensitive resin composition.

The heating time (the heating time at the maximum heating temperature) is preferably 10 to 360 minutes, more preferably 20 to 300 minutes, and still more preferably 30 to 240 minutes.

Particularly, in the case of forming a multilayer laminate, the heating is preferably performed at 180°C to 320°C, and more preferably 180°C to 260°C, from the viewpoint of adhesion between the cured films. Although the reason is not clear, it is considered that, at this temperature, the ethynyl groups of the polymer precursor between layers mutually undergo a crosslinking reaction.

The heating may be performed stepwise. For example, a pretreatment step in which the temperature is raised from 25°C to 180°C at 3 °C/min, held at 180°C for 60 minutes, raised from 180°C to 200°C at 2 °C/min, held at 200°C for 120 minutes, and the like may be performed. The heating temperature as the pretreatment step is preferably 100°C to 200°C, more preferably 110°C to 190°C, and still more preferably 120°C to 185°C. In the pretreatment step, it is also preferable to perform the treatment while irradiating with ultraviolet rays as described in US9159547B. By such a pretreatment step, it is possible to improve the properties of the film. The pretreatment step may be performed for a short time of about 10 seconds to two hours, and more preferably 15 seconds to 30 minutes. The pretreatment may be performed in two or more steps, for example, a pretreatment step 1 may be performed in a range of 100°C to 150°C, and then a pretreatment step 2 may be performed in a range of 150°C to 200°C.

Further, it may be cooled after heating, and the cooling rate in this case is preferably 1 to 5°C/min.

It is preferable that the heating step is performed in an atmosphere of low oxygen concentration by flowing an inert gas such as nitrogen, helium, argon, or the like, from the viewpoint of preventing the decomposition of the polymer precursor. The oxygen concentration is preferably 50 ppm (volume ratio) or lower, and more preferably 20 ppm (volume ratio) or lower.

<<Metal layer forming step>>

It is preferable that the manufacturing method according to the embodiment of the present invention includes a metal layer forming step of forming a metal layer on the surface of the photosensitive resin composition layer after development treatment.

As the metal layer, while existing metal types can be used without particular limitation, copper, aluminum, nickel, vanadium, titanium, chromium, cobalt, gold, and tungsten are exemplified, copper and aluminum are more preferable, and copper is still more preferable.

The method of forming the metal layer does not have a particular limitation, and the existing method can be applied. For example, the methods disclosed in JP2007-157879A, JP2001-521288A, JP2004-214501A, and JP2004-101850A can be used. For example, photolithography, lift-off, electrolytic plating, electroless plating, etching, printing, and methods combining these may be considered. More specific examples of the method of forming the metal layer include a patterning method combining sputtering, photolithography, and etching, and a patterning method combining photolithography and electrolytic plating.

The thickness of the metal layer is preferably 0.1 to 50 μm, and more preferably 1 to 10 μm at the thickest part.

<<Laminating step>>

The production method according to the embodiment of the present invention preferably further includes a laminating step.

The laminating step is a series of steps including performing the following steps in order on the surface of the cured film (resin layer) or the metal layer; (a) film forming step (layer forming step), (b) exposure step, (c) development treatment step, and (d) heating step again on the surface of the cured film (resin layer) or metal layer. However, the aspect may be such that only the (a) film forming step (a) is repeated. In addition, the aspect may be such that the (d) heating step is

performed at one time at the end or in the middle of the lamination. That is, the aspect may be such that the steps (a) to (c) are repeated a predetermined number of times, and then the heating of the step (d) is performed to cure the laminated photosensitive resin composition layers at one time. In addition, the (c) developing step may be followed by the (e) metal layer forming step, and even in this case, the heating of the step (d) may be performed each time, or the heating of the step (d) may be performed at one time after lamination is performed a predetermined number of times. Further, the laminating step may appropriately include the above-described drying step, heating step, and the like.

In a case where the laminating step is further performed the laminating step, a surface activation treatment step may be further performed after the heating step, the exposure step, or the metal layer forming step. Plasma treatment is exemplified as the surface activation treatment.

The laminating step is preferably performed 2 to 5 times, and more preferably 3 to 5 times.

For example, a configuration having 3 to 7 resin layers such as a resin layer/a metal layer/a resin layer/a metal layer/a resin layer/a metal layer is preferable, and a configuration having 3 to 5 resin layers is more preferable.

In the present invention, an aspect in which after a metal layer is formed, further a cured film (a resin layer) of the photosensitive resin composition is formed to cover the metal layer is particularly preferable. Specifically, an aspect in which (a) film forming step, (b) exposure step, (c) developing step, (e) metal layer forming step, and (d) heating step are repeated in order, or an aspect in which (a) film forming step, (b) exposure step, (c) developing step, and (e) metal layer forming step are repeated in order, and then (d) heating step is performed at one time at the end or in the middle thereof. By alternately performing the laminating step of laminating the photosensitive resin composition layer (resin) and the metal layer forming step, the photosensitive resin composition layer (resin layer) and the metal layer can be alternately laminated.

In the present invention, a semiconductor device having the cured film or the laminate according to the embodiment of the present invention is also disclosed. As the specific example of the semiconductor device using the photosensitive resin composition according to the embodiment of the present invention for forming an interlayer insulating film for a rewiring layer, the description in paragraphs 0213 to 0218 and the description of Fig. 1 of JP2016-027357A can be referred to.

Examples

Hereinafter, the present invention will be described more specifically with reference to Examples. "Parts" and "%" are on the mass basis unless otherwise described.

<Synthesis Example 1>

[Synthesis of polyimide precursor (A-1: polyimide precursor having no radically polymerizable group) from pyromellitic acid dianhydride, 4,4'-diaminodiphenyl ether, and benzyl alcohol]

14.06 g (64.5 mmol) of pyromellitic acid dianhydride (dried at 140°C for 12 hours) and 14.22 g (131.58 mmol) of benzyl alcohol were suspended in 50 mL of N-methylpyrrolidone and dried with a molecular sieve. The suspension was heated at 100°C for 3 hours. The reaction mixture was cooled to room temperature and 21.43 g (270.9 mmol) of pyridine and 90 mL of N-methylpyrrolidone were added thereto. Then, the reaction mixture was cooled to -10°C, and 16.12 g (135.5 mmol) of $SOCl_2$ was added thereto over 10 minutes, while keeping the temperature at -10°C ± 4°C. Viscosity increased while adding $SOCl_2$. After diluting with 50 mL of N-methylpyrrolidone, the reaction mixture was stirred at room temperature for 2 hours. Then, a solution prepared by dissolving 11.08 g (58.7 mmol) of 4,4'-diaminodiphenyl ether in 100 mL of N-methylpyrrolidone was dropwise added to the reaction mixture at -5°C to 0°C over 20 minutes. Then, the reaction mixture was reacted at 0°C for 1 hour, thereafter 70 g of ethanol was added, and the mixture was stirred at room temperature overnight. Next, the polyimide precursor was precipitated in 5 liters of water and the water-polyimide precursor mixture was stirred for 15 minutes at a speed of 5,000 rpm. The polyimide precursor was filtered off, stirred again in 4 liters of water for 30 minutes, and filtered again. Then, the obtained polyimide precursor was dried under reduced pressure at 45°C for 3 days. The weight-average molecular weight of this polyimide precursor was 18,000.

A-1

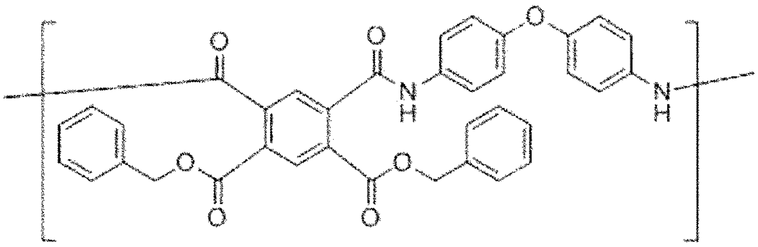

<Synthesis Example 2>

[Synthesis of polyimide precursor (A-2: polyimide precursor having radically polymerizable group) from pyromellitic acid dianhydride, 4,4'-diaminodiphenyl ether, and 2-hydroxyethyl methacrylate]

14.06 g (64.5 mmol) of pyromellitic acid dianhydride (dried at 140°C for 12 hours), 16.8 g (129 mmol) of 2-hydroxyethyl methacrylate, 0.05 g of hydroquinone, 20.4 g (258 mmol) of pyridine, 100 g of diethylene glycol dimethyl ether (diglyme) were mixed and stirred at a temperature of 60°C for 18 hours to produce a diester of pyromellitic acid and 2-hydroxyethyl methacrylate. Next, the obtained diester was chlorinated with $SOCl_2$ and then converted to a polyimide precursor with 4,4'-diaminodiphenyl ether in the same manner as in Synthesis Example 1, and a polyimide precursor was obtained in the same manner as in Synthesis Example 1. The weight-average molecular weight of this polyimide precursor was 19,000.

A-2

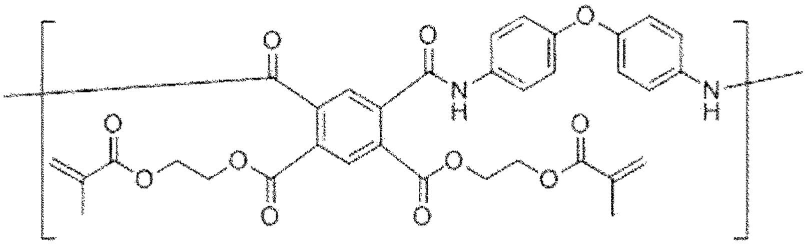

<Synthesis Example 3>

[Synthesis of polyimide precursor (A-3: polyimide precursor having radically polymerizable group) from 4,4'-oxydiphthalic acid dianhydride, 4,4'-diaminodiphenyl ether, and 2-hydroxyethyl methacrylate]

20.0 g (64.5 mmol) of 4,4'-oxydiphthalic acid dianhydride (dried at 140°C for 12 hours), 16.8 g (129 mmol) of 2-hydroxyethyl methacrylate, 0.05 g of hydroquinone, 20.4 g (258 mmol) of pyridine, 100 g of diglyme were mixed and stirred at a temperature of 60°C for 18 hours to produce a diester of 4,4'-oxydiphthalic acid and 2-hydroxyethyl methacrylate. Next, the obtained diester was chlorinated with $SOCl_2$ and then converted to a polyimide precursor with 4,4'-diaminodiphenyl ether in the same manner as in Synthesis Example 1, and a polyimide precursor was obtained in the same manner as in Synthesis Example 1. The weight-average molecular weight of this polyimide precursor was 18,000.

A-3

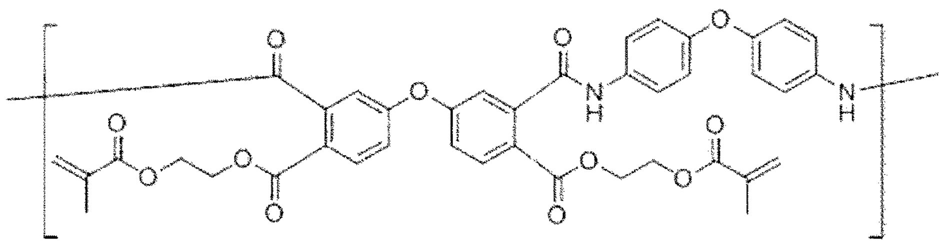

<Synthesis Example 4>

[Synthesis of polyimide precursor (A-4: polyimide precursor having radically polymerizable group) from 4,4'-oxydiphthalic acid dianhydride, 4,4'-diamino-2,2'-dimethylbiphenyl (orthotolidine), and 2-hydroxyethyl methacrylate]

20.0 g (64.5 mmol) of 4,4'-oxydiphthalic acid dianhydride (dried at 140°C for 12 hours), 16.8 g (129 mmol) of 2-hydroxyethyl methacrylate, 0.05 g of hydroquinone, 20.4 g (258 mmol) of pyridine, 100 g of diglyme were mixed and stirred at a temperature of 60°C for 18 hours to produce a diester of 4,4'-oxydiphthalic acid and 2-hydroxyethyl methacrylate. Next, the obtained diester was chlorinated with $SOCl_2$ and then converted to a polyimide precursor with 4,4'-diamino-2,2'-dimethylbiphenyl in the same manner as in Synthesis Example 1, and a polyimide precursor was obtained in the same manner as in Synthesis Example 1. The weight-average molecular weight of this polyimide precursor was 19,000.

A-4

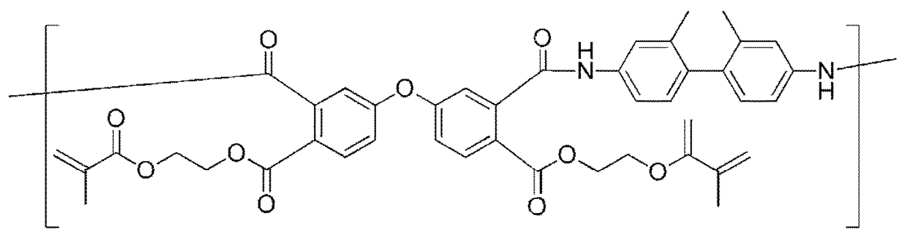

<Synthesis Example 5>

[Synthesis of polybenzoxazole precursor (A-5) from 2,2'-bis (3-amino-4-hydroxyphenyl) hexafluoropropane and 4,4'-oxydibenzoyl chloride]

13.92 g of 2,2'-bis(3-amino-4-hydroxyphenyl) hexafluoropropane was added in 100 mL of N-methylpyrrolidone and then stirred and dissolved. Subsequently, 11.21 g of 4,4'-oxydibenzoyl chloride was added dropwise over 10 minutes while maintaining the temperature at 0°C to 5°C, and stirring was continued for 60 minutes. Then, the polybenzoxazole precursor was precipitated in 6 liters of water and the water-polybenzoxazole precursor mixture was stirred at a speed of 5,000 rpm for 15 minutes. The polybenzoxazole precursor was filtered off, stirred again in 6 liters of water for 30 minutes, and filtered again. Then, the obtained polybenzoxazole precursor was dried under reduced pressure at 45°C for 3 days. The weight-average molecular weight of this polybenzoxazole precursor was 15,000.

A-5

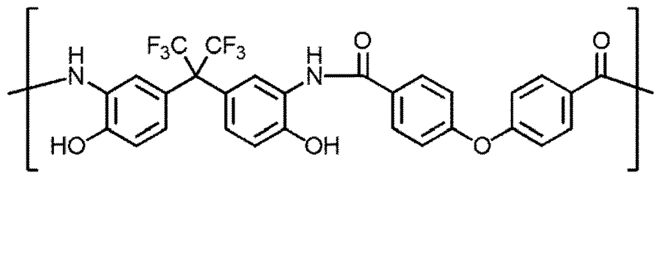

<Synthesis Example 6>

[Synthesis of polymer (RA-1) for Comparative Example]

27.0 g (153.2 mmol) of benzyl methacrylate, 20 g (157.3 mmol) of N-isopropylmethacrylamide, 39 g (309.2 mmol) of allyl methacrylate, 13 g (151.0 mmol) of methacrylic acid, 3.55 g (15.4 mmol) of a polymerization initiator (V-601, manufactured by FUJIFILM Wako Pure Chemical Corporation), and 300 g of 3-methoxy-2-propanol were mixed. The mixed solution was dropwise added to 300 g of 3-methoxy-2-propanol heated to 75°C under a nitrogen atmosphere over 2 hours. After completion of the dropwise addition, the mixture was further stirred at 75°C for 2 hours under a nitrogen atmosphere. After the completion of this stirring, the polymer was precipitated in 5 liters of water and stirred at a speed of 5,000 rpm for 15 minutes. The acrylic resin was filtered off, stirred again in 4 liters of water for 30 minutes, and filtered again. Then, the obtained acrylic resin was dried under reduced pressure at 45°C for 3 days. The weight-average molecular weight of this polymer was 25,000.

RA-1

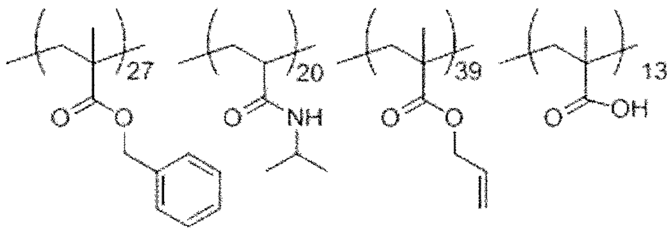

<Examples and Comparative Examples>

The components listed in the table below were mixed to obtain each photosensitive resin composition. The obtained photosensitive resin composition was pressure-filtered through a filter having a pore width of 0.8 μm. Then, each photosensitive resin composition was evaluated for storage stability, imidization rate, breaking elongation, and resolution of the minimum line width pattern.
Photosensitive resin compositions 29 and 32 are not according to the present invention.

[Table 1]

| Photosensitive resin composititon | (A) Heterocyclic ring-containing polymer percursor | | (B) Base generator | | (C) Radical polymerization initiator | | (D) Radically polymerizable compound | | (E) Polymerization inhibitor | | (F) Migration suppressing agent | | (G) Metal adhesiveness improving agent | | (I) Solvent | | | |
|---|---|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass | Type | Parts by mass |
| 1 | A-1 | 31.3 | B-1 | 1.3 | C-1 | 1.2 | D-1 | 5.5 | E-1 | 0.1 | F-1 | 0.1 | G-1 | 0.6 | I-1 | 45 | I-2 | 15 |
| 2 | A-2 | 31.3 | B-1 | 1.3 | C-1 | 1.2 | D-1 | 5.5 | E-1 | 0.1 | F-1 | 0.1 | G-1 | 0.6 | I-1 | 45 | I-2 | 15 |
| 3 | A-3 | 31.3 | B-1 | 1.3 | C-1 | 1.2 | D-1 | 5.5 | E-1 | 0.1 | F-1 | 0.1 | G-1 | 0.6 | I-1 | 45 | I-2 | 15 |
| 4 | A-4 | 31.3 | B-1 | 1.3 | C-1 | 1.2 | D-1 | 5.5 | E-1 | 0.1 | F-1 | 0.1 | G-1 | 0.6 | I-1 | 45 | I-2 | 15 |
| 5 | A-5 | 31.3 | B-1 | 1.3 | C-1 | 1.2 | D-1 | 5.5 | E-1 | 0.1 | F-1 | 0.1 | G-1 | 0.6 | I-1 | 60 | I-2 | 0 |
| 6 | A-3 | 31.3 | B-2 | 1.3 | C-1 | 1.2 | D-1 | 5.5 | E-1 | 0.1 | F-1 | 0.1 | G-1 | 0.6 | I-1 | 45 | I-2 | 15 |
| 7 | A-3 | 31.3 | B-3 | 1.3 | C-1 | 1.2 | D-1 | 5.5 | E-1 | 0.1 | F-1 | 0.1 | G-1 | 0.6 | I-1 | 45 | I-2 | 15 |
| 8 | A-3 | 31.3 | B-4 | 1.3 | C-1 | 1.2 | D-1 | 5.5 | E-1 | 0.1 | F-1 | 0.1 | G-1 | 0.6 | I-1 | 45 | I-2 | 15 |
| 9 | A-3 | 31.3 | B-5 | 1.3 | C-1 | 1.2 | D-1 | 5.5 | E-1 | 0.1 | F-1 | 0.1 | G-1 | 0.6 | I-1 | 45 | I-2 | 15 |
| 10 | A-3 | 31.3 | B-6 | 1.3 | C-1 | 1.2 | D-1 | 5.5 | E-1 | 0.1 | F-1 | 0.1 | G-1 | 0.6 | I-1 | 45 | I-2 | 15 |
| 11 | A-3 | 31.3 | B-7 | 1.3 | C-1 | 1.2 | D-1 | 5.5 | E-1 | 0.1 | F-1 | 0.1 | G-1 | 0.6 | I-1 | 45 | I-2 | 15 |
| 12 | A-3 | 31.3 | B-8 | 1.3 | C-1 | 1.2 | D-1 | 5.5 | E-1 | 0.1 | F-1 | 0.1 | G-1 | 0.6 | I-1 | 45 | I-2 | 15 |
| 13 | A-3 | 31.3 | B-9 | 1.3 | C-1 | 1.2 | D-1 | 5.5 | E-1 | 0.1 | F-1 | 0.1 | G-1 | 0.6 | I-1 | 45 | I-2 | 15 |
| 14 | A-3 | 31.3 | B-10 | 1.3 | C-1 | 1.2 | D-1 | 5.5 | E-1 | 0.1 | F-1 | 0.1 | G-1 | 0.6 | I-1 | 45 | I-2 | 15 |
| 15 | A-3 | 31.3 | B-11 | 1.3 | C-1 | 1.2 | D-1 | 5.5 | E-1 | 0.1 | F-1 | 0.1 | G-1 | 0.6 | I-1 | 45 | I-2 | 15 |
| 16 | A-3 | 31.3 | B-12 | 1.3 | C-1 | 1.2 | D-1 | 5.5 | E-1 | 0.1 | F-1 | 0.1 | G-1 | 0.6 | I-1 | 45 | I-2 | 15 |
| 17 | A-3 | 31.3 | B-13 | 1.3 | C-1 | 1.2 | D-1 | 5.5 | E-1 | 0.1 | F-1 | 0.1 | G-1 | 0.6 | I-1 | 45 | I-2 | 15 |
| 18 | A-3 | 31.3 | B-14 | 1.3 | C-1 | 1.2 | D-1 | 5.5 | E-1 | 0.1 | F-1 | 0.1 | G-1 | 0.6 | I-1 | 45 | I-2 | 15 |
| 19 | A-3 | 31.3 | B-15 | 1.3 | C-1 | 1.2 | D-1 | 5.5 | E-1 | 0.1 | F-1 | 0.1 | G-1 | 0.6 | I-1 | 45 | I-2 | 15 |
| 20 | A-3 | 31.3 | B-16 | 1.3 | C-1 | 1.2 | D-1 | 5.5 | E-1 | 0.1 | F-1 | 0.1 | G-1 | 0.6 | I-1 | 45 | I-2 | 15 |
| 21 | A-3 | 31.3 | B-17 | 1.3 | C-1 | 1.2 | D-1 | 5.5 | E-1 | 0.1 | F-1 | 0.1 | G-1 | 0.6 | I-1 | 45 | I-2 | 15 |
| 22 | A-3 | 31.3 | B-18 | 1.3 | C-1 | 1.2 | D-1 | 5.5 | E-1 | 0.1 | F-1 | 0.1 | G-1 | 0.6 | I-1 | 45 | I-2 | 15 |

(continued)

| Photosensitive resin composititon | (A) Heterocyclic ring-containing polymer percursor | | (B) Base generator | | (C) Radical polymerization initiator | | (D) Radically polymerizable compound | | (E) Polymerization inhibitor | | (F) Migration suppressing agent | | (G) Metal adhesiveness improving agent | | (I) Solvent | | | |
|---|---|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass | Type | Parts by mass |
| 23 | A-3 | 31.3 | B-19 | 1.3 | C-1 | 1.2 | D-1 | 5.5 | E-1 | 0.1 | F-1 | 0.1 | G-1 | 0.6 | I-1 | 45 | I-2 | 15 |
| 24 | A-3 | 31.3 | B-20 | 1.3 | C-1 | 1.2 | D-1 | 5.5 | E-1 | 0.1 | F-1 | 0.1 | G-1 | 0.6 | I-1 | 45 | I-2 | 15 |
| 25 | A-3 | 31.3 | B-21 | 1.3 | C-1 | 1.2 | D-1 | 5.5 | E-1 | 0.1 | F-1 | 0.1 | G-1 | 0.6 | I-1 | 45 | I-2 | 15 |
| 26 | A-3 | 31.3 | B-22 | 1.3 | C-1 | 1.2 | D-1 | 5.5 | E-1 | 0.1 | F-1 | 0.1 | G-1 | 0.6 | I-1 | 45 | I-2 | 15 |
| 27 | A-3 | 31.3 | B-23 | 1.3 | C-1 | 1.2 | D-1 | 5.5 | E-1 | 0.1 | F-1 | 0.1 | G-1 | 0.6 | I-1 | 45 | I-2 | 15 |
| 28 | A-3 | 31.3 | B-24 | 1.3 | C-1 | 1.2 | D-1 | 5.5 | E-1 | 0.1 | F-1 | 0.1 | G-1 | 0.6 | I-1 | 45 | I-2 | 15 |
| 29 | A-3 | 31.3 | B-25 | 1.3 | C-1 | 1.2 | D-1 | 5.5 | E-1 | 0.1 | F-1 | 0.1 | G-1 | 0.6 | I-1 | 45 | I-2 | 15 |
| 30 | A-3 | 31.3 | B-26 | 1.3 | C-1 | 1.2 | D-1 | 5.5 | E-1 | 0.1 | F-1 | 0.1 | G-1 | 0.6 | I-1 | 45 | I-2 | 15 |

[Table 2]

| Photosensitive resin composition | (A) Heterocyclic ring-containing polymer precursor | | (B) Base generator | | (C) Radical polymerization initiator | | (D) Radically polymerizable compound | | (E) Polymerization inhibitor | | (F) Migration suppressing agent | | (G) Metal adhesiveness improving agent | | (I) Solvent | | | |
|---|---|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass | Type | Parts by mass |
| 31 | A-3 | 31.3 | B-27 | 1.3 | C-1 | 1.2 | D-1 | 5.5 | E-1 | 0.1 | F-1 | 0.1 | G-1 | 0.6 | I-1 | 45 | I-2 | 15 |
| 32 | A-3 | 31.3 | B-28 | 1.3 | C-1 | 1.2 | D-1 | 5.5 | E-1 | 0.1 | F-1 | 0.1 | G-1 | 0.6 | I-1 | 45 | I-2 | 15 |
| 33 | A-3 | 31.3 | B-29 | 1.3 | C-1 | 1.2 | D-1 | 5.5 | E-1 | 0.1 | F-1 | 0.1 | G-1 | 0.6 | I-1 | 45 | I-2 | 15 |
| 34 | A-3 | 31.3 | B-30 | 1.3 | C-1 | 1.2 | D-1 | 5.5 | E-1 | 0.1 | F-1 | 0.1 | G-1 | 0.6 | I-1 | 45 | I-2 | 15 |
| 35 | A-3 | 31.3 | B-31 | 1.3 | C-1 | 1.2 | D-1 | 5.5 | E-1 | 0.1 | F-1 | 0.1 | G-1 | 0.6 | I-1 | 45 | I-2 | 15 |
| 36 | A-3 | 31.3 | B-32 | 1.3 | C-1 | 1.2 | D-1 | 5.5 | E-1 | 0.1 | F-1 | 0.1 | G-1 | 0.6 | I-1 | 45 | I-2 | 15 |
| 37 | A-3 | 32.3 | B-7 | 0.0 | C-1 | 1.2 | D-1 | 5.7 | E-1 | 0.1 | F-1 | 0.1 | G-1 | 0.6 | I-1 | 45 | I-2 | 15 |
| 38 | A-3 | 32.0 | B-7 | 0.4 | C-1 | 1.2 | D-1 | 5.6 | E-1 | 0.1 | F-1 | 0.1 | G-1 | 0.6 | I-1 | 45 | I-2 | 15 |
| 39 | A-3 | 30.8 | B-7 | 1.9 | C-1 | 1.2 | D-1 | 5.4 | E-1 | 0.1 | F-1 | 0.1 | G-1 | 0.6 | I-1 | 45 | I-2 | 15 |
| 40 | A-3 | 28.1 | B-7 | 5.3 | C-1 | 1.1 | D-1 | 4.9 | E-1 | 0.1 | F-1 | 0.1 | G-1 | 0.5 | I-1 | 45 | I-2 | 15 |
| 41 | A-3 | 31.3 | B-8 | 1.3 | C-2 | 1.2 | D-1 | 5.5 | E-1 | 0.1 | F-1 | 0.1 | G-1 | 0.6 | I-1 | 45 | I-2 | 15 |
| 42 | A-3 | 31.3 | B-8 | 1.3 | C-3 | 1.2 | D-1 | 5.5 | E-1 | 0.1 | F-1 | 0.1 | G-1 | 0.6 | I-1 | 45 | I-2 | 15 |
| 43 | A-3 | 31.3 | B-8 | 1.3 | C-1 | 1.2 | D-2 | 5.5 | E-1 | 0.1 | F-1 | 0.1 | G-1 | 0.6 | I-1 | 45 | I-2 | 15 |
| 44 | A-3 | 31.3 | B-8 | 1.3 | C-1 | 1.2 | D-3 | 5.5 | E-1 | 0.1 | F-1 | 0.1 | G-1 | 0.6 | I-1 | 45 | I-2 | 15 |
| 45 | A-3 | 31.3 | B-8 | 1.3 | C-1 | 1.2 | D-1 | 5.5 | E-2 | 0.1 | F-1 | 0.1 | G-1 | 0.6 | I-1 | 45 | I-2 | 15 |
| 46 | A-3 | 31.3 | B-8 | 1.3 | C-1 | 1.2 | D-1 | 5.5 | E-3 | 0.1 | F-1 | 0.1 | G-1 | 0.6 | I-1 | 45 | I-2 | 15 |
| 47 | A-3 | 31.3 | B-8 | 1.3 | C-1 | 1.2 | D-1 | 5.5 | E-1 | 0.1 | F-2 | 0.1 | G-1 | 0.6 | I-1 | 45 | I-2 | 15 |
| 48 | A-3 | 31.3 | B-8 | 1.3 | C-1 | 1.2 | D-1 | 5.5 | E-1 | 0.1 | F-3 | 0.1 | G-1 | 0.6 | I-1 | 45 | I-2 | 15 |
| 49 | A-3 | 31.3 | B-8 | 1.3 | C-1 | 1.2 | D-1 | 5.5 | E-1 | 0.1 | F-4 | 0.1 | G-1 | 0.6 | I-1 | 45 | I-2 | 15 |
| 50 | A-3 | 31.3 | B-8 | 1.3 | C-1 | 1.2 | D-1 | 5.5 | E-1 | 0.1 | F-1 | 0.1 | G-2 | 0.6 | I-1 | 45 | I-2 | 15 |
| 51 | A-3 | 31.3 | B-8 | 1.3 | C-1 | 1.2 | D-1 | 5.5 | E-1 | 0.1 | F-1 | 0.1 | G-3 | 0.6 | I-1 | 45 | I-2 | 15 |
| 52 | A-3 | 31.3 | B-8 | 1.3 | C-1 | 1.2 | D-1 | 5.5 | E-1 | 0.1 | F-1 | 0.1 | G-1 | 0.6 | I-1 | 45 | I-2 | 15 |

(continued)

| Photosensitive resin composition | (A) Heterocyclic ring-containing polymer precursor | | (B) Base generator | | (C) Radical polymerization initiator | | (D) Radically polymerizable compound | | (E) Polymerization inhibitor | | (F) Migration suppressing agent | | (G) Metal adhesiveness improving agent | | (I) Solvent | | | |
|---|---|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass | Type | Parts by mass |
| 53 | A-3 | 31.3 | B-1 | 0.7 | C-1 | 1.2 | D-1 | 5.5 | E-1 | 0.1 | F-1 | 0.1 | G-1 | 0.6 | I-1 | 45 | I-2 | 15 |
| | | | B-8 | 0.7 | | | | | | | | | | | | | | |
| R-1 | A-3 | 31.3 | RB-1 | 1.3 | C-1 | 1.2 | D-1 | 5.5 | E-1 | 0.1 | F-1 | 0.1 | G-1 | 0.6 | I-1 | 45 | I-2 | 15 |
| R-2 | RA-1 | 31.3 | B-1 | 1.3 | C-1 | 1.2 | D-1 | 5.5 | E-1 | 0.1 | F-1 | 0.1 | G-1 | 0.6 | I-1 | 45 | I-2 | 15 |

<Components of photosensitive resin composition>

The details of the components constituting each photosensitive resin composition are as follows.

(A) Heterocyclic ring-containing polymer precursors: A-1 to A-5 and RA-1 synthesized as described above
(B) Specific thermal base generator: the exemplified compounds B-1 to B-33 described above

Base generator for Comparative Example: the following compounds

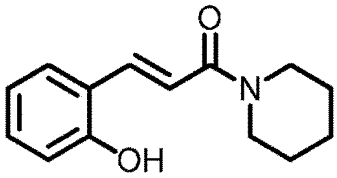

(RB-1)

(C) Photo-radical polymerization initiator

C-1: IRGACURE OXE 01 (manufactured by BASF SE)
C-2: IRGACURE OXE 02 (manufactured by BASF SE)
C-3: IRGACURE 369 (manufactured by BASF SE)

(D) Radically polymerizable compound

D-1: A-DPH (manufactured by Shin-Nakamura Chemical Co., Ltd., dipentaerythritol hexaacrylate)
D-2: SR-209 (manufactured by Sartomer Co., Ltd., the following compound)

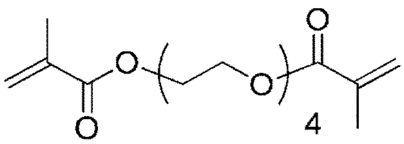

D-3: A-TMMT (pentaerythritol tetraacrylate manufactured by Shin-Nakamura Chemical Co., Ltd.)

(E) Polymerization inhibitor

E-1: 2,6-di-tert-butyl-4-methylphenol (manufactured by Tokyo Chemical Industry Co., Ltd.)
E-2: p-benzoquinone (manufactured by Tokyo Chemical Industry Co., Ltd.)
E-3: p-methoxyphenol (manufactured by Tokyo Chemical Industry Co., Ltd.)

(F) Migration suppressing agent

F-1: The following compound
F-2: The following compound
F-3: The following compound
F-4: The following compound

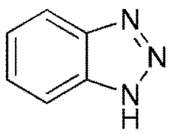
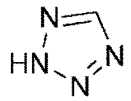
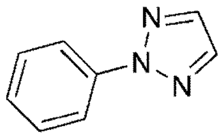
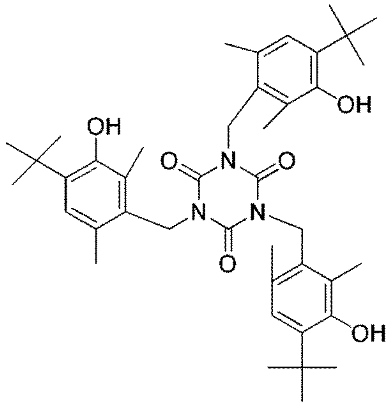

F－1 F－2 F－3 F－4

(G) Metal adhesiveness improving agent

G-1: The following compound
G-2: The following compound
G-3: The following compound

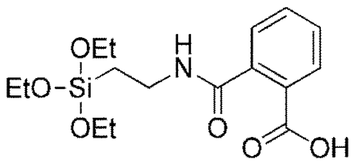

G－1

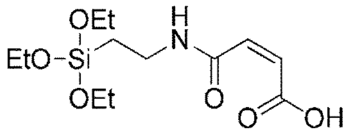

G－2

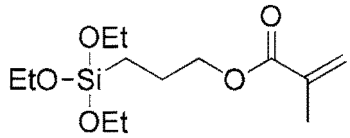

G－3

(I) Solvent

I-1: γ-butyrolactone (manufactured by Sanwayuka Industry Corporation)
I-2: Dimethyl sulfoxide (manufactured by FUJIFILM Wako Pure Chemical Corporation)

<Storage stability>

The viscosity (day 0) of the photosensitive resin composition after filtration was measured using an E-type viscometer. After allowing the photosensitive resin composition to stand in a closed container at 25°C for 14 days, the viscosity (day 14) was measured again using an E-type viscometer. Viscosity variation rate was calculated from the following expression. The lower the viscosity variation rate is, the higher the storage stability is.

$$\text{Viscosity variation rate} = [100 \times \{1 - (\text{viscosity (day 14)} / \text{viscosity (day 0)})\}]$$

The viscosity was measured at 25°C, and the others were in accordance with JISZ8803: 2011.

A: Viscosity variation rate is 5% or less.
B: Viscosity variation rate is more than 5% and 10% or less.
C: Viscosity variation rate is more than 10% and 15% or less.
D: Viscosity variation rate is more than 15% and 20% or less.
E: Viscosity variation rate is more than 20%.

<Imidization rate>

A silicon wafer was coated with each of the filtered photosensitive resin compositions in a layer shape by a spin coating method to form a photosensitive resin composition layer. The silicon wafer coated with the obtained photosensitive resin composition layer was dried at 100°C for 5 minutes on a hot plate to form a uniform photosensitive resin composition layer having a thickness of 20 μm on the silicon wafer. The photosensitive resin composition layer on the silicon wafer was exposed with an exposure energy of 500 mJ/$cm^2$ using a stepper (Nikon NSR 2005 i9C) to obtain an exposed photosensitive resin composition layer (a resin layer before curing). Next, the temperature was raised at a temperature elevaltion rate of 10°C/min under a nitrogen atmosphere, and after reaching 250°C, this temperature was maintained for 3 hours to obtain a resin layer after curing. ATR-IR measurement (TENSORII, manufactured by BRUKER) was performed on the resin layer before curing and the resin layer after curing, and the imidization rate was calculated from the following expression using a peak area of 1,660 $cm^{-1}$. The higher the imidization rate is, the more the imidization is progressing by heating, which indicates the result is preferable.

Imidization rate = 100 × [1 - (peak area (resin layer after curing) / peak area (resin layer before curing))]

A: Imidization rate is 90% or more.
B: Imidization rate is 80% or more and less than 90%.
C: Imidization rate is 70% or more and less than 80%.
D: Imidization rate is 60% or more and less than 70%.
E: Imidization rate is less than 60%.

<Breaking elongation>

A silicon wafer was coated with the filtered photosensitive resin composition described above in a layer shape by a spin coating method to form a photosensitive resin composition layer. The silicon wafer coated with the obtained photosensitive resin composition layer was dried at 100°C for 5 minutes on a hot plate to form a uniform photosensitive resin composition layer having a thickness of 20 μm on the silicon wafer. The photosensitive resin composition layer on the silicon wafer was exposed to an exposure energy of 500 mJ/$cm^2$ using a stepper (Nikon NSR 2005 i9C), the exposed photosensitive resin composition layer (resin layer) was subjected to a nitrogen atmosphere, the temperature was raised at a temperature elevation rate of 10 °C/min, and after reaching 180°C, this temperature was maintained for 3 hours. The cured resin layer was immersed in a 4.9% hydrofluoric acid solution, and the resin layer was peeled from the silicon wafer to obtain a resin film 1.

The breaking elongation of the resin film 1 was measured in accordance with JIS-K6251: 2017 in a longitudinal direction and the width direction of the film using a tensile tester (Tensilon) with a crosshead speed of 300 mm/min, a sample width of 10 mm, and a sample length of 50 mm in an environment of 25°C and 65% relative humidity (RH). The breaking elongation was calculated from $E_b = (L_b - L_0)/L_0$ ($E_b$: an elongation at the time of cutting, $L_0$: a length of the test piece before the test, $L_b$: a length of the test piece when the test piece is cut). The breaking elongation in each of the longitudinal direction and the width direction was independently measured five times, and the average value in each of the longitudinal direction and width direction was used for the evaluation.

A: Breaking elongation is more than 60%.
B: Breaking elongation is more than 55% and 60% or less.
C: Breaking elongation is more than 50% and 55% or less.
D: Breaking elongation is more than 40% and 50% or less.
E: Breaking elongation is 40% or less.

<Resolution of minimum line width pattern>

A silicon wafer was spin-coated with each of the photosensitive resin compositions after the filtration. The silicon wafer coated with the photosensitive resin composition was dried at 100°C for 5 minutes on a hot plate to form a uniform photosensitive resin composition layer having a film thickness of 20 μm on the silicon wafer. The photosensitive resin composition layer on the silicon wafer was exposed using a stepper (Nikon NSR 2005 i9C). Exposure was performed using an i-line with exposure energies of 200, 300, 400, 500, 600, 700, and 800 mJ/$cm^2$ at a wavelength of 365 nm, using line-and-space photomasks from 5 μm to 25 μm in 1 μm increments, whereby a resin layer was obtained.

The resin layer was developed with cyclopentanone for 60 seconds. The smaller the line width of the obtained

resin layer (line pattern) is, the finer pattern can be formed, which is the preferable result. In addition, the less the minimum line width that can be formed is hard to change with respect to the fluctuation of the exposure amount, the more the optionality of the exposure amount in forming the fine pattern increases, which is the preferable result. The measurement limit is 5 μm.

A: Line width was 5 μm or more and 8 μm or less.
B: Line width was more than 8 μm and less than 10 μm.
C: Line width was more than 10 μm and less than 15 μm.
D: Line width was more than 15 μm and 20 μm or less.
E: Line width was more than 20 μm.
F: A pattern having a line width with sharp edges could not be obtained.

[Table 3]

| | Photosensitive resin composition | Storage stability | Imidization rate | Breaking elongation | Evaluation of resolution of minimum line width pattern | | | | | | |
|---|---|---|---|---|---|---|---|---|---|---|---|
| | | | | | 200 | 300 | 400 | 500 | 600 | 700 | 800 |
| Example 1 | 1 | A | A | B | E | E | D | C | B | A | B |
| Example 2 | 2 | A | B | C | B | A | A | A | B | B | C |
| Example 3 | 3 | A | B | B | B | A | A | A | A | A | B |
| Example 4 | 4 | A | B | C | B | A | A | A | B | B | C |
| Example 5 | 5 | A | B | C | E | E | D | C | B | A | B |
| Example 6 | 6 | A | B | B | B | A | A | A | A | A | B |
| Example 7 | 7 | A | B | B | B | A | A | A | A | A | B |
| Example 8 | 8 | A | B | B | B | A | A | A | A | A | B |
| Example 9 | 9 | A | B | B | B | A | A | A | A | A | B |
| Example 10 | 10 | A | B | B | B | A | A | A | A | A | B |
| Example 11 | 11 | A | A | A | B | A | A | A | A | A | B |
| Example 12 | 12 | A | A | A | B | A | A | A | A | A | B |
| Example 13 | 13 | A | C | C | B | A | A | A | A | A | B |
| Example 14 | 14 | A | A | A | B | A | A | A | A | A | B |
| Example 15 | 15 | A | A | A | B | A | A | A | A | A | B |
| Example 16 | 16 | A | A | A | B | A | A | A | A | A | B |
| Example 17 | 17 | A | B | B | B | A | A | A | A | A | B |
| Example 18 | 18 | A | A | A | B | A | A | A | A | A | B |
| Example 19 | 19 | A | A | A | B | A | A | A | A | A | B |
| Example 20 | 20 | A | A | A | B | A | A | A | A | A | B |
| Example 21 | 21 | A | A | A | B | A | A | A | A | A | B |
| Example 22 | 22 | A | B | B | B | A | A | A | A | A | B |
| Example 23 | 23 | A | B | B | B | A | A | A | A | A | B |
| Example 24 | 24 | A | A | A | B | A | A | A | A | A | B |
| Example 25 | 25 | A | B | B | B | A | A | A | A | A | B |
| Example 26 | 26 | A | B | B | B | A | A | A | A | A | B |
| Example 27 | 27 | A | B | B | B | A | A | A | A | A | B |
| Example 28 | 28 | A | B | B | B | A | A | A | A | A | B |

(continued)

| | Photosensitive resin composition | Storage stability | Imidization rate | Breaking elongation | Evaluation of resolution of minimum line width pattern | | | | | | |
|---|---|---|---|---|---|---|---|---|---|---|---|
| | | | | | 200 | 300 | 400 | 500 | 600 | 700 | 800 |
| Example 29 | 29 | B | B | B | B | A | A | A | A | A | B |
| Example 30 | 30 | A | B | B | B | A | A | A | A | A | B |
| Example 31 | 31 | B | B | B | B | A | A | A | A | A | B |
| Example 32 | 32 | B | A | A | B | A | A | A | A | A | B |
| Example 33 | 33 | A | B | B | B | A | A | A | A | A | B |
| Example 34 | 34 | B | C | C | B | A | A | A | A | A | B |
| Example 35 | 35 | B | B | B | B | A | A | A | A | A | B |
| Example 36 | 36 | B | C | C | B | A | A | A | A | A | B |
| Example 37 | 37 | A | C | C | A | A | A | A | A | A | B |
| Example 38 | 38 | A | B | B | B | A | A | A | A | A | B |
| Example 39 | 39 | A | A | A | B | B | A | A | A | A | A |
| Example 40 | 40 | B | A | A | B | B | B | A | A | A | A |
| Example 41 | 41 | A | B | B | A | A | A | A | A | B | B |
| Example 42 | 42 | A | B | B | C | B | A | A | A | A | B |
| Example 43 | 43 | A | B | B | B | A | A | A | A | A | A |
| Example 44 | 44 | A | A | A | B | A | A | A | A | A | B |
| Example 45 | 45 | A | B | B | B | A | A | A | A | A | B |
| Example 46 | 46 | A | B | B | B | A | A | A | A | A | B |
| Example 47 | 47 | A | B | B | B | A | A | A | A | A | B |
| Example 48 | 48 | A | B | B | B | A | A | A | A | A | B |
| Example 49 | 49 | A | B | B | B | A | A | A | A | A | B |
| Example 50 | 50 | A | B | B | B | A | A | A | A | A | B |
| Example 51 | 51 | A | B | B | B | A | A | A | A | A | B |
| Example 52 | 52 | A | B | B | B | A | A | A | A | A | B |
| Example 53 | 53 | A | B | B | B | A | A | A | A | A | B |
| Comparative Example 1 | R-1 | B | D | E | E | D | C | C | B | B | C |
| Comparative Example 2 | R-2 | A | - | E | E | E | D | D | C | C | B |

The numerical value of "resolution of the minimum line width pattern" is the exposure energy, and the unit thereof is $mJ/cm^2$. The evaluation results of the resolution of the pattern at each exposure energy are shown.

From the above results, it has been found that the photosensitive resin composition containing the specific thermal base generator and the precursor of the heterocyclic ring-containing polymer according to the present invention has excellent storage stability and exhibits an excellent cyclization rate (imidization rate). In addition, it has been found that in a case where an alkyl group (particularly, an alkyl group having a cyclic structure) having a relatively large number of carbon atoms is adopted as $R^{N1}$ and $R^{N2}$ in Formula (N1) for the specific thermal base generator in response to a request, a cured film of the photosensitive resin composition can be excellent in breaking elongation. Further, it has been also found that a film of the photosensitive resin composition, which is excellent in pattern resolution, can be obtained by combining a polymer precursor having a radically polymerizable group, as necessary.

<Example 100>

The photosensitive resin composition of Example 1 was pressure-filtered through a filter having a pore width of 1.0 μm, and then spun (3,500 rpm, 30 seconds) and applied onto the surface of a resin substrate on which a thin copper layer was formed. The photosensitive resin composition applied onto the resin substrate was dried at 100°C for 2 minutes and then exposed using a stepper (NSR 1505 i6, manufactured by Nikon Corporation). The exposure was carried out through a mask at a wavelength of 365 nm and an exposure amount of 200 mJ/$cm^2$. After exposure, baking was performed, development with cyclopentanone was performed for 30 seconds, and rinsing with PGMEA was performed for 20 seconds to obtain a pattern.

Then, heating was performed at 230°C for 3 hours to form an interlayer insulating film for a rewiring layer. This interlayer insulating film for a rewiring layer was excellent in insulating properties.

## Claims

1. A photosensitive resin composition comprising:

   a thermal base generator represented by Formula (N1); and
   a precursor of a heterocyclic ring-containing polymer,

   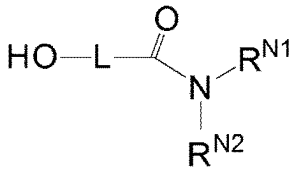

   Formula (N1);

   in Formula (N1),
   L represents a hydrocarbon group which is a divalent hydrocarbon group having a saturated hydrocarbon group on a path of a linking chain which links an oxygen atom and an adjacent carbon atom and in which the number of the atoms on the path of the linking chain is 4, 5 or 6, wherein the linking chain refers to an atomic chain which interconnects the linking targets with the minimum number of atoms, and
   $R^{N1}$ and $R^{N2}$ each independently represent a monovalent organic group and may be linked to each other to form a cyclic structure.

2. The photosensitive resin composition according to claim 1, wherein L in Formula (N1) has a structure represented by Formula (N2-a) or Formula (N2-b),

   $-L^1-Ar-L^2-$ Formula (N2-a);

   $-Ar^1-L^3-Ar^2-$ Formula (N2-b);

   in Formula (N2-a), $L^1$ and $L^2$ each independently represent a single bond or a hydrocarbon group, at least one of $L^1$ or $L^2$ contains a saturated hydrocarbon group on the path, and Ar represents an arylene group; and in Formula (N2-b), $L^3$ represents a hydrocarbon group containing a saturated hydrocarbon group on the path, and $Ar^1$ and $Ar^2$ each independently represent an arylene group.

3. The photosensitive resin composition according to claim 1 or 2, wherein $R^{N1}$ and $R^{N2}$ in Formula (N1) are each independently an aliphatic hydrocarbon group.

4. The photosensitive resin composition according to claim 3, wherein at least one of $R^{N1}$ or $R^{N2}$ in Formula (N1) is an aliphatic hydrocarbon group having a polar group.

5. The photosensitive resin composition according to claim 1 or 2, wherein $R^{N1}$ and $R^{N2}$ in Formula (N1) are linked to each other to form an aliphatic cyclic structure.

6. The photosensitive resin composition according to claim 5, wherein the aliphatic cyclic structure has at least a polar group as a part of a substituent.

**7.** The photosensitive resin composition according to any one of claims 1 to 6, further comprising a photo-radical polymerization initiator and a radically polymerizable compound.

**8.** The photosensitive resin composition according to any one of claims 1 to 7, wherein the precursor of the heterocyclic ring-containing polymer includes a polyimide precursor or a polybenzoxazole precursor.

**9.** The photosensitive resin composition according to claim 8, wherein the precursor of the heterocyclic ring-containing polymer includes the polyimide precursor.

**10.** The photosensitive resin composition according to claim 9, wherein the polyimide precursor has a constitutional unit represented by Formula (1),

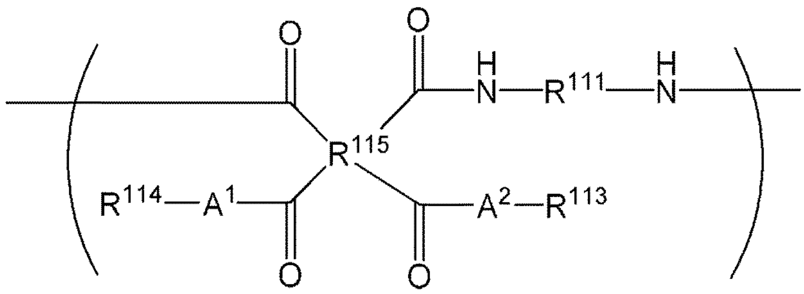

(1)

in Formula (1), $A^1$ and $A^2$ each independently represent an oxygen atom or NH, $R^{111}$ represents a divalent organic group, $R^{115}$ represents a tetravalent organic group, and $R^{113}$ and $R^{114}$ each independently represent a hydrogen atom or a monovalent organic group.

**11.** The photosensitive resin composition according to claim 10, wherein at least one of $R^{113}$ or $R^{114}$ in Formula (1) contains a radically polymerizable group.

**12.** Use of the photosensitive resin composition according to any one of claims 1 to 11 for forming an interlayer insulating film for a rewiring layer.

**13.** A cured film obtained by curing the photosensitive resin composition according to any one of claims 1 to 11.

**14.** A laminate comprising two or more cured films according to claim 13, wherein a metal layer is provided between any cured films.

**15.** A method for manufacturing a cured film, comprising a film forming step of applying the photosensitive resin composition according to any one of claims 1 to 11 onto a substrate to form a film.

**16.** The method for manufacturing a cured film according to claim 15, further comprising a step of heating the film at 50° to 450°C.

**17.** A semiconductor device comprising the cured film according to claim 13 or the laminate according to claim 14.

**Patentansprüche**

**1.** Lichtempfindliche Harzzusammensetzung, umfassend:

einen thermischen Basengenerator, der durch Formel (N1) dargestellt wird; und
einen Vorläufer eines heterocyclischen ringhaltigen Polymers,

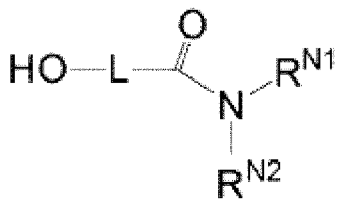

Formel (N1);

wobei in Formel (N1),
L eine Kohlenwasserstoffgruppe darstellt, die eine divalente Kohlenwasserstoffgruppe mit einer gesättigten Kohlenwasserstoffgruppe auf einem Pfad einer Verknüpfungskette, die ein Sauerstoffatom und ein benachbartes Kohlenstoffatom verknüpft, ist, und bei der die Anzahl der Atome auf dem Pfad der Verknüpfungskette 4, 5 oder 6 beträgt, wobei sich die Verknüpfungskette auf eine Atomkette, die die Verknüpfungsziele mit der minimalen Anzahl an Atomen miteinander verbindet, bezieht, und
$R^{N1}$ und $R^{N2}$ jeweils unabhängig voneinander eine einwertige organische Gruppe darstellen und miteinander verknüpft sein können, um eine zyklische Struktur zu bilden.

**2.** Lichtempfindliche Harzzusammensetzung nach Anspruch 1, wobei L in Formel (N1) eine Struktur, die durch Formel (N2-a) oder Formel (N2-b) dargestellt wird, aufweist,

$-L^1-Ar-L^2-$ Formel (N2-a);

$-Ar^1-L^3-Ar^2-$ Formel (N2-b);

wobei in Formel (N2-a) $L^1$ und $L^2$ jeweils unabhängig eine Einfachbindung oder eine Kohlenwasserstoffgruppe darstellen, mindestens eine von $L^1$ und $L^2$ eine gesättigte Kohlenwasserstoffgruppe auf dem Pfad enthält und Ar eine Arylengruppe darstellt; und in Formel (N2-b) $L^3$ eine Kohlenwasserstoffgruppe, die eine gesättigte Kohlenwasserstoffgruppe auf dem Pfad enthält, darstellt und $Ar^1$ und $Ar^2$ jeweils unabhängig voneinander eine Arylengruppe darstellen.

**3.** Lichtempfindliche Harzzusammensetzung nach Anspruch 1 oder 2, wobei $R^{N1}$ und $R^{N2}$ in Formel (N1) jeweils unabhängig voneinander eine aliphatische Kohlenwasserstoffgruppe sind.

**4.** Lichtempfindliche Harzzusammensetzung nach Anspruch 3, wobei mindestens eines von $R^{N1}$ und $R^{N2}$ in Formel (N1) eine aliphatische Kohlenwasserstoffgruppe mit einer polaren Gruppe ist.

**5.** Lichtempfindliche Harzzusammensetzung nach Anspruch 1 oder 2, wobei $R^{N1}$ und $R^{N2}$ in Formel (N1) miteinander verknüpft sind, um eine aliphatische zyklische Struktur zu bilden.

**6.** Lichtempfindliche Harzzusammensetzung nach Anspruch 5, wobei die aliphatische zyklische Struktur mindestens eine polare Gruppe als einen Teil eines Substituenten aufweist.

**7.** Lichtempfindliche Harzzusammensetzung nach einem der Ansprüche 1 bis 6, ferner umfassend einen photoradikalischen Polymerisationsinitiator und eine radikalisch polymerisierbare Verbindung.

**8.** Lichtempfindliche Harzzusammensetzung nach einem der Ansprüche 1 bis 7, wobei der Vorläufer des heterocyclischen ringhaltigen Polymers einen Polyimidvorläufer oder einen Polybenzoxazolvorläufer enthält.

**9.** Lichtempfindliche Harzzusammensetzung nach Anspruch 8, wobei der Vorläufer des heterocyclischen ringhaltigen Polymers den Polyimidvorläufer enthält.

**10.** Lichtempfindliche Harzzusammensetzung nach Anspruch 9, wobei der Polyimidvorläufer eine Konstitutionseinheit, die durch Formel (1) dargestellt ist, aufweist,

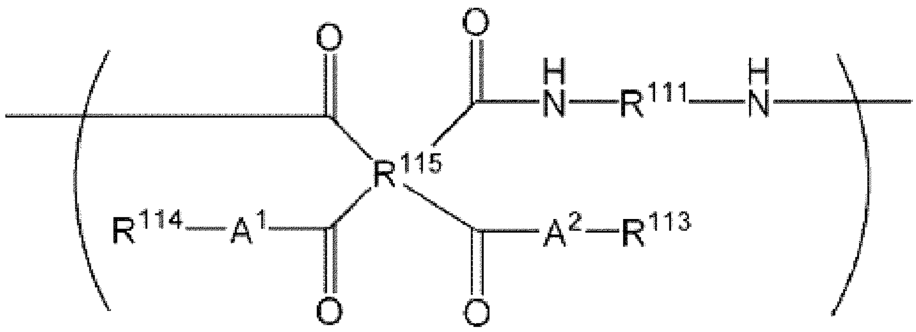

(1)

wobei in Formel (1) $A^1$ und $A^2$ jeweils unabhängig ein Sauerstoffatom oder NH darstellen, $R^{111}$ eine zweiwertige organische Gruppe darstellt, $R^{115}$ eine vierwertige organische Gruppe darstellt und $R^{113}$ und $R^{114}$ jeweils unabhängig voneinander ein Wasserstoffatom oder eine einwertige organische Gruppe darstellen.

**11.** Lichtempfindliche Harzzusammensetzung nach Anspruch 10, wobei mindestens eines von $R^{113}$ und $R^{114}$ in Formel (1) eine radikalisch polymerisierbare Gruppe enthält.

**12.** Verwendung der lichtempfindlichen Harzzusammensetzung nach einem der Ansprüche 1 bis 11 zum Bilden eines Zwischenschicht isolierenden Films für eine Neuverdrahtungsschicht.

**13.** Ausgehärteter Film, der durch Aushärten der lichtempfindlichen Harzzusammensetzung nach einem der Ansprüche 1 bis 11 erhalten wird.

**14.** Laminat, das zwei oder mehr ausgehärtete Filme nach Anspruch 13 umfasst, wobei eine Metallschicht zwischen beliebigen ausgehärteten Filmen vorgesehen ist.

**15.** Verfahren zum Herstellen eines ausgehärteten Films, umfassend einen Filmbildungsschritt des Aufbringens der lichtempfindlichen Harzzusammensetzung nach einem der Ansprüche 1 bis 11 auf ein Substrat, um einen Film zu bilden.

**16.** Verfahren zum Herstellen eines ausgehärteten Films nach Anspruch 15, ferner umfassend einen Schritt des Erwärmens des Films bei 50 °C bis 450 °C.

**17.** Halbleitervorrichtung, umfassend den ausgehärteten Film nach Anspruch 13 oder das Laminat nach Anspruch 14.

**Revendications**

**1.** Composition de résine photosensible comprenant :

un générateur de base thermique représenté par Formule (N1) ; et
un précurseur d'un polymère contenant un cycle hétérocyclique,

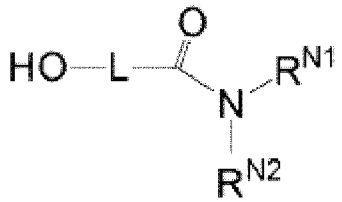

Formule (N1):

dans Formule (N1),
L représente un groupe hydrocarboné qui est un groupe hydrocarboné divalent ayant un groupe hydrocarboné saturé sur une voie d'une chaîne de liaison qui relie un atome d'oxygène et un atome de carbone adjacent et dans lequel le nombre des atomes sur la voie de la chaîne de liaison est de 4, 5 ou 6, dans laquelle la chaîne de liaison fait référence à une chaîne atomique qui interconnecte les cibles de liaison avec le nombre minimum d'atomes, et

$R^{N1}$ et $R^{N2}$ représentent chacun indépendamment un groupe organique monovalent et peuvent être liés l'un à l'autre pour former une structure cyclique.

**2.** Composition de résine photosensible selon la revendication 1, dans laquelle L dans Formule (N1) a une structure représentée par Formule (N2-a) ou Formule (N2-b),

$-L^1-Ar-L^2-$ Formule (N2-a);

$-Ar^1-L^3-Ar^2-$ Formule (N2-b);

dans Formule (N2-a), $L^1$ et $L^2$ représentent chacun indépendamment une liaison simple ou un groupe hydrocarboné, au moins l'un de $L^1$ ou $L^2$ contient un groupe hydrocarboné saturé sur la voie, et Ar représente un groupe arylène ; et dans Formule (N2-b), $L^3$ représente un groupe hydrocarboné contenant un groupe hydrocarboné saturé sur la voie, et $Ar^1$ et $Ar^2$ représentent chacun indépendamment un groupe arylène.

**3.** Composition de résine photosensible selon la revendication 1 ou la revendication 2, dans laquelle $R^{N1}$ et $R^{N2}$ dans Formule (N1) sont chacun indépendamment un groupe hydrocarboné aliphatique.

**4.** Composition de résine photosensible selon la revendication 3, dans laquelle au moins l'un de $R^{N1}$ ou $R^{N2}$ dans Formule (N1) est un groupe hydrocarboné aliphatique ayant un groupe polaire.

**5.** Composition de résine photosensible selon la revendication 1 ou la revendication 2, dans laquelle $R^{N1}$ et $R^{N2}$ dans Formule (N1) sont liés l'un à l'autre pour former une structure cyclique aliphatique.

**6.** Composition de résine photosensible selon la revendication 5, dans laquelle la structure cyclique aliphatique a au moins un groupe polaire comme une partie d'un substituant.

**7.** Composition de résine photosensible selon l'une quelconque des revendications 1 à 6, comprenant en outre un initiateur de polymérisation photoradicalaire et un composé polymérisable par voie radicalaire.

**8.** Composition de résine photosensible selon l'une quelconque des revendications 1 à 7, dans laquelle le précurseur du polymère contenant un cycle hétérocyclique inclut un précurseur de polyimide ou un précurseur de polybenzoxazole.

**9.** Composition de résine photosensible selon la revendication 8, dans laquelle le précurseur du polymère contenant un cycle hétérocyclique inclut le précurseur de polyimide.

**10.** Composition de résine photosensible selon la revendication 9, dans laquelle le précurseur de polyimide a une unité constitutionnelle représentée par Formule (1),

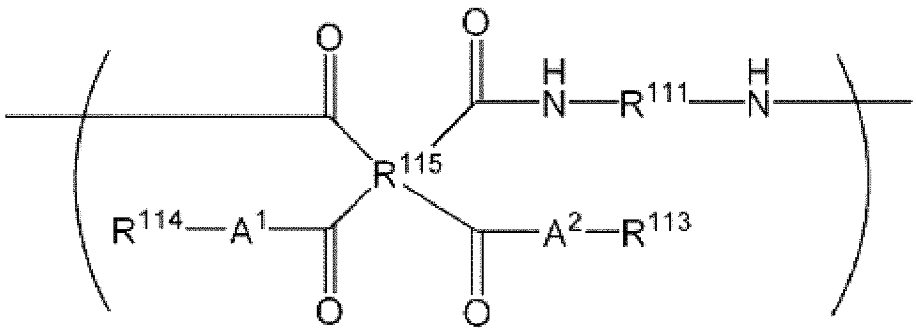

(1)

dans Formule (1), $A^1$ et $A^2$ représentent chacun indépendamment un atome d'oxygène ou -NH-, $Rm^{111}$ représente un groupe organique divalent, $R^{115}$ représente un groupe organique tétravalent, et $R^{113}$ et $R^{114}$ représentent chacun indépendamment un atome d'hydrogène ou un groupe organique monovalent.

**11.** Composition de résine photosensible selon la revendication 10, dans laquelle au moins l'un de $R^{113}$ ou $R^{114}$ dans Formule (1) contient un groupe polymérisable par voie radicalaire.

**12.** Utilisation de la composition de résine photosensible selon l'une quelconque des revendications 1 à 11 pour former un film isolant intercouche pour une couche de recâblage.

**13.** Film durci obtenu en durcissant la composition de résine photosensible selon l'une quelconque des revendications 1 à 11.

**14.** Stratifié comprenant deux films durcis ou plus selon la revendication 13, dans lequel une couche métallique est prévue entre quelconques films durcis.

**15.** Procédé de fabrication d'un film durci, comprenant une étape de formation de film consistant à appliquer la composition de résine photosensible selon l'une quelconque des revendications 1 à 11 sur un substrat pour former un film.

**16.** Procédé de fabrication d'un film durci selon la revendication 15, comprenant en outre une étape de chauffage du film à 50 °C à 450 °C.

**17.** Dispositif semi-conducteur comprenant le film durci selon la revendication 13 ou le stratifié selon la revendication 14.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011121962 A
- JP 2014201695 A
- WO 2017104672 A1
- JP 2013204019 A
- WO 2018151195 A1
- JP 2011068888 A
- JP 2013241548 A
- WO 2015199219 A
- WO 2015199220 A
- JP 2016027357 A
- JP 2015087611 A
- JP 10291969 A
- JP H10291969 A
- JP 4225898 B
- JP 2009191179 A
- JP 2001233842 A
- JP 2000080068 A
- JP 2006342166 A
- JP 2012014052 A
- JP 2010262028 A
- JP 2014500852 A
- JP 2013164471 A
- JP 2007269779 A
- JP 2009191061 A
- WO 2015125469 A
- JP 2008063554 A
- JP 48041708 B
- JP 50006034 B
- JP 51037193 A
- JP 48064183 A
- JP 49043191 B
- JP 52030490 B
- JP 2008292970 A
- JP 2010160418 A
- JP 2010129825 A
- JP 4364216 B
- JP 46043946 B
- JP S46043946 B
- JP 1040337 B
- JP H1040337 B
- JP 1040336 B
- JP H1040336 B
- JP 2025493 A
- JP H2025493 A
- JP 61022048 A
- JP S61022048 A
- JP 2015034964 A
- JP 10062986 A
- JP H10062986 A
- JP 2015187211 A
- JP S48041708 B
- JP S51037193 A
- JP 2032293 B
- JP H2032293 B
- JP 2016765 B
- JP H2016765 B
- JP 58049860 B
- JP S58049860 B
- JP 56017654 B
- JP S56017654 B
- JP 62039417 B
- JP S62039417 B
- JP 62039418 B
- JP S62039418 B
- JP 63277653 A
- JP S63277653 A
- JP 63260909 A
- JP S63260909 A
- JP 1105238 A
- JP H1105238 A
- JP 2013015701 A
- JP 2009283711 A
- JP 2011059656 A
- JP 2012194520 A
- JP 2015127817 A
- JP 2014191002 A
- WO 2011080992 A1
- JP 2014191252 A
- JP 2014041264 A
- WO 2014097594 A
- JP 2011128358 A
- JP 2014186186 A
- JP 2013072935 A
- JP 2015123351 A
- US 9159547 B
- JP 2007157879 A
- JP 2001521288 A
- JP 2004214501 A
- JP 2004101850 A

**Non-patent literature cited in the description**


- High functionality and applied technology of polyimide. Science & Technology Co., Ltd., April 2008
- Basics and development of polyimide materials. CMC Technical library. Masaaki Kakimoto, November 2011
- Handbook of Chemistry, Pure Chemistry, 5th Edition. Chemical Society of Japan
- *Journal of Japan Adhesive Association*, 1984, vol. 20 (7), 300-308
- Polymer Dictionary. The Society of Polymer Science, 2005, 683-684
- High functionality and applied technology of polyimide. Science & Technology Co., Ltd, April 2008
- Basics and development of polyimide materials. **MASAAKI KAKIMOTO**. CMC Technical library. November 2011
- Latest Polyimide Basics and Applications. Japan Polyimide & Aromatic Polymers Study Group, NTS Inc, August 2010